(19)

**Europäisches Patentamt**
**European Patent Office**
**Office européen des brevets**

(11) **EP 2 867 894 B1**

(12) **EUROPÄISCHE PATENTSCHRIFT**

(45) Veröffentlichungstag und Bekanntmachung des Hinweises auf die Patenterteilung:
**24.08.2016 Patentblatt 2016/34**

(21) Anmeldenummer: **13737170.4**

(22) Anmeldetag: **01.07.2013**

(51) Int Cl.:
*G10L 21/0388* (2013.01)    *G10L 19/02* (2013.01)

(86) Internationale Anmeldenummer:
**PCT/EP2013/063827**

(87) Internationale Veröffentlichungsnummer:
**WO 2014/005992 (09.01.2014 Gazette 2014/02)**

(54) **VORRICHTUNG, VERFAHREN UND COMPUTERPROGRAMM FÜR FREI WÄHLBARE FREQUENZVERSCHIEBUNGEN IN DER SUBBAND-DOMÄNE**

DEVICE, METHOD AND COMPUTER PROGRAM FOR FREELY SELECTABLE FREQUENCY SHIFTS IN THE SUB-BAND DOMAIN

DISPOSITIF, PROCÉDÉ ET PROGRAMME INFORMATIQUE POUR DÉCALAGE DE FRÉQUENCE LIBREMENT SÉLECTIF DANS LE DOMAINE DE SOUS-BANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.07.2012 US 201261667119 P**
**10.07.2012 EP 12175808**

(43) Veröffentlichungstag der Anmeldung:
**06.05.2015 Patentblatt 2015/19**

(73) Patentinhaber:
• **Fraunhofer-Gesellschaft zur Förderung der angewandten Forschung e.V.**
**80686 München (DE)**
• **Technische Universität Ilmenau**
**98693 Ilmenau (DE)**

(72) Erfinder:
• **NAGEL, Frederik**
**90425 Nürnberg (DE)**
• **SCHNABEL, Michael**
**95179 Geroldsgrün (DE)**
• **NEUKAM, Christian**
**88239 Wangen i.A. (DE)**
• **SCHULLER, Gerald**
**99094 Erfurt (DE)**

(74) Vertreter: **Zinkler, Franz et al**
**Schoppe, Zimmermann, Stöckeler**
**Zinkler, Schenk & Partner mbB**
**Patentanwälte**
**Radlkoferstrasse 2**
**81373 München (DE)**

(56) Entgegenhaltungen:
**WO-A1-2011/089029    US-A1- 2012 065 983**

EP 2 867 894 B1

**Beschreibung**

Die vorliegende Erfindung bezieht sich auf Audiosignalverarbeitung und, im Speziellen, auf eine Vorrichtung, ein Verfahren und ein Computerprogramm für beliebige Frequenzverschiebungen in der Subband-Domäne.

In der von neuen Medien geprägten Gesellschaft sind rechnergestützte Datenverarbeitungssysteme ein fester Bestandteil des täglichen Lebens. Schon seit einiger Zeit finden sich fast in jedem Haushalt Systeme zum Konsum neuer Medien wieder. Beispiele für solche Systeme, die Daten in digitaler Form übermitteln und wiedergeben, sind Abspielgeräte für Video- und Audiodaten, wie etwa für die DVD und BluRay, für die CD und das Dateiformat mp3. Diese Wiedergabesysteme zeichnen sich durch nahezu verlustfreie Reproduktion der medialen Inhalte aus. Neben der klassischen Telekommunikation stellt das Internet ein wichtiges Portal für die Kommunikation, beispielsweise mittels VoIP, dar. Die genannten Technologien werden alle durch die zugrundeliegende digitale Signalverarbeitung verbunden. Sie ist für die Qualität der Wiedergabe und Effizienz der digitalen Technologien von entscheidender Bedeutung.

Audiosignalverarbeitung wird dabei immer wichtiger. Derzeit gibt es auf dem Markt eine Vielzahl an Audiocodern, z.B. realisiert durch Algorithmen zur digitalen Aufbereitung von Audiomaterial zur Speicherung oder Übertragung. Ziel jedes Codier-Verfahrens ist es, den Informationsgehalt eines Signals so zu komprimieren, dass es ein Minimum an Speicherplatz benötigt und gleichzeitig eine größtmögliche Reproduktionsqualität erhalten bleibt. Die Effizienz moderner Audiocoder richtet sich in erster Linie nach dem benötigten Speicherplatz und unter anderem nach dem benötigten Rechenaufwand des Algorithmus.

Ein digitaler Audiocoder ist prinzipiell ein Instrument zur Überführung von Audiosignalen in ein zur Speicherung oder Übertragung geeignetes Format. Dies geschieht auf Senderseite des Audiocoders (Encoder). Die so erzeugten Daten werden dann im Empfänger (Decoder) wieder in ihre ursprüngliche Form zurückgeführt und entsprechen im Idealfall den Originaldaten bis auf eine konstante Verzögerung (engl. Delay). Das generelle Ziel von Audiocodern ist die Minimierung der zur Repräsentation des Audiosignals benötigten Datenmenge bei gleichzeitiger Maximierung der empfundenen Wiedergabequalität. Bei der Entwicklung von Audiocodern muss also auf eine Reihe von Faktoren wie Wiedergabetreue, Datenrate und Komplexität geachtet werden. Daneben spielt auch das durch die Bearbeitung des Signals hinzugefügte Delay (die hinzugefügte Verzögerung) eine wichtige Rolle (Bosi und Goldberg, 2003).

Gerade in den Anfängen der Audiocodierung war die Effizienz der Verfahren von großer Bedeutung, da nur sehr begrenzt Speicher und Rechenleistung zur Verfügung standen. Heutzutage scheint dieser Anspruch nicht mehr gegeben. Selbst Heim-PCs oder Laptops können aufwändige Algorithmen mühelos in Echtzeit berechnen und Breitband-Internetverbindungen stellen ausreichend Bandbreite für die Übertragung von codiertem Audiomaterial zur Verfügung. Dennoch ist die Weiterentwicklung von Audiocodierverfahren von besonderer Bedeutung. Im Bereich der mobilen Kommunikation und der Satellitenübertragung ist die Bandbreite stark begrenzt. Es ist wichtig, die zu übertragende Datenmenge zu reduzieren. Es wird zudem in diesen Bereichen viel Wert auf die Effizienz der verwendeten Codier-Technologie gelegt. Die zugrundeliegenden Algorithmen müssen einfach strukturiert sein, um Rechenleistung und Stromverbrauch zu minimieren.

Ein anderer Aspekt ist die Qualität der reproduzierten codierten Audiosignale. Viele Audiocoder reduzieren die Datenmenge über Irrelevanzreduktion. Dabei gehen in Abhängigkeit der Datenrate Signalanteile verloren. Bei niedrigen Datenraten sinkt damit die Qualität wiedergegebener Audiosignale.

Generell kann zwischen zwei Arten der Audiocodierung unterschieden werden, der verlustfreien und der verlustbehafteten Audiocodierung. Die verlustfreie Audiocodierung ermöglicht auf Empfängerseite eine exakte Rekonstruktion des ursprünglichen Signals. Dagegen verursacht das verlustbehaftete Verfahren über ein Modell der subjektiven Wahrnehmung irreversible Abweichungen gegenüber dem Originalsignal (Zölzer, 2005).

Die verlustfreie Audiocodierung basiert auf der Verminderung der Redundanz, die im zu codierenden Signal enthalten ist. Ein gängiges Verfahren dazu ist zum Beispiel die lineare Prädiktion (engl. Linear Predictive Coding, LPC) in Verbindung mit nachfolgender Entropiecodierung. Solche Audiocodierverfahren ermöglichen die bitgenaue Rekonstruktion des Eingangssignals aus dem codierten Bitstrom.

Die lineare Prädiktion nutzt statistische Abhängigkeiten zwischen aufeinanderfolgenden Abtastwerten (engl. Samples) des Signals, um zukünftige Werte vorhersagen zu können. Dem liegt die Tatsache zugrunde, dass sich aufeinanderfolgende Samples ähnlicher sind als weiter entfernte. Die Vorhersage wird durch ein lineares Prädiktionsfilter realisiert, welches den aktuellen Abtastwert durch eine Reihe vorhergehender Samples schätzt. Es wird aber nicht diese Schätzung selbst weiterverarbeitet, sondern die Differenz zwischen diesem Wert und dem eigentlichen Abtastwert an dieser Stelle. Ziel der linearen Prädiktion ist es, die Energie dieses Fehlersignals durch optimierte Filter zu minimieren und dieses Fehlersignal, das nur eine geringe Bandbreite benötigt, zu übertragen (Weinzierl, 2008).

Anschließend wird das Fehlersignal entropiecodiert. Die Entropie ist ein Maß für den mittleren Informationsgehalt eines Signals und gibt das theoretische Minimum der für die Codierung benötigten Bits an. Ein typisches Verfahren dazu ist die Huffman-Codierung. Dabei werden einzelnen Abtastwerten in Abhängigkeit ihrer statistischen Auftrittswahrscheinlichkeit bestimmte Codewörter zugewiesen. Häufig auftretenden Abtastwerten werden kurze Symbolen zugewiesen und selten auftretende Signalwerte werden durch lange Codewörter repräsentiert. Im Mittel wird so das codierte Signal durch die kleinstmögliche Anzahl an Bits dargestellt (Bosi und Goldberg, 2003).

Sowohl die lineare Prädiktion als auch die Entropiecodierung sind reversibel und entfernen somit aus dem Signal keine Information. Es werden durch Kombination beider Verfahren lediglich Redundanzen aus dem zu codierenden Signal entfernt. Da solche verlustfreien Ansätze stark von der Signalcharakteristik abhängen, ist der Codiergewinn vergleichsweise gering. Die erzielte Kompressionsrate, also das Verhältnis von Eingangsbitrate und Bitrate des codierten Signals, liegt im Bereich von 1,5 : 1 bis 3 : 1 (Weinzierl, 2008).

Die verlustbehaftete Audiocodierung basiert auf dem Prinzip der Irrelevanzreduktion. Diese Verfahren benötigen ein Modell der menschlichen Wahrnehmung, welches psychoakustische Phänomene des Gehörsinns bezüglich Zeit- und Frequenzauflösung beschreibt. Daher wird die verlustbehaftete Audiocodierung auch als wahrnehmungsangepasste oder psychoakustische Codierung bezeichnet. Im Bereich der Audiocodierung werden alle Signalanteile als irrelevant bezeichnet, die durch den Menschen nicht wahrgenommen werden können und somit unhörbar sind (Zölzer, 2005). Um die Funktionsweise eines wahrnehmungsangepassten Audiocoders genauer zu verstehen, ist ein fundiertes Wissen über die Psychoakustik von großer Bedeutung.

Das menschliche Gehör analysiert ein Schallereignis durch Zerlegung in Frequenzgruppen. Diese Frequenzgruppen werden in der Bark-Skala dargestellt und in der englischsprachigen Literatur als Critical Bands bezeichnet. Jede dieser Frequenzgruppen fasst dabei einen Frequenzbereich zusammen, der durch das Gehör gemeinsam ausgewertet wird. Dabei entspricht ein Frequenzbereich einem örtlichen Bereich auf der Basilarmembran. Insgesamt werden 24 Critical Bands der Basilarmembran zugeordnet, deren Bandbreite mit steigender Frequenz zunimmt (Fastl und Zwicker, 2007). Verlustbehaftete Audiocoder übernehmen dieses Modell der Frequenzgruppen, um breitbandige Signale in Teilbänder zu zerlegen und jedes Band einzeln zu codieren (Zölzer, 2005). Oftmals wird dieses Modell angepasst und statt der Bark-Skala eine lineare Frequenzeinteilung mit mehr als 24 Bändern verwendet.

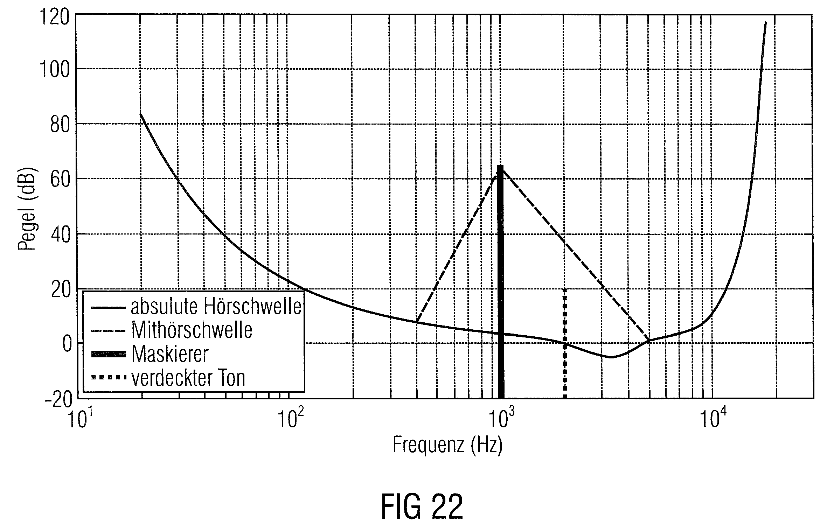

Ein weiteres wichtiges Merkmal der auditiven Wahrnehmung ist das frequenzabhängige Lautstärkeempfinden von Tönen gleichen Schalldruckpegels. Daraus ergeben sich zwei Eigenschaften des Gehörs. Zum einen werden Töne unterschiedlicher Frequenz aber mit gleichem Schalldruckpegel als unterschiedlich laut empfunden, zum anderen gibt es eine frequenzabhängige Schwelle, ab welcher Töne gerade noch wahrgenommen werden können (Fastl und Zwicker, 2007). Diese Schwelle wird auch als absolute Hörschwelle oder Ruhehörschwelle bezeichnet und ist in Fig. 22 dargestellt. Für die Audiocodierung lassen sich daraus zwei Schlüsse ziehen. Signale, deren Pegel unterhalb der absoluten Hörschwelle liegen, brauchen nicht verarbeitet werden, da sie ohnehin nicht wahrgenommen werden. Daneben lässt sich die Anzahl der benötigten Quantisierungsstufen pro Frequenzband aus dem Abstand zwischen der Ruhehörschwelle und dem Signalpegel mitbestimmen (Zölzer, 2005).

Den größten Einfluss auf die Audiocodierung haben die Verdeckungs- oder Maskierungseffekte. Hier kann zwischen zeitlicher und frequenzabhängiger Maskierung unterschieden werden. Als Maskierer wird in beiden Fällen ein Schallereignis bezeichnet, durch das ein anderes Schallereignis verdeckt wird. Das maskierte Ereignis ist also unhörbar. Bei zeitlicher Maskierung wird ein Ereignis vor beziehungsweise nach dem Maskierer verdeckt. Vorverdeckung (engl. Premasking) ist unabhängig von der Dauer des Maskieres und verdeckt Schallereignisse bis 50ms vor der Wahrnehmung des Maskierers selbst (Yost, 1994). Dagegen ist Nachverdeckung (engl. Postmasking) abhängig von der Dauer des Maskierers. Hier werden Schallereignisse nach Verstummen des Maskierers verdeckt. In Abhängigkeit der Dauer des Maskierers können bis zu 200ms vergehen, bis das Gehör wieder für Signale im Bereich der Ruhehörschwelle empfänglich ist (Fastl und Zwicker, 2007).

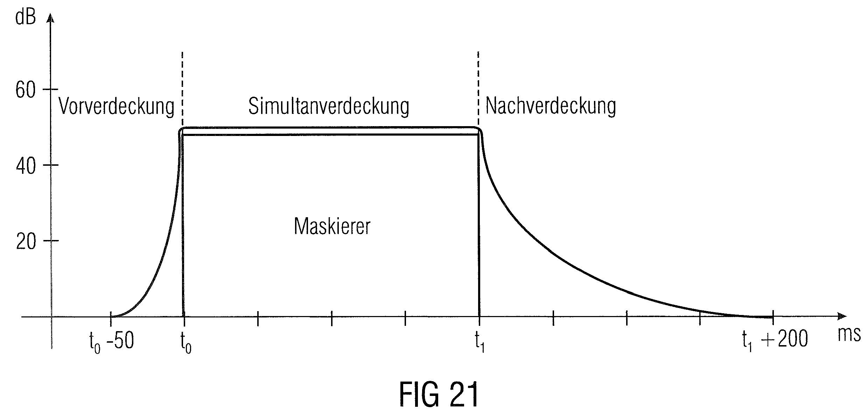

Fig. 21 zeigt eine schematische Darstellung einer zeitlichen Maskierung. Speziell zeigt Fig. 21 schematisch die Bereiche des Pre- und Postmaskings und jeweils den Pegel unter welchem Signale verdeckt werden. Zeitliche Verdeckung kann in der Audiocodierung benutzt werden, um die durch den Codierprozess auftretenden Störgeräusche wie beispielsweise Quantisierungsrauschen vor Signalsequenzen mit hohem Pegel (Transienten) zu verbergen.

Maskierungseffekte im Frequenzbereich spielen eine weit größere Rolle als zeitliche Verdeckungseffekte. Die frequenzabhängige Maskierung beschreibt die Veränderung der Ruhehörschwelle für Einzeltöne und Schmalbandrauschen. Diese Signale verzerren durch ihre spezifische Mithörschwelle die Ruhehörschwelle deutlich. Signale, deren Pegel kleiner als die Mithörschwelle des Maskierers ist, und die sich im Wirkbereich dieser Schwelle befinden, können nicht wahrgenommen werden (Fastl und Zwicker, 2007). In Fig. 22 ist dieser Zusammenhang verdeutlicht.

Fig. 22 zeigt eine schematische Darstellung der frequenzabhängigen Maskierung im menschlichen Gehör. Wie zu erkennen ist, liegt der maskierte Ton unterhalb der Mithörschwelle des Maskierers und ist somit unhörbar. Dieser Effekt wird bei verlustbehafteten Audiocodierverfahren ausgenutzt. Signalanteile, die unterhalb der frequenzabhängigen Mithörschwelle liegen, werden aus dem Signal entfernt und nicht weiterverarbeitet (Zölzer, 2005).

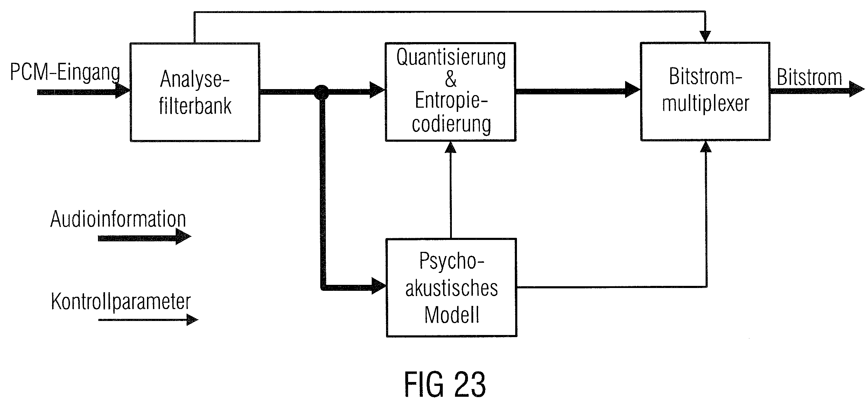

Der generelle Aufbau eines typischen wahrnehmungsangepassten Encoders ist in Fig. 23 dargestellt. Dabei zeigt Fig. 23 ein Blockschaltbild eines psychoakustischen Audioencoders. Zunächst wird das zu codierenden PCM-Signal durch die Analysefilterbank in Frequenzbänder zerlegt und dem psychoakustischen Modell zugeführt. Darin wird durch die beschriebenen psychoakustischen Eigenschaften des Gehörs eine zeitabhängige Mithörschwelle ermittelt, welche die Genauigkeit der Quantisierung für die unterschiedlichen Frequenzbänder regelt. Dabei werden wichtige, also gut wahrnehmbare, Frequenzbänder sehr hochauflösend quantisiert und unwichtige werden mit wenigen Bits Auflösung dargestellt. Anschließend wird, wie bei der verlustfreien Audiocodierung, noch eine Entropiecodierung zur Datenreduktion durchgeführt. Da durch die Analysefilterbank und das psychoakustische Modell zusätzliche Kontrollparameter übertragen werden müssen, wird durch den Bitstrommultiplexer der eigentliche Bitstrom zusammengesetzt. Der Codiergewinn bei verlustbehafteten Audiocodern wird hier durch die Kombination aus Quantisierung und Entropiecodierung erzielt (Zölzer, 2005). Die Kopressionsrate liegt hier je nach zu erzielender Qualität zwischen 4 : 1 und 50 : 1 (Weinzierl, 2008).

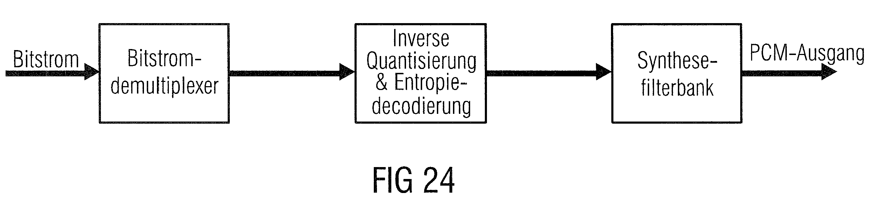

Der Decoder ist vergleichsweise einfach aufgebaut. Zunächst wird der empfangene Bitstrom durch einen Demultiplexer wieder in Signaldaten und Kontrollparameter aufgeteilt. Danach werden eine Entropiedecodierung und eine inverse Quantisierung durchgeführt. Dabei steuern die Kontrollparameter die inverse Quantisierung der Nutzdaten. Die so gewonnenen Teilbandsignale werden nun auf die Synthesefilterbank zur Rekonstruktion des breitbandigen PCM-Signals gegeben (Zölzer, 2005). Das dazugehörende Blockschaltbild eines psychoakustischen Audiodecoders ist in Fig. 24 zu sehen.

Nachfolgend werden auf eine Reihe von Signaltransformationen aus dem Stand der Technik eingegangen. Da die Quantisierung in vielen Audiocodern auf einem Wahrnehmungsmodell basiert, das die Wahrnehmung des Menschen im Frequenzbereich beschreibt, ist es notwendig, das zu codierende Signal ebenfalls in den Frequenzbereich zu überführen. Dafür gibt es eine große Anzahl an Transformationen mit unterschiedlichen Charakteristiken und Anwendungsbereichen. Im Folgenden werden die für die Audiocodierung relevanten Transformationen vorgestellt und der Aufbau einer Filterbank gezeigt.

Die Fouriertransformation ist das bedeutendste Verfahren für die Analyse der harmonischen Struktur eines Signals. Sie ist Teil der Fourieranalyse und nach dem französischen Mathematiker und Physiker Jean-Baptiste-Joseph Fourier (1768 bis 1830) benannt, der diese erstmalig einführte. Bei der Fouriertransformation handelt es sich um eine Funktion zur Überführung eines Zeitsignals in seine Repräsentation im Frequenzbereich. Sie wird unter anderem genutzt, um das Verhalten von linearen, zeitinvarianten (LTI) Systemen zu beschreiben und vorhersagen zu können (Burrus und Parks, 1985). Sie spielt daher beispielsweise eine große Rolle in der Akustik und in der Charakterisierung des menschlichen Gehörs. Das grundlegende Vorgehen der Fouriertransformation ist die Zerlegung eines Zeitsignals in eine gewichtete Summe von Sinus- und Cosinusschwingungen. Für aperiodische, kontinuierliche Signale wird sie wie folgt berechnet (Bosi und Goldberg, 2003):

$$X(f) = \int\limits_{-\infty}^{\infty} x(t)e^{-j2\pi ft}dt$$

$$(2.1)$$

Dabei ist $x(t)$ das zu analysierende Signal im Zeitbereich und $X(f)$ das dazu gehörende Fourierspektrum im Frequenzbereich. Es ist zu beachten, dass das Ergebnis komplex ist, obwohl ein reelles Signal transformiert wird. Mit Hilfe der Eulerschen Relation in Gleichung 2.2 lässt sich zeigen, dass dabei der Realteil von $X(f)$ den Cosinustermen von $x(t)$ und der Imaginärteil den Sinuskomponenten entspricht. Mit Hilfe von:

$$e^{-j2\pi ft} = \cos(2\pi ft) - j\sin(2\pi ft)$$

$$(2.2)$$

folgt aus Gleichung 2.1.:

$$X(f) = \int_{-\infty}^{\infty} x(t) \cdot (\cos(2\pi f t) - j\sin(2\pi f t))\, dt$$

$$(2.3)$$

$$= \int_{-\infty}^{\infty} x(t) \cdot \cos(2\pi f t)\, dt - j \int_{-\infty}^{\infty} x(t) \cdot \sin(2\pi f t)\, dt$$

$$(2.4)$$

und daraus:

$$X(f) = \mathrm{Re}\{X(f)\} + j\,\mathrm{Im}\{X(f)\}$$

$$(2.5)$$

Da sich Sinus und Cosinus nur in ihrer Phase voneinander unterscheiden, kann aus dem Verhältnis der entsprechenden Terme auf die Phase des Signals geschlossen werden. Es gilt:

$$X(f) = |X(f)| \cdot e^{j\varphi(f)}$$

$$(2.6)$$

mit:

$$|X(f)| = \sqrt{(\mathrm{Re}\{X(f)\})^2 + (\mathrm{Im}\{X(f)\})^2}$$

$$(2.7)$$

$$\varphi(f) = \arctan\left(\frac{\mathrm{Im}\{X(f)\}}{\mathrm{Re}\{X(f)\}}\right)$$

$$(2.8)$$

Dabei wird $|X(f)|$ als Betragsfrequenzgang und $\varphi(f)$ als Phasenfrequenzgang oder einfach als Phase bezeichnet.
Durch die inverse Fouriertransformation (Gleichung 2.9) wird das transformierte Signal wieder in seine ursprüngliche Darstellung im Zeitbereich überführt. Es ist zu beachten, dass sich die Fouriertransformation und ihre Inverse durch einen konstanten Vorfaktor und dem Vorzeichen der Exponentialfunktion unterscheiden (Burrus und Parks, 1985).

$$x(t) = \frac{1}{2\pi} \int_{-\infty}^{\infty} X(f) e^{j2\pi f t}\, df$$

$$(2.9)$$

Im Folgenden wird auf die Diskrete Fouriertransformation eingegangen.

In der Praxis treten bei Verwendung der Fouriertransformation in Digitalrechnern Probleme auf. Zum einen liegt das daran, dass nur endlich viele Zeitwerte verarbeitet werden können, zum anderen muss neben der Zeitvariablen auch die Frequenzvariable diskret abgetastet werden. Die Lösung dieser Probleme stellt die diskrete Fouriertransformation (DFT) dar. Mit Hilfe der DFT wird ein endliches, zeitdiskretes Signal in ein diskretes, periodisches Spektrum überführt. Sie ist damit eine der wichtigsten Transformationen in der digitalen Signalverarbeitung. Der Ursprung der DFT liegt in der Fouriertransformation, eine genaue Herleitung ist in (Lochmann, 1990) zu finden. Die DFT eines zeitdiskreten Signals $x[n]$ der Länge $N$ ist definiert als (Burrus und Parks, 1985):

$$X[k] = \sum_{n=0}^{N-1} x[n] W^{kn}, \quad \forall k \in [0, N-1]$$

(2.10.)

und analog dazu die inverse diskrete Fouriertransformation (IDFT):

$$x[n] = \frac{1}{N} \sum_{n=0}^{N-1} X[k] W^{-kn}, \quad \forall k \in [0, N-1]$$

(2.11)

mit dem komplexen Drehzeiger $W$:

$$W = e^{-j\frac{2\pi}{N}}$$

(2.12)

Dabei ist $X[k]$ das diskrete, periodische Spektrum von $x[n]$ mit $\forall k, n \in \mathbb{N}$. Die Periodenlänge des Spektrums entspricht der Transformationslänge $N$ und es werden normalisierte Frequenzen im Intervall $[0, 2\pi]$ abgebildet.

Für reelle Eingangssignale weist die DFT eine wichtige Eigenschaft auf. Es werden hier nicht wie im allgemeinen Fall $N$ unabhängige Frequenzkoeffizienten berechnet, sondern nur halb so viele. Diese Eigenschaft kann zum Beispiel für die Speicherung oder Übertragung der Daten ausgenutzt werden. Für die Rücktransformation werden dann die zweiten $N/2$ Werte über folgenden Zusammenhang berechnet (Rao und Yip, 2001):

$$X[N-k] = X[k]^*$$

(2.13)

Der Operator $^*$ kennzeichnet dabei in Formel 2.13 die komplexe Konjugation. Damit ist $X[k]^*$ die konjugiert-komplexe Wertefolge zu $X[k]$.

Der Berechnungsaufwand der DFT und IDFT liegt bei $N^2$ komplexen Multiplikationen und Additionen. Werden Symmetrien in der Berechnung genutzt, wird die Anzahl der benötigten Rechenschritte auf $N$ID$N$ reduziert und die Komplexität entspricht $O(N\log N)$. Allerdings muss bei den schnellen Verfahren die Transformationslänge $N$ einer Potenz der Zahl Zwei entsprechen. Die schnelle Fouriertransformation wird als FFT bezeichnet (Kiencke und Jäkel, 2005).

Die diskrete Fouriertransformation hat sich nicht im Bereich der Datenkompression durchsetzen können. Die großen Nachteile der DFT sind der hohe Rechenaufwand und die im Spektrum enthaltene Redundanz. Obwohl es in Form der FFT effiziente Verfahren zur Berechnung der DFT existieren, wird immer ein komplexes Spektrum erzeugt. Es werden also aus $N$ Transformationswerten $N$ komplexe Wertepaare berechnet. Zudem beinhalten nur die ersten $N/2$ Spektralwerte neue Information.

Nachfolgend wird auf die Diskrete Cosinus- und Sinustransformation eingegangen.

Eine Lösung der oben angesprochenen Probleme der DFT stellt die diskrete Cosinustransformation (DCT) dar. Die DCT ist eine reelle, diskrete, lineare und orthogonale Transformation. Gerade durch diese Eigenschaften ist sie die meistgenutzte Transformation in der digitalen Datenkomprimierung (Britanak u. a., 2007).

Die DCT ist eine diskrete trigonometrische Transformation. Insgesamt wird zwischen acht DCT-Formen unterschieden. In Abhängigkeit ihrer Randfortsetzung teilen sie sich in gerade und ungerade Transformationen sowie in die Typen I, II, III und IV auf. Für die digitale Signalverarbeitung sind aber nur die geraden Typen der DCT von Bedeutung. Diese sind im Folgenden aufgeführt (Rao und Yip, 2001):

$$X^I[k] = \varepsilon[k] \sum_{n=0}^{N} \varepsilon[n]x[n] \cos\left(\frac{\pi nk}{N}\right), \qquad \forall k \in [0, N]$$

$$(2.14a)$$

$$X^{II}[k] = \varepsilon[k] \sum_{n=0}^{N-1} x[n] \cos\left(\frac{\pi(n + 0,5)k}{N}\right), \qquad \forall k \in [0, N-1]$$

$$(2.14b)$$

$$X^{III}[k] = \sum_{n=0}^{N-1} \varepsilon[n]x[n] \cos\left(\frac{\pi(k + 0,5)n}{N}\right), \qquad \forall k \in [0, N-1]$$

$$(2.14c)$$

$$X^{IV}[k] = \sum_{n=0}^{N-1} x[n] \cos\left(\frac{\pi(n + 0,5)(k + 0,5)}{N}\right), \quad \forall k \in [0, N-1]$$

$$(2.14d)$$

mit:

$$\varepsilon[p] = \begin{cases} \dfrac{1}{\sqrt{2}} & \text{wenn } p = 0 \vee p = N \\ 1 & \text{sonst} \end{cases}$$

$$(2.15)$$

Jede dieser Formen hat seine eigene Anwendung in der Codierung. Die DCT-II wird primär als Transformation von Bilddaten eingesetzt. In der Literatur ist sie der erste beschriebene Typ der DCT. Daher bezeichnet allgemein der Begriff "DCT" die DCT-II (Ahmed u. a., 1974). Die DCT-III ist bis auf einen Vorfaktor die inverse Transformation zur DCT-II und umgekehrt. Für die Audiocodierung ist die DCT-IV von besonderer Bedeutung. Sie ist Grundlage der modifizierten diskreten Cosinustransformation.

Um wichtige Eigenschaften der DCT aufzeigen zu können, wird im Folgenden ein Zusammenhang zwischen DFT und DCT hergestellt. Wie oben dargestellt wurde, berechnet die DFT aus einem reellwertigen Signal der Länge $N$ nur $N/2$ unabhängige Frequenzkoeffizienten. Umgekehrt bedeutet dies, dass $2N$ Werte im Zeitbereich benötigt werden, um $N$ Spektralwerte zu erhalten. Stehen aber nur $N$ Zeitwerte zur Verfügung, muss das Signal auf eine geeignete Art fortgesetzt werden. Hier bietet sich die symmetrische Erweiterung durch Spiegelung des gesamten Signals an. Das erweiterte Signal scheint sich somit mit einer Periodenlänge von 2N zu wiederholen. Das hat den Vorteil, dass der störende Leckeffekt der DFT bei beschnittenen Signalen unterdrückt wird (Kiencke und Jäkel, 2005).

Ein beliebiges reelles Signal $x[n]$ der Länge $N$ wird symmetrisch erweitert, so dass gilt:

$$\breve{x}[n] = [x[0], \dots, x[N-1], x[N-1], \dots, x[0]]$$

(2.16)

mit $0 \leqq n \leqq 2N - 1$. Die Länge von $\tilde{x}[n]$ ist damit 2N. Auf dieses Signal wird nun die DFT aus Gleichung 2.10 mit Gleichung 2.12 angewendet und umgeformt (Rao und Yip, 2001). Eine detaillierte Herleitung ist im Anhang A.1 zu finden. Es gilt:

$$\breve{X}[k] = \sum_{n=0}^{2N-1} \breve{x}[n] e^{-j\frac{2\pi}{2N}kn}$$

(2.17a)

$$= 2e^{j\frac{\pi}{2N}k} \sum_{n=0}^{N-1} \tilde{x}[n] \cos\left(\frac{\pi(n+0.5)k}{N}\right), \quad \forall k \in [0, N-1]$$

(2.17b)

Wird dieses Ergebnis mit der DCT-II in Gleichung 2.14b verglichen, fällt auf, dass sich die zwei Gleichungen nur um den Phasenterm $2e^{j\frac{\pi}{2N}k}$ unterscheiden. Da dieser signalunabhängig ist und keine Information beinhaltet, kann er für die Berechnung der DCT vernachlässigt werden (Rao und Yip, 2001). Für die DCT-I lässt sich ein ähnlicher Zusammenhang zeigen, nur mit einer anderen Signalfortsetzung von x[n]. Die DCT-IV ergibt sich dann aus einer Phasendrehung der Basisfunktion der DCT-II. Eine detaillierte Herleitung dazu findet sich in (Rao und Yip, 2001).

Aus diesem Ergebnis lassen sich nun einige Schlüsse ziehen. Zunächst fällt auf, dass die DCT im Gegensatz zur DFT eine rein reelle Transformation ist. Daraus ergeben sich zwei Vorteile. Erstens müssen keine komplexen Multiplikationen und Additionen zur Berechnung durchgeführt werden und zweitens wird zur Speicherung der Daten nur die Hälfte an Speicherplatz benötigt, da keine komplexen Wertepaare vorliegen. Des Weiteren fällt auf, dass die DCT zur Berechnung von N unabhängigen Frequenzkoeffizienten genau N Werte für die Transformation benötigt. Die Frequenzen liegen alle im Intervall [0, $\pi$]. Im Gegensatz zur DFT ist die für reellwertige Eingangssignale im Spektrum enthaltene Redundanz verschwunden und damit die Frequenzauflösung doppelt so hoch. Von Nachteil ist allerdings, dass sich das DCT-Spektrum nicht in Betrag und Phase umwandeln lässt. Außerdem kann es vorkommen, dass im Signal Frequenzen enthalten sind, die zwar den DCT-Basisfunktionen (vgl. Gleichung 2.14a bis 2.14d) entsprechen, aber im Verhältnis dazu in ihrer Phase um 90° gedreht sind. Diese Frequenzen werden dann nicht durch die DCT dargestellt, d.h. der betreffende DCT-Koeffizient ist Null. Aus diesen Gründen eignet sich die DCT gut zur effektiven und schnellen Datenkompression, aber weniger zur Signalanalyse (Malvar, 1992).

Neben der diskreten Cosinustransformation existiert noch die diskrete Sinustransformation (DST). Insgesamt werden ebenfalls acht Formen der DST unterschieden. Hier ist lediglich die DST-IV von Bedeutung. Sie entspricht in ihrer Form sowie ihren Eigenschaften der DCT-IV (Rao und Yip, 2001):

$$X_s^{IV}[k] = \sum_{n=0}^{N-1} x[n] \sin\left(\frac{\pi(n+0,5)(k+0,5)}{N}\right), \quad \forall k \in [0, N-1]$$

(2.18)

Wird ein Signal sowohl mit der DCT-IV als auch der DST-IV transformiert, enthält das durch Kombination der beiden reellen Spektren entstandene komplexe Spektrum wieder Informationen über Betrag und Phase. Die Frequenzauflösung ist dabei immer noch doppelt so groß wie bei der DFT, es werden also N Frequenzen im Intervall [0, $\pi$] abgebildet (Malvar, 1992).

Für die Signalverarbeitung langer Audiosignale ist es nicht möglich, das Signal als Ganzes zu transformieren. Zum einen steigt dabei der Berechnungsaufwand enorm, da auch für die Berechnung der DCT $N^2$ Rechenoperationen benötigt werden. Zum anderen ist es nicht möglich, das Signal in Echtzeit zu verarbeiten, da immer auf die Übertragung des gesamten Datenstroms gewartet werden muss, bis das Signal rekonstruiert werden kann. Folglich ist es notwendig, das Signal in Blöcke zu unterteilen. In diesem Fall wird die DCT als sogenannte Blocktransformation angewendet (Rao und Yip, 2001). Mit dem Blockindex $b \in \mathbb{N}$ ergibt sich für die DCT-IV aus Gleichung 2.14d:

$$X_b^{IV}[k] = \sum_{n=0}^{N-1} x[n + bN] \cos\left(\frac{\pi(n + 0,5)(k + 0,5)}{N}\right), \quad \forall k \in [0, N-1]$$

(2.19)

Die Signallänge von *x[n]* entspricht hier *bN.* Bei Blocktransformationen treten durch die Quantisierung Blockartefakte auf. Ein bekanntes Beispiel, bei dem solche Artefakte zu erkennen sind, ist das JPEG-Kompressionsverfahren. Der Ursprung der Blockartefakte liegt in den zur Periodisierung durchzuführenden Randfortsetzungen. Sie entsprechen nicht den ursprünglich angenommenen Signalfortsetzungen (vgl. Gleichung 2.16). Das Resultat sind Sprungstellen an den Blockgrenzen, die im Frequenzbereich die Energie zu hohen Frequenzen hin verschieben (Malvar, 1992). Sprungstellen in einem Audiosignal sind als Knacken wahrnehmbar. Für solche Artefakte ist das menschliche Gehör sehr empfindlich. Sie müssen daher unbedingt vermieden werden.

Nachfolgend wird die modifizierte diskrete Cosinustransformation erläutert.

Die modifizierte diskrete Cosinustransformation (MDCT) ist die zentrale Transformation für die Audiokompression. Sie wird unter anderem bei mp3, AAC und Dolby Digital (ac-3) eingesetzt. Die MDCT ist eine reelle, diskrete, lineare und orthogonale Transformation und eine Modifikation der DCT-IV. Sie ist wie folgt definiert (Rao und Yip, 2001):

$$X_b[k] = \sum_{n=0}^{2N-1} x[n + bN] \cos\left(\frac{\pi(n + 0,5 - \frac{N}{2})(k + 0,5)}{N}\right), \quad \forall k \in [0, N-1]$$

(2.20)

Ein Vorteil der MDCT gegenüber der DCT-IV liegt in der Vermeidung von Blockartefakten. Dies wird in erster Linie durch die Überlappung mehrerer aufeinanderfolgender Blöcke erreicht. Diese Art der Transformation ist auch als Lapped Orthogonal Transform (LOT) bekannt (Malvar und Staelin, 1989).

Die Redundanz kann durch das Overlap-Add (OLA) Verfahren wieder entfernt werden. Dabei werden bei der inversen Transformation die entstehenden Blöcke zu 50% überlagert und aufaddiert, dieses Vorgehen wird als Overlap-Add bezeichnet.

Die Frequenzauflösung der MDCT kann durch die Gewichtung der Eingangsfolge *x[n + bN]* mit einer Fensterfunktion weiter verbessert werden. In Gleichung 2.20 entspricht das Fenster einer Rechteckfunktion, die den aktuellen Block *b* aus dem Gesamtsignal herausschneidet. Im Frequenzbereich entspricht dies einer Faltung mit der si-Funktion. Durch Anpassen dieser Fensterfunktion kann die schlechte Sperrbanddämpfung der si-Funktion verbessert und so eine erhöhte Frequenzselektivität erreicht werden. Damit die MDCT weiterhin perfekt rekonstruiert, muss die Fensterfunktion *w[n]* der Länge 2*N* den Princen-Bradley-Bedingungen (PR-Bedingungen) genügen (Princen u. a.,1987):

$$w[n] = w[2N - 1 - n]$$

(2.21a)

$$w^2[n] + w^2[n + N] = 1$$

(2.21b)

Ein einfaches Fenster, das diesen Bedingungen genügt und ausreichend Sperrbanddämpfung besitzt, ist das Sinushalbwellenfenster. Es wird unter anderem bei mp3 und AAC eingesetzt und ist wie folgt definiert (Malvar, 1992):

$$w[n] = \sin\left(\frac{\pi(n + 0,5)}{2N}\right), \quad \forall n \in [0, 2N - 1]$$

(2.22)

Durch Einsetzen der Fensterfunktion *w*[2*N* - 1 - *n*] in Gleichung 2.20 ist eine weitere wichtige Eigenschaft der MDCT zu erkennen. Das Ergebnis entspricht der diskreten Faltung von $x[n + bN]$ mit der modulierten Fensterfunktion $w[n]$. Damit gilt für $\forall k \in [0, N - 1]$ (Schuller und Smith, 1996):

$$X_k[b] = \sum_{n=0}^{2N-1} x[n + bN]\,w[2N - 1 - n]\cos\left(\frac{\pi(n + 0,5 - \frac{N}{2})(k + 0,5)}{N}\right)$$

$$(2.23)$$

So kann die MDCT nicht nur als Blocktransformation, sondern auch als modulierte Filterbank gesehen werden (Malvar, 1992). Dabei entspricht die Fensterfunktion dem Tiefpassprototyp-FIR-Filter, das mit dem Cosinus-Kernel moduliert wird und damit die Frequenzbänder der Filterbank darstellt. Daraus folgt, dass die Eingangsfolge $x[n + bN]$ in genau N Subbänder zerlegt wird. In Zusammenhang mit der TDA-Eigenschaft erfüllt die MDCT die Voraussetzungen einer sogenannten "critically sampled Filterbank".

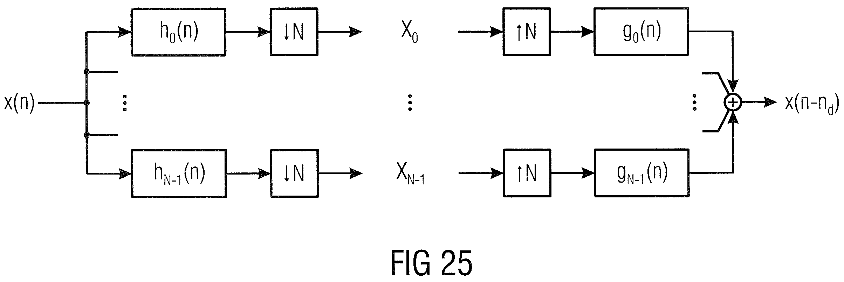

Eine solche critically sampled Filterbank ist in Fig. 25 zu sehen. Im Speziellen zeigt Fig. 25 eine $N$-Band critically sampled PR Filterbank mit einem Systemdelay von $n_d$ Samples. Für die Audiocodierung sind solche Filterbänke besonders wichtig, da sie ein Signal mit der geringsten Anzahl an Samples möglichst genau und komplett beschreiben (Rao und Yip, 2001).

Das Symbol $\downarrow N$ entspricht einer Verringerung der Abtastrate um den Faktor $1/N$ und $\uparrow N$ einer Vergrößerung um den Faktor N. Das Signal nach der Synthese-Filterbank $\hat{x}[n] = x[n - n_d]$ ist mit dem Eingangssignal $x[n]$ vor der Analyse-Filterbank bis auf ein konstantes Delay von $n_d$ Samples identisch. $h_k[n]$ ist im Fall der MDCT die modulierte Fensterfunktion $w_k[n]$. Da $w[n]$ den PR-Bedingungen genügt, sind die Analysefilter $h_k$ identisch zu den Synthesefiltern $g_k$.

Aus mathematischer Sicht bietet es sich an, lineare Gleichungssysteme, darunter alle bisher genannten Transformationen, in der Vektor-Matrix-Schreibweise zu formulieren. Ein Signal $x[n]$ der Länge $bN$ wird als Spaltenvektor $\underline{x} = [x[0], x[1], ..., x[bN - 1]]^T$ angegeben. Der Operator T kennzeichnet dabei die Transposition. Die Blockbildung lässt sich als Matrix darstellen, in der jede Spalte der Matrix einen Block von $x[n]$ enthält:

$$\underline{\underline{X}} = \begin{bmatrix} x[0] & x[N] & \ldots & x[(b-1)N] \\ x[1] & x[N+1] & \ldots & x[(b-1)N+1] \\ \vdots & \ddots & \ldots & \vdots \\ x[N-1] & x[2N-1] & \ldots & x[bN-1] \end{bmatrix}$$

$$(2.24)$$

Die Transformationsvorschrift kann ebenfalls als Matrix dargestellt werden. Die modulierten Fensterfunktionen bilden hier die Zeilen der Matrix. Es gilt für $\forall k \in [0, N - 1]$, $\forall n \in [0, 2N - 1]$:

$$\underline{\mathbf{T}}_{MDCT}(k, n) := w[n]\cos\left(\frac{\pi(n + 0,5 - \frac{N}{2})(k + 0,5)}{N}\right) \in \mathbb{R}^{N \times 2N}$$

$$(2.25)$$

Um die MDCT von $\underline{x}$ berechnen zu können, muss die Blockstruktur von $\underline{\underline{X}}$ noch um 50% Overlap für das TDA erweitert werden. Damit kann die MDCT geschrieben werden als:

$$\underline{\underline{X}} = \underline{\mathbf{T}}_{MDCT} \cdot \underline{\underline{X}}_{TDA}$$

$$(2.26)$$

mit:

$$\mathbf{X}_{TDA} = \begin{bmatrix} x[0] & x[N] & \dots & x[(b-2)N] \\ x[1] & x[N+1] & \dots & x[(b-1)N+1] \\ \vdots & \vdots & \ddots & \vdots \\ x[2N-1] & x[3N-1] & \dots & x[bN-1] \end{bmatrix}$$

$$(2.27)$$

Jede Spalte von $\mathbf{X}$ bildet das MDCT-Spektrum des betreffenden Blocks mit Index b in $\underline{x}$.

Für die Berechnung eines Blocks benötigt diese Form der MDCT $2N^2$ Multiplikationen und Additionen. Der Berechnungsaufwand kann aber deutlich reduziert werden.

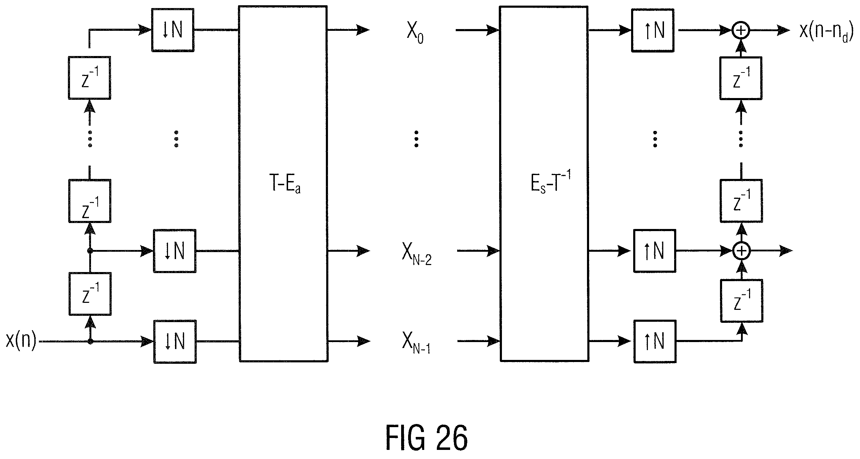

Dazu ist es notwendig, die Filterbank in Fig. 25 in eine äquivalente Polyphasenfilterbank (siehe Fig. 26) zu überführen. Mithilfe der Polyphasendarstellung und der z-Transformation lassen sich Multiratensysteme wie die MDCT-Filterbank umfangreicher analysieren.

Ein FIR-Filter $h[n]$ kann immer in $M \in \mathbb{N}$ Phasen geteilt werden, wenn die Länge des Filters einem ganzzahligen Vielfachen von $M$ entspricht. Die $m$-te Phase $p_m[n]$ von h[n] wird erzeugt, indem $h[n]$ mit $z^{-m}$ verzögert und die Abtastrate um den Faktor $M$ verringert wird (Malvar, 1992). Es gilt:

$$p_m[n] = h[nM + m]$$

$$(2.28)$$

Mit dieser Zerlegung und der z-Transformation lässt sich das Filter h[n] wie folgt darstellen (Malvar, 1992):

$$H[z] = \sum_{n=0}^{MN-1} h[n]z^{-n}$$

$$(2.29)$$

$$= \sum_{m=0}^{M-1} z^{-m} \sum_{n=0}^{N-1} h[nM + m]z^{-nM}$$

$$(2.30)$$

Anstelle der Summenschreibweise wird auch hier die Vektorschreibweise bevorzugt. Gleichung 2.30 lässt sich damit als $N$-dimensionaler Vektor darstellen:

$$\underline{\mathbf{H}} = \begin{bmatrix} H_0[z] \\ H_1[z] \\ \vdots \\ H_{N-1}[z] \end{bmatrix}$$

$$(2.31)$$

mit:

$$H_n[z] = \sum_{m=0}^{M-1} h[nM + m]z^{-nM-m}$$

(2.32)

Diese Polyphasenzerlegung kann nun auf jedes Filter der MDCT-Filterbank angewendet werden. Das Ergebnis ist die schon erwähnte äquivalente Polyphasendarstellung der Filterbank in Fig. 26 (Schuller und Smith, 1996). Dabei stellt Fig. 26 eine äquivalente N-Band critically sampled PR Polyphasenfilterbank dar.

Durch Ausnutzung von Symmetrien im MDCT-Kernel und der TDA-Eigenschaft lassen sich die Analyse- und Synthesepolyphasenfiltermatrizen $\underline{P}_a$ und $\underline{P}_s$ in je eine schwachbesetzte Foldingmatrix und eine Transformationsmatrix aufteilen (Schuller und Smith, 1996). Die oldingmatrizen $\underline{F}_a$ und $\underline{F}_s$ haben dabei eine Diamantstruktur mit den Koeffizienten der Fensterfunktion $w[n]$ als Polynome im z-Bereich. Sie lassen sich weiter in eine Fenstermatrix und eine Delaymatrix zerlegen:

$$\underline{F}_a = \underline{D} \cdot \underline{F}$$

(2.33a)

$$\underline{F}_s = \underline{F}^{\mathsf{T}} \cdot \underline{D}^{-1}$$

(2.33b)

Die genaue Form und die Aufspaltung der Foldingmatrizen wird weiter unten gezeigt. Die Transformationsmatrizen entsprechen der DCT-IV Matrix:

$$\underline{T}(k, n) := \cos\left(\frac{\pi(n + 0,5)(k + 0,5)}{N}\right) \in \mathbb{R}^{N \times N}$$

(2.34a)

$$\underline{T}^{-1} = \frac{2}{N} \cdot \underline{T}$$

(2.34b)

Mit diesen Matrizen wird das MDCT-Spektrum des in Blöcke aufgeteilten Eingangssignals $\underline{X}$ folgendermaßen berechnet (Schuller und Smith, 1996):

$$\underline{X} = \underline{T} \cdot \underline{D} \cdot \underline{F} \cdot \underline{x}$$

(2.35)

und für die inverse Transformation gilt:

$$\hat{x} = F^T \cdot D^{-1} \cdot T^{-1} \cdot X$$

(2.36)

Diese Lösung biete einige Vorteile gegenüber der Berechnung der MDCT nach Gleichung 2.26. Zunächst ist die Entstehung des Time Domain Aliasing leichter zu erkennen. Mit der Polyphasendarstellung der Foldingmatrix in Gleichung 2.33a kann der Vorgang als Umklappen gewichteter Signalanteile des Blocks $(b - 1)$ auf den aktuellen Block $b$ interpretiert werden. Durch die Addition dieser Signalanteile entsteht das TDA. Der größte Vorteil der Berechnung der MDCT über Polyphasen ist der deutlich reduzierte Berechnungsaufwand. Durch die Verwendung der quadratischen DCT-IV Matrix und der schwachbesetzten Foldingmatrix reduziert sich der Berechnungsaufwand auf $N(N + 2)$ Multiplikationen und Additionen. Durch Verwendung schneller Implementierungen der DCT ähnlich der FFT kann die Anzahl der benötigten Operationen bis auf $N(\log N + 2)$ und damit die Komplexität auf $O(N \log N)$ gesenkt werden (Rao und Yip, 2001). Aus diesen Gründen wird die MDCT hier als nach dem Polyphasenansatz implementiert angesehen.

Im Rahmen der Audiosignalverarbeitung kann es notwendig sein, ein Signal einer geringen Frequenz in höhere Frequenzen zu verschieben, wobei diese Frequenzverschiebung frei wählbar und präzise sein soll. Dieses Problem stellt sich für Audiocoder, die die höheren Frequenzen eines Signals wiederherstellen wollen. Moderne Audiocodiertechnologien verwenden Verfahren der Bandbreitenerweiterung zur effizienteren Komprimierung von Audiodaten. Neben den psychoakustischen Eigenschaften des menschlichen Gehörs wird die Korrelation der niederfrequenten Signalanteile zu den hochfrequenten Anteilen zur Datenreduktion ausgenutzt.

Ein Beispiel für die Realisierung einer Bandbreitenerweiterung ist in US2012065983 A1 beschrieben.

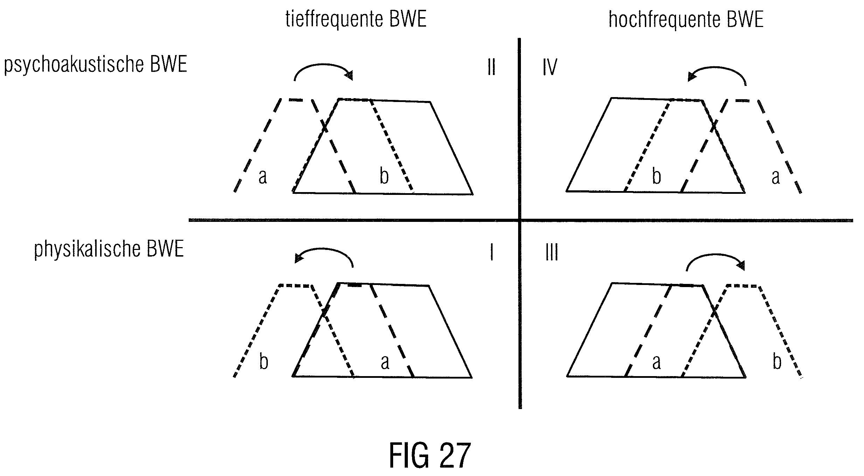

Trotz zahlreicher Möglichkeiten zur Reduktion der Datenrate durch die Audiocodierung geraten aktuelle Audiocoder bei gewünschten niedrigen Bitraten an ihre Grenzen. Gerade die psychoakustischen Verfahren produzieren dann unerwünschte Verfälschungen des Signals. Das zeigt sich in Form von störenden Artefakten wie fehlenden Höhen, verschmierten Transienten oder künstlichem Zischeln des wiedergegebenen Audiosignals. In vielen Anwendungsfällen steht aber nur begrenzt Übertragungsbandbreite zur Verfügung. Eine Lösung dieser Probleme bietet die Bandbreitenerweiterung (engl. Bandwidth Extension, BWE). Generell vereint die Bandbreitenerweiterung eine Reihe von Verfahren, mit denen ein bandbegrenztes Audiosignal spektral ausgeweitet werden kann, um wieder die ursprüngliche Bandbreite zu erhalten. Insgesamt wird zwischen vier Kategorien von Verfahren zur Bandbreitenerweiterung unterschieden (Larsen und Aarts, 2004). Diese sind in Fig. 27 grafisch dargestellt.

Fig. 27 zeigt Kategorien der Bandbreitenerweiterung (Larsen und Aarts, 2004). In Fig. 27, oben links ist Low-frequency psychoacoustic BWE gezeigt. In Fig. 27, oben rechts ist High-frequency psychoakoustic BWE zu sehen. In Fig. 27, unten links ist Low-frequency BWE dargestellt. Ferner ist in Fig. 27, unten rechts High-frequency BWE dargestellt. Die Energie des Bandes 'a' (gestrichelte Linie) wird in das Band 'b' (gepunktete Linie) geschoben.

Für die Audiocodierung ist nur die Kategorie III (unten rechts in Fig. 27) nützlich. Bei der sogenannten "High-frequency BWE" werden die im bandbegrenzten Signal vorhandenen Frequenzen genutzt, um den hochfrequenten Bereich des Spektrums zu rekonstruieren. Die Idee ein solches Verfahren zur Bandbreitenerweiterung von Audiosignalen zu benutzen ist darin begründet, dass zwischen dem hochfrequenten und niederfrequenten Anteil des Signals eine starke Korrelation vorliegt. Damit ist es möglich, die fehlenden hohen Frequenzen aus den vorhandenen tiefen Signalanteilen zu rekonstruieren (Larsen und Aarts, 2004). Im Folgenden werden aktuelle Techniken und Verfahren vorgestellt, womit ein bandbegrenztes Signal mittels Highfrequency BWE auf seine ursprüngliche Bandbreite erweitert werden kann.

Aus dem Stand der Technik ist dabei die Spektralbandreplikation (englisch: Spectral Band Replication; SBR) bekannt, wie sie unter anderem in HE-AAC eingesetzt wird. Bei der Spektralbandreplikation mit SBR werden Korrelationen zwischen nieder- und hochfrequenten Signalanteilen ausgenutzt, um das durch den Encoder bereitgestellte Tiefpasssignal spektral aufzuweiten. Die niedrigen Frequenzbänder der zugrundeliegenden Filterbank werden auf die fehlenden hohen Bänder kopiert und die spektrale Einhüllende angepasst. Dieser Kopierprozess verursacht, insbesondere bei niedrigen Grenzfrequenzen, wahrnehmbare Artefakte wie Rauigkeit und unerwünschte Klangfarbenänderung. Diese werden hauptsächlich durch die fehlende harmonische Fortsetzung des Spektrums an der Grenze zwischen Basisband und den algorithmisch erzeugten hohen Frequenzbändern hervorgerufen.

Ein SBR Audiocoder aus dem Stand der Technik verwendet eine pQMF Subbandzerlegung des Signals und gewährleistet auf diese Weise eine hohe Codiereffizienz [Ekstrand 2002]. Dies wird dadurch erreicht, dass lediglich die unteren Frequenzbänder übertragen werden, während die höheren Frequenzanteile unter Hilfe von Seiteninformation und der zuvor erwähnten Frequenzverschiebung der unteren Bänder rekonstruiert werden.

Die Spectralbandreplikation ist das zurzeit am weitesten verbreitete Verfahren zur Bandbreitenerweiterung. Es wird unter anderem in HE-AAC und mp3PRO eingesetzt. Entwickelt wurde SBR von dem Unternehmen Coding Technologies mit dem Ziel, die Effizienz vorhandener Audiocoder zu erhöhen. Das wird erreicht, indem nur Frequenzen unterhalb einer bestimmten Eckfrequenz $f_g$ von einem Encoder verarbeitet werden. In den genannten Beispielen werden mp3- und AAC-Encoder als Core-Coder eingesetzt. Frequenzen, die über der Eckfrequenz liegen, werden nur durch wenige Parameter beschrieben. Je nach zu erreichender Qualität liegt diese zwischen 5kHz und 13kHz. Im Empfänger werden dann mit Hilfe dieser Seiteninformationen und dem decodierten bandbegrenzten Signal die hohen Frequenzanteile rekonstruiert (Ekstrand, 2002).

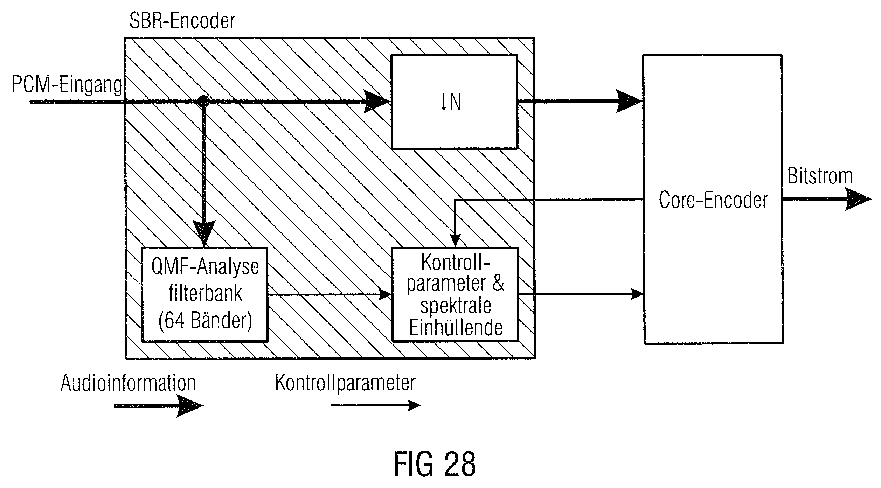

Fig. 28 zeigt das Blockschaltbild eines erweiterten SBR-Encoders. Die Abtastrate des Eingangssignals wird herabgesetzt und anschließend dem eigentlichen Encoder zugeführt. Parallel dazu wird das Signal durch eine komplexe Quadrature-Mirror-Filterbank (QMF) analysiert und eine Energieberechnung durchgeführt. Die genutzte QMF besteht aus 64 Teilbändern. Daraus lassen sich dann die erforderlichen Parameter für die Schätzung der spektralen Einhüllenden ableiten. Weitere Parameter ermöglichen es, auf die speziellen Charakteristiken des Eingangssignals zu reagieren. Durch die Kenntnis des SBR-Encoders über die Erzeugung des hohen Frequenzbands kann dieser starke Unterschiede zwischen dem ursprünglichen und synthetisierten Hochfrequenzanteil (HF) erkennen.

Sind im Signal beispielsweise stark ausgeprägte Einzeltöne oberhalb der Grenzfrequenz vorhanden, so werden diese durch zusätzliche Parameter beschrieben und können dem rekonstruierten Signal wieder zugeführt werden. Die erzeugten Seiteninformationen wird neben den eigentlichen Audiodaten in den ausgehenden Bitstrom eingefügt (Larsen und Aarts, 2004).

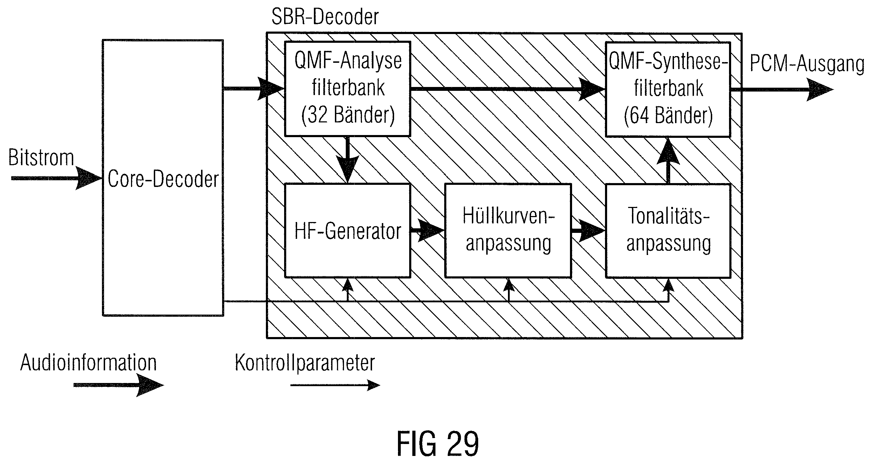

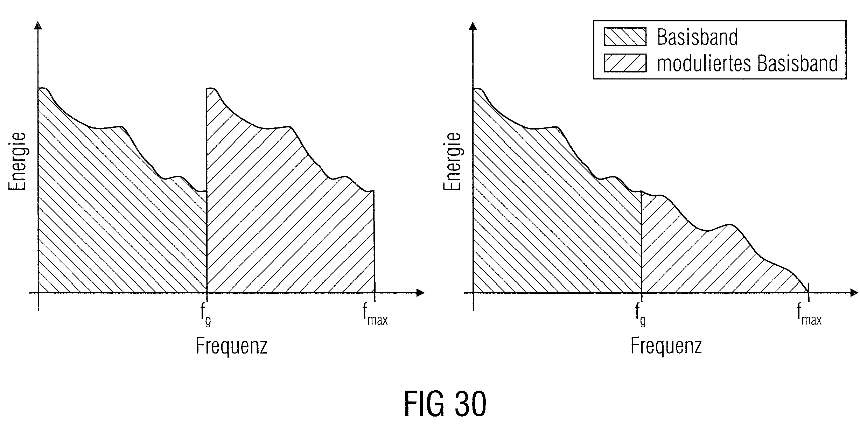

Fig. 29 zeigt das Blockschaltbild des zugehörigen, mit SBR erweiterten Decoders dargestellt. Die bandbegrenzten Audiodaten werden durch den Decoder decodiert und die Kontrollparameter aus dem Bitstrom extrahiert. Anschließend werden die Audiodaten zur Rekonstruktion der hohen Frequenzanteile wieder einer QMF-Filterbank zugeführt. Innerhalb dieser Filterbank wird das Basisband kopiert und oberhalb der Grenzfrequenz eingefügt (vgl. Fig. 30, links).

Fig. 30 zeigt schematisch den Betragsfrequenzgang. Dabei ist Fig. 30 eine schematische Darstellung der SBR-HF-Rekonstruktion. In Fig. 30, links ist ein Kopieren und Verschieben des Basisbands gezeigt. In Fig. 30, rechts ist ein Spektrum nach der Anpassung der spektralen Einhüllenden dargestellt.

Die im SBR-Encoder erzeugte Information über die spektrale Einhüllende wird nun verwendet, um die Hüllkurve des kopierten Spektrums an die ursprüngliche anzugleichen. Diese Adaption erfolgt anhand der übertragenen Kontrollparameter und der Energie des jeweiligen QMF-Bands. Weichen die Eigenschaften des rekonstruierten Spektrums von den ursprünglichen ab, werden dem Signal zusätzlich tonale Komponenten oder Rauschen hinzugefügt (Larsen und Aarts, 2004). In Fig. 30, rechts ist das angepasste rekonstruierte Spektrum zu sehen.

Abschließend werden das bandbegrenzte Signal und das rekonstruierte hochfrequente Signal zusammengeführt und durch die Synthese-Filterbank in den Zeitbereich überführt. Auf diese Weise ist ein bandbreitenerweitertes Signal entstanden, das nun wiedergegeben werden kann.

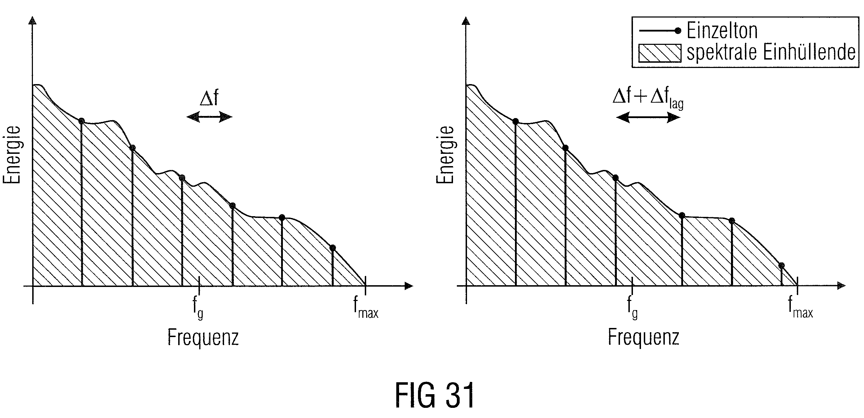

Bei dieser Art der Bandbreitenerweiterung entstehen Probleme bei sehr tonalen Signalen mit einer stark ausgeprägten harmonischen Struktur. Auch wenn das SBR-Verfahren Techniken zur tonalen Anpassung des Spektrums vorsieht, reichen diese nicht aus, um eine zerstörte harmonische Struktur wiederherzustellen. Das Resultat ist eine wahrnehmbare Rauigkeit (engl. roughness) im Signal (Wilde, 2009). Dieses Artefakt ist für den Hörer sehr unangenehm. Der Ursprung liegt im Kopierprozess des SBR-Decoders. Hier wird keine Rücksicht auf die harmonische Feinstruktur des Signals gelegt und einfach das Basisband repliziert. Das Ergebnis ist in Fig. 31 zu sehen.

Fig. 31 zeigt eine Zerstörung der harmonischen Struktur bei SBR. In Fig. 31, links ist ein ursprüngliches Breitbandspektrum gezeigt. In Fig. 31, rechts ist ein Spektrum nach der SBR HF-Rekonstruktion gezeigt.

Es ist deutlich zu erkennen, dass im Bereich oberhalb der Grenzfrequenz die Harmonischen zum ursprünglichen Spektrum verschoben sind. Zwar ist das rekonstruierte HF-Spektrum in sich harmonisch, jedoch ist die harmonische Struktur bei der Grenzfrequenz um einen zusätzlichen Frequenzhub $f_{lag}$ gespreizt. Zudem werden durch die Rekonstruktion der Hüllkurve die Amplitudenverhältnisse der harmonischen Teiltöne verzerrt. Dieser Effekt tritt bei allen harmonischen Signalen auf, wie sie beispielsweise durch Musikinstrumente entstehen.

Für harmonische Signale, wie z.B. eine Pitch-Pipe erzeugt die SBR und äquivalente Bandbreitenerweiterungsverfahren dabei unerwünschte Artefakte, wie z.B. klangliche Rauheit und unschöne Klangfarben, da die harmonische Struktur des Signals nicht vollständig erhalten bleibt. Für Signale, die eine ausgeprägte harmonische Struktur aufweisen, treten bei Anwendung der SBR unerwünschte Artefakte wie Rauigkeit und Timbreänderungen auf.

Deshalb wurden zwei Zeitdomänen-Bandbreitenerweiterungsverfahren (englisch: Bandwidth Extension) entwickelt, die diese Strukturen erhalten: Die Phasen Vocoder-gesteuerte harmonische Bandbreitenerweiterung (englisch: Harmonie Bandwidth Extension; HBE) und die kontinuierliche Modulation (Continuous Modulation; CM)-BWE, die einzelne Seitenband-Modulation verwenden [Nagel und Disch 2009], [Nagel u. a. 2010]. Besonders die CM-BWE erzielt eine gute harmonische Wiederherstellung wegen der kontinuierlichen Modulation mit frei wählbaren Frequenzen.

Es existieren einige alternative Bandbreitenerweiterungsverfahren, die das Problem der unharmonischen spektralen Fortsetzung vermeiden. Im Folgenden werden zwei dieser Verfahren vorgestellt. Im Wesentlichen ersetzen diese Verfahren den HF-Generator des SBR-Decoders in Fig. 29 und stellen damit eine Alternative zum einfachen Kopierprozess dar. Die Anpassung der spektralen Einhüllenden und der Tonalität bleiben unverändert. Da das Eingangssignal im Zeitbereich vorliegen muss, werden diese Verfahren auch als Zeitbereichsverfahren zur Bandbreitenerweiterung bezeichnet.

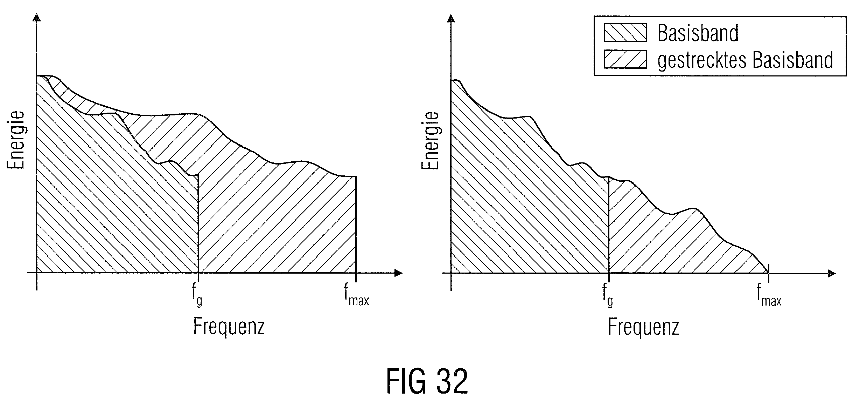

Zunächst kann die Harmonische Bandbreitenerweiterung genannt werden. Die harmonische Bandbreitenerweiterung (engl. *Harmonic Bandwidth Extension,* HBE) nutzt einen Phasenvocoder zur Erzeugung des Hochtonbereichs. Durch die Anwendung eines Phasenvocoders wird das Spektrum gestreckt. Wie in Fig. 32, links dargestellt, wird das Basisband bis auf die maximale Signalfrequenz $f_{max}$ gespreizt und der Frequenzbereich zwischen der Grenzfrequenz und $f_{max}$. ausgeschnitten. Das Spektrum setzt sich dann aus diesem Ausschnitt und dem Basisband zusammen (vgl. Fig. 32, rechts). Die Einhüllende wird, wie bei SBR, angepasst (Nagel und Disch, 2009).

Fig. 32 ist eine schematische Darstellung der HBE-HF-Rekonstruktion. In Fig. 32, links ist eine Streckung des Basisbands um den Faktor 2 gezeigt. In Fig. 32, rechts ist ein Spektrum nach der Anpassung der spektralen Einhüllenden gezeigt.

Durch die Nutzung von ganzzahligen Streckungsfaktoren $\sigma \in \mathbb{N}^+$ ist gewährleistet, dass an der Grenzfrequenz $f_g$ die harmonische Struktur nicht verändert wird. Es gilt:

$$f_{max} = \sigma \cdot f_g$$

$$(3.1)$$

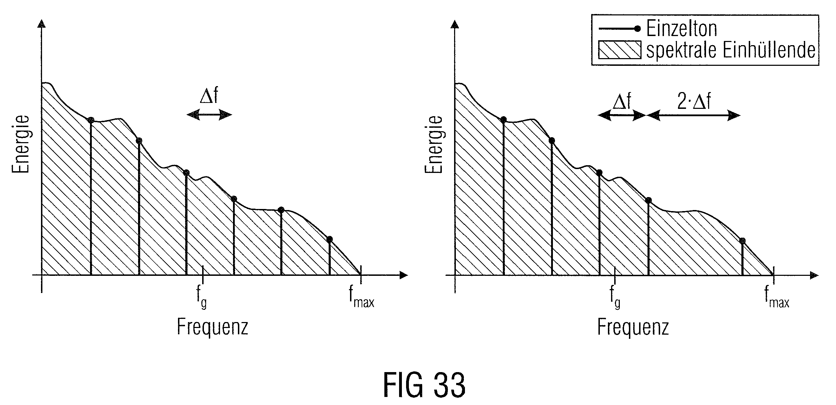

Von Nachteil ist, dass sich durch die Spreizung des Spektrums der Abstand zwischen den Teiltönen im HF-Bereich mit dem Streckungsfaktor ändert, wie in Fig. 33 zu erkennen ist. Zudem sind aufwändige Berechnungen notwendig, um das Spektrum zu spreizen. Darunter fallen eine hochauflösende DFT, Anpassung der Phase und Abtastratenwandlung (Dolson, 1986). Ist das Audiosignal in Blöcke unterteilt, wird zusätzlich eine Overlap-Add-Struktur benötigt, um die Phase der benachbarten Blöcke kontinuierlich fortsetzten zu können. Für sehr tonale Signale lassen sich mit der Phasenvocodertechnik sehr gute Ergebnisse erzielen, bei perkussiven Signalen verschmieren aber die Transienten und es wird notwendig, eine separate Transientenbehandlung vorzunehmen (Wilde, 2009).

Fig. 33 zeigt eine harmonische Struktur bei HBE. In Fig. 33, links ist ein ursprüngliches Breitbandspektrum gezeigt. In Fig. 33, rechts ist Spektrum nach der HBE HF-Rekonstruktion dargestellt.

Im Folgenden wird die kontinuierliche Einseitenbandmodulation dargestellt.

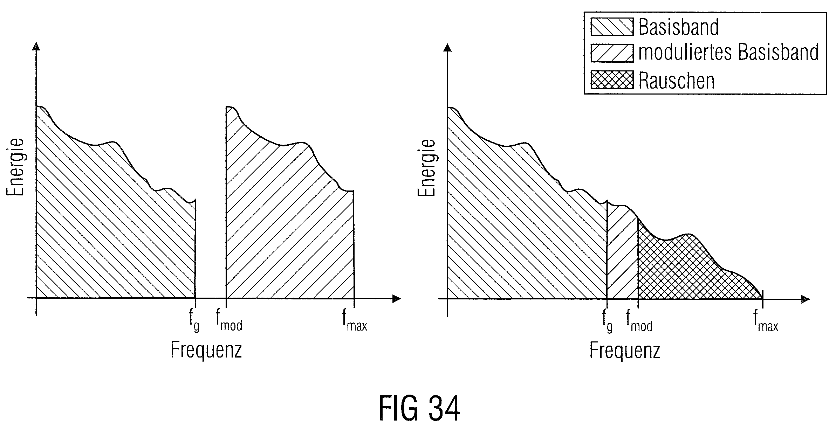

Die kontinuierliche Einseitenbandmodulation (engl. Continuously Modulated Bandwidth Extension, CM-BWE) ist ein weiteres Zeitbereichsverfahren zur Bandbreitenerweiterung. Bei diesem Verfahren wird das Basisband mittels Einseitenbandmodulation mit der Frequenz $f_{mod}$ moduliert und so an einen anderen spektralen Ort verschoben, wie in Fig. 34 dargestellt. Durch eine variable Modulationsfrequenz kann gewährleistet werden, dass die harmonische Struktur des bandbreitenerweiterten Signals erhalten bleibt. Bei Modulationsfrequenzen, die größer sind als die Grenzfrequenz $f_g$, muss die entstehende Lücke im Spektrum durch Rauschen gefüllt werden (Nagel u. a., 2010).

Fig. 34 zeigt eine schematische Darstellung der CM-BWE-HF-Rekonstruktion. In Fig. 34, links ist eine Modulation des Basisbands mit der Frequenz $f_{mod}$ dargestellt. In Fig. 34, rechts ist ein Spektrum nach der Anpassung der spektralen Einhüllenden gezeigt.

Neben dem in Fig. 34 dargestellten Fall kann es auch notwendig werden, das Basisband mehrmals zu modulieren. In einem solchen Fall muss die Modulationsfrequenz für jede Modulation angepasst werden, in dem jeweils ihr nächstes ganzzahliges Vielfaches gewählt wird (Nagel u. a., 2010). Vor der Modulation muss das Basisband entsprechend der Modulationsfrequenz durch einen Tiefpass gefiltert werden, damit nach der Modulation die maximal mögliche Signalfrequenz $f_{max}$ nicht überschritten wird. Ähnlich zu den bereits vorgestellten Verfahren wird anschließend die spektrale Einhüllende geformt und die Tonalität angepasst.

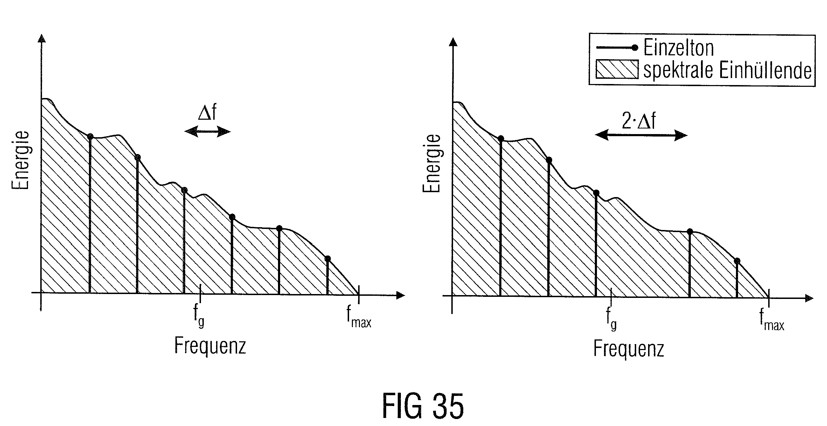

In Fig. 35 ist die harmonische Struktur zu sehen, wie sie in einem mittels CM-BWE erweitertes Signal entsteht. In Fig. 35, links ist ein ursprüngliches Breitbandspektrum zu sehen. In Fig. 35, rechts ist ein Spektrum nach der CM-BWE HF-Rekonstruktion dargestellt. Wie bei dem HBE-Verfahren fehlt bei CM-BWE ein harmonischer Teilton im Spektrum. Dies fällt aber nicht störend auf, da die harmonische Struktur an sich erhalten bleibt.

Nachteile dieses Verfahrens liegen in der Berechnung der Einseitenbandmodulation. Für eine korrekte Berechnung wird ein analytisches Signal benötigt, also ein Signal, das nur positive Frequenzen aufweist. Für die Berechnung eines solchen Signals ist ein Hilbert-Transformator erforderlich. Dabei handelt es sich im Wesentlichen um ein akausales Filter mit unendlicher Impulsantwort. Ein solches Filter lässt sich nicht realisieren und muss vereinfacht werden. Um dennoch bei einer minimalen Ordnung des Filters eine möglichst hohe Sperrbanddämpfung zu erreichen, wird dem Signal ein nicht vernachlässigbares Delay durch die Kausalisierung des Filters hinzugefügt (Wilde, 2009).

Wird die Frequenzverschiebung aber in der Zeitdomäne realisiert, kann sich dies sehr komplex darstellen. Die Realisierung der Verschiebung in der Subband-Domäne eines Subband-Audiocodierers kann dagegen dazu führen, dass die Frequenzauflösung zu grob für die benötigten Frequenzverschiebungen ist.

Wünschenswert ist, den durch die Codierung von Audiosignalen den benötigten Speicherbedarf der digitalen Daten, beziehungsweise die benötigte Bandbreite zur Übertragung dieser Daten, zu minimieren. Gleichzeitig soll die wahrgenommene Qualität des reproduzierten Audiosignals mit dem CD-Standard (Abtastfrequenz 44100 Hz bei 16 Bit Quantisierungstiefe) vergleichbar sein. Dabei soll bei sinkender Datenrate die Qualität maximiert werden.

Es ist daher eine Aufgabe der vorliegenden Erfindung, verbesserte Konzepte für frei wählbare Frequenzverschiebungen in der Subband-Domäne bereitzustellen. Die Aufgabe der vorliegenden Erfindung wird durch eine Vorrichtung nach Anspruch 1, durch ein Verfahren nach Anspruch 23 und durch ein Computerprogramm nach Anspruch 24 gelöst.

Eine Vorrichtung zur Erzeugung eines frequenzverschobenen Audiosignals basierend auf einem Audioeingangssignal wird bereitgestellt. Das Audioeingangssignal ist dabei für eine Mehrzahl von ersten Subbändern durch einen oder mehrere erste Subband-Werte darstellbar. Die Vorrichtung umfasst eine Schnittstelle und eine Frequenzverschiebungseinheit. Die Schnittstelle ist zum Empfang des Audioeingangssignals eingerichtet. Die Frequenzverschiebungseinheit ist zur Erzeugung des frequenzverschobenen Audiosignals eingerichtet, wobei das frequenzverschobene Audiosignal für eine Mehrzahl von zweiten Subbändern jeweils einen oder mehrere zweite Subband-Werte aufweist. Ferner weist jeder der ersten und der zweiten Subband-Werte Information über jeweils einen Phasenwinkel auf.

Die Frequenzverschiebungseinheit ist ferner dafür eingerichtet, einen der zweiten Subband-Werte basierend auf einem der ersten Subband-Werte so zu erzeugen, dass der zweite Phasenwinkel dieses zweiten Subband-Werts sich von dem ersten Phasenwinkel dieses ersten Subband-Werts um eine Phasenwinkel-Differenz unterscheiden kann, wobei die Phasenwinkel-Differenz von einer Frequenzinformation abhängt, die angibt, um welche Frequenzdifferenz das Audioeingangssignal zu verschieben ist, um das frequenzverschobene Audiosignal zu erhalten, und wobei die Phasenwinkel-Differenz von einer Frequenz-Bandbreite von einem der ersten Subbänder abhängt.

Ausführungsformen stellen verbesserte Konzepte zur Bandbreitenerweiterung bereit, wobei diese verbesserten Konzepte im Folgenden als "harmonische Spektralbanderweiterung" oder "HSBE" bezeichnet werden. Diese entwickelte harmonische Bandbreitenerweiterung im Frequenzbereich ermöglicht es, unerwünschte Artefakte zu unterdrücken. Das replizierte Spektrum wird dabei so moduliert, dass die ursprüngliche harmonische Struktur erhalten bleibt. HSBE kann dabei im Gegensatz zu anderen Verfahren auf der Signaldarstellung im MDCT-Bereich basieren, und erlaubt damit eine effiziente Implementierung. Die harmonisch korrekte Bandbreitenerweiterung wird durch einen Kopiervorgang der Spektralwerte mit anschließender Modulation erreicht.

Gemäß einer Ausführungsform wird die Subband-Domäne der MDCT verwendet, die üblicherweise bereits in Audiocodierern realisiert wird. Auf diese Weise führt die Transformation nicht zu zusätzlicher Komplexität oder Verzögerung.

In Ausführungformen werden, wenn das Signal um ein gerades ganzzahliges Vielfaches der Subband-Bandbreite verschoben wird, die Subband-Signale unterer Frequenzen in die entsprechenden höheren Frequenzbänder verschoben.

Wenn das Signal um ein ungerades ganzzahliges Vielfaches zu verschieben ist, wird in Ausführungsformen jeder zweite Abtastwert der Subband-Signale, die zu kopieren sind, mit umgekehrten Vorzeichen versehen (ansteigender Blockindex, in Richtung der Zeit). Auf diese Weise funktioniert die Aliasing-Kompensationseigenschaft (englisch: Alias Cancellation Property) der MDCT Filterbank auch noch für das Frequenz-verschobene und kopierte Signal.

Wenn die Signale unterer Frequenzen um ein nicht-ganzzahliges Vielfaches der Subband-Bandbreite verschoben werden, werden in Ausführungsformen komplexwertige Versionen der Subbänder unterer Frequenzen erzeugt, es wird eine Kopie von diesen genommen und diese werden mit einer komplexen Exponentialfunktion moduliert (multipliziert), wobei diese komplexe Exponentialfunktion eine Frequenz hat, die der Differenz der Frequenz des nächsten ganzzahligen Vielfachen der Subband-Bandbreite entspricht (es liegt eine gebrochene Subband-Bandbreitenverschiebung vor). Hierdurch wird jedoch die Aliasing-Kompensationseigenschaft der MDCT Filterbank beeinträchtigt bzw. zerstört.

Um die resultierende Frequenzverzerrung zu verhindern oder zu reduzieren, wird ein faltungs-ähnliches Verarbeiten zwischen benachbarten Subband-Signalen durchgeführt, wobei eine gewichtete Version des einen Subband-Signals zu dem Subband-Signal einer in seiner Nachbarschaft befindlichen Subbands hinzuaddiert, so dass es das umgekehrte Vorzeichen der Aliasing-Komponente dort hat, und so dass das Aliasing kompensiert oder reduziert wird. In einer Ausführungsform werden die Gewichte dabei so gewählt, dass sie der gewünschten gebrochenen Frequenzverschiebung entsprechen.

Durch die Modulation des Spektrums wird also die TDAC-Eigenschaft der MDCT verletzt, so dass Aliasing-Komponenten auftreten. Um diese zu eliminieren, wird in Ausführungsformen eine FIR-Filterstruktur zur Aliasing-Cancelation bereitgestellt. Die dazu benötigten Filterimpulsantworten werden mittels sukzessiver Approximation optimiert und beispielsweise als Look-Up-Tabelle hinterlegt.

Für die Anwendbarkeit der hier vorgestellten Konzepte ist es nicht erforderlich, den Encodierungsprozess, also das Komprimieren der Daten beispielsweise über Anwendung eines psychoakustischen Modells anzupassen.

Die bereitgestellten Konzepte setzen auf bereits vorhandenen Bandbreitenerweiterungsverfahren auf und verbessern diese. Mit diesem neuen Verfahren ist es möglich, die Qualität des wiedergegebenen Audiomaterials bei gleichbleibendem Speicherbedarf zu erhöhen. Es wird dabei nicht der Encodierprozess beeinflusst, sondern der Decoder weiterentwickelt. Das entwickelte Verfahren realisiert eine harmonische Bandbreitenerweiterung. Es baut dabei auf der Spektralbandreplikation (SBR) auf, wie sie in der HE-AAC-Technologie verwendet wird.

Die bereitgestellten erfinderischen, effizienten Spektralbandreplikations-Konzepte erhalten die harmonische Struktur des ursprünglichen Spektrums und reduzieren somit die beschriebenen Artefakte der bekannten SBR Technologie.

Konzepte für die harmonischen Spektralbanderweiterung (HSBE) werden bereitgestellt. Da gerade die Effizienz eine entscheidende Rolle spielt, wird die zugrundeliegende Signalverarbeitung von der verwendeten Filterbank bis hin zur Unterdrückung von Artefakten durch FIR-Filter beschrieben.

Die hier vorgestellte harmonische Spektralbanderweiterung schafft eine leistungsfähige und effiziente Möglichkeit, das bandbegrenzte Spektrum eines Audiosignals unter Fortsetzung der harmonischen Struktur zu erweitern.

Es wird gezeigt, dass bei der harmonischen Spektralbanderweiterung zahlreiche Problemstellungen zu beachten sind, damit das Spektrum korrekt harmonisch fortgesetzt werden kann. Auch wenn schon einige Verfahren zur Rekonstruktion der harmonischen Struktur des Spektrums bekannt sind, ist es dennoch sinnvoll, neue und effizientere Techniken zu entwickeln. Gerade für die Integration in moderne Audiocoder-Strukturen wie AAC oder USAC ist eine Anpassung an die dort geltenden Rahmenbedingungen unabdingbar.

Ein wesentlicher Bestandteil zur erfolgreichen harmonischen Spektralbanderweiterung ist die Unterdrückung auftretender Störkomponenten. Gerade deswegen liegt ein Schwerpunkt hier auf der Funktionsweise und Optimierung der dafür entworfenen Aliasing-Cancelation. Es zeigt sich, dass durch die Wahl geeigneter FIR-Filter die unerwünschten Signalanteile stark reduziert werden können. Dabei wird nicht wie bei der klassischen Filterung ein Zeitsignal mit der Filterimpulsantwort gefaltet, sondern die komplexen MDCT/MDST-Koeffizienten. Auch wenn durch dieses Verfahren nicht alle auftretenden Aliasing-Komponenten ausgelöscht werden können, so genügt es, einige dominante Störanteile zu eliminieren.

Daneben bildet die Transformation der MDCT-Koeffizienten in MDST-Spektralwerte ein weiteres wichtiges Element der harmonischen Spektralbanderweiterung. Moderne Audiocoder arbeiten ausschließlich im MDCT-Bereich. Zwar wird das Signal ausreichend genau in seiner spektralen Darstellung beschrieben, trotzdem reicht diese Information für die Replikation des Spektrums mit HSBE nicht aus. Der benötigte Phasenverlauf kann erst durch zusätzliche MDST-Koeffizienten modifiziert werden. Hierfür wird eine Transformation eingeführt, die es mit einem konstanten Delay ermöglicht, aus den bekannten MDCT-Werten möglichst effektiv die fehlenden MDST-Koeffizienten zu berechnen. Neben einer exakten Lösung wird eine fehlerbehaftete aber ressourcensparende Alternative vorgestellt.

Wichtig bei der HSBE ist die Modulation des Spektrums. Hier zeigt sich, dass zur effizienten Replikation des Spektrums zwei Schritte sinnvoll sind. Zum einen wird das Spektrum um ganzzahlige MDCT-Teilbänder verschoben und zum anderen für eine Feinauflösung eine Modulation innerhalb der Bandbreite eines MDCT-Teilbands durchgeführt. Für Signale in CD-Qualität liegt die erzielte Auflösung mit dieser Technik bei circa 0,5 Hz. Damit kann die harmonische Struktur des Spektrums sehr genau repliziert werden.

Die für die Bestimmung der zur Modulation notwendigen Lag-Frequenz kann zum Beispiel durch den Encoder bereitgestellt werden.

In Ausführungsformen werden ein System, eine Vorrichtung oder ein Verfahren oder ein Computerprogramm bereitgestellt, um ein Frequenz-verschobenes Signal zu erzeugen, wobei Subbandzerlegung verwendet wird, wobei für gebrochene Subband-Bandbreitenverschiebungen die Subbänder durch Multiplikation mit einer komplexen Exponentialfunktion multipliziert werden.

In Ausführungsformen werden die Aliasing-Komponenten kompensiert oder zumindest reduziert, indem eine Butterfly-Verarbeitung zwischen benachbarten Subband-Signalen durchgeführt wird.

Gemäß weiterer Ausführungsformen wird die Frequenzverschiebung in der Subband-Domäne eines Audiocodiersystems durchgeführt.

In Ausführungsformen wird die Frequenzverschiebung verwendet, um fehlende Frequenzanteile und/oder spektrale Löcher einer Frequenzdarstellung eines Signals in einem Audiocodiersystem zu erfüllen.

Gemäß Ausführungsformen wird die Frequenzverschiebung in Kombination mit der Abtastraten-Umwandlung verwendet, um die Abspielgeschwindigkeit zu verändern, wobei der Pitch erhalten bleibt.

Erhöht man beispielsweise durch Frequenzverschiebung zunächst die Frequenz und verringert man sodann die Abspielgeschwindigkeit, verlängert sich die Abspielzeit einer bestimmten Menge Audiodaten bei gleichbleibendem Pitch. Verringert man beispielsweise umgekehrt durch Frequenzverschiebung zunächst die Frequenz und erhöht man sodann die Abspielzeit der bestimmten Menge Audiodaten, so verkürzt sich die Abspielzeit bei gleichbleibendem Pitch.

In weiteren Ausführungsformen werden die Konzepte dafür verwendet, ein Musiksignal fein einzustellen. Die bereitgestellten Konzepte können beispielsweise besonders vorteilhaft im Rahmen von Auto Tune eingesetzt werden. Sollen zum Beispiel nur kleine Tonhöhenänderungen eines digitalen Musiksignals realisiert werden, beispielsweise Frequenzänderungen, die kleiner als die Bandbreite eines Subbands sind, wie zum Beispiel kleiner als ein MDCT- oder ein QMF-Subband, sind die bereitgestellten Konzepte besonders vorteilhaft.

Gemäß Ausführungsformen werden die Konzepte verwendet, um höhere Frequenzen eines Spektrums zu erzeugen, indem geringere Frequenzanteile eines Spektrums kopiert oder Frequenz-verschoben werden.

In Ausführungsformen ist die Subband-Zerlegung eine modifizierte diskrete CosinusTransformation (englisch: Modified Discrete Cosine Transform; MDCT).

In weiteren Ausführungsformen ist die Subband-Zerlegung eine Polyphasen Quadratische Spiegelfilterbank (englisch: Quadrature Mirror Filterbank; QMF).

Die in obigen Ausführungsformen bereitgestellten Konzepte können unter anderem sowohl als ein System, eine Vorrichtung oder ein Verfahren oder ein Computerprogramm realisiert werden.

Auf Basis der bereitgestellten entwickelten Algorithmen und Funktionsprinzipien ist eine lauffähige Implementierung der harmonischen Spektralbanderweiterung entstanden. Eine echtzeitfähige Implementierung in Matlab oder in der Programmiersprache C oder in einer anderen Programmiersprache ist möglich. Die Anwendung der bereitgestellten Konzepte in Echtzeitsystemen ist somit möglich. Es ist zu erwarten, dass sich durch diese Verfahren die Qualität des reproduzierten Signals erhöht, wie es auch bei SBR der Fall ist.

Die Analyse der Komplexität der Modulation des Spektrums gemäß den bereitgestellten Konzepten liefert sehr gute Werte. Dabei hängt der Rechenaufwand maßgeblich von der MDCT-MDST-Transformation ab.

Des Weiteren wird ein Verfahren zur Erzeugung eines frequenzverschobenen Audiosignals basierend auf einem Audioeingangssignal bereitgestellt, wobei das Audioeingangssignal für eine Mehrzahl von ersten Subbändern durch einen oder mehrere erste Subband-Werte darstellbar ist.

Das Verfahren umfasst:

Empfangen des Audioeingangssignals, und
Erzeugen des frequenzverschobenen Audiosignals, wobei das frequenzverschobene Audiosignal für eine Mehrzahl von zweiten Subbändern jeweils einen oder mehrere zweite Subband-Werte aufweisen,
wobei jeder der ersten und der zweiten Subband-Werte Information über jeweils einen Phasenwinkel aufweist, und wobei einer der zweiten Subband-Werte basierend auf einem der ersten Subband-Werte so erzeugt wird, dass der zweite Phasenwinkel dieses zweiten Subband-Werts sich von dem ersten Phasenwinkel dieses ersten Subband-Werts um eine Phasenwinkel-Differenz unterscheiden kann, wobei die Phasenwinkel-Differenz von einer Frequenzinformation abhängt, die angibt, um welche Frequenzdifferenz das Audioeingangssignal zu verschieben ist, um das frequenzverschobene Audiosignal zu erhalten, und wobei die Phasenwinkel-Differenz von einer Frequenz-Bandbreite von einem der ersten Subbänder abhängt.

Ferner wird ein Computerprogramm zur Durchführung des obigen Verfahrens, wenn das Computerprogramm auf einem Computer oder Signalprozessor ausgeführt wird, bereitgestellt.

Bevorzugte Ausführungsformen finden sich in den abhängigen Ansprüchen.

Im Folgenden werden bevorzugte Ausführungsformen unter Bezugnahme auf die Zeichnungen beschrieben, in denen:

Fig. 1a      eine Vorrrichtung zur Bandbreitenerweiterung gemäß einer Ausführungsform zeigt,
Fig. 1b      eine Vorrichtung gemäß einem Ausführungsbeispiel, bei der die Vorrichtung dafür eingerichtet ist, ein frequenzverbreitertes Audiosignal zu erzeugen, zeigt,
Fig. 2      eine schematische Darstellung der HSBE-HF-Rekonstruktion gemäß einer Ausführungsform zeigt,
Fig. 3      eine Vorrichtung 300 zur Erzeugung zur Erzeugung eines frequenzverschobenen Audiosignals gemäß einer Ausführungsform zeigt,
Fig. 4A, 4B      eine Abschätzung der MDCT-MDST-Transformationsmatrix gemäß einer Ausführungsform zeigt,
Fig. 5      Impulsantworten der MDCT-MDST-Transformationsmatrizen gemäß einer Ausführungsform darstellt,
Fig. 6      eine Schätzung des MDST-Spektrums für weißes Rauschen zeigt,
Fig. 7      eine harmonische Struktur bei HSBE gemäße einer Ausführungsform zeigt,
Fig.8      ein Schema der erweiterten HSBE-HF-Rekonstruktion gemäß einer Ausführungsform darstellt,
Fig. 9      Aliasing-Komponenten für $\varphi = 45°$ darstellt,
Fig. 10      eine Filterimpulsantwort eines Anti-Aliasing-Filters gemäß einem Ausführungsbeispiel für $\varphi = 90°$ darstellt,
Fig. 11      den Einfluss der Anti-Aliasing-Filterung auf ein Sinussignal für $\varphi = 90°$ gemäß einer Ausführungsform zeigt,
Fig. 12      eine Butterfly-Struktur zur Aliasing-Reduzierung gemäß einer Ausführungsform zeigt,
Fig. 13      eine HSBE-LPC-Hüllkurvenanpassung gemäß einer Ausführungsform zeigt,
Fig. 14      die Komplexität der Modulation und Anti-Aliasing-Filterung von HSBE darstellt,
Fig. 15      die Komplexität der schnellen MDCT/MDST darstellt,
Fig. 16      eine Darstellung zur Komplexität der MDCT-MDST-Transformation ist,
Fig. 17      eine Reststörung bei HSBE in Abhängigkeit der Transformationslänge ist,
Fig. 18      einen Vergleich der HSBE mit der SBR zeigt,

Fig. 19       eine schnelle universelle DCT-III/DST-III Struktur zeigt,

Fig. 20       eine schnelle DCT-IV Struktur darstellt,

Fig. 21       eine schematische Darstellung einer zeitlichen Maskierung zeigt,

Fig. 22       eine schematische Darstellung der frequenzabhängigen Maskierung im menschlichen Gehör zeigt,

Fig. 23       ein Blockschaltbild eines psychoakustischen Audioencoders zeigt,

Fig. 24       ein Blockschaltbild eines psychoakustischen Audiodecoders zeigt,

Fig. 25       eine Filterbank mit einer Systemverzögerung von $n_d$ Samples darstellt,

Fig. 26       eine Polyphasenfilterbank darstellt,

Fig. 27       Kategorien der Bandbreitenerweiterung zeigt,

Fig. 28       ein Blockschaltbild eines erweiterten SBR-Encoders zeigt,

Fig. 29       ein Blockschaltbild eines mit SBR erweiterten Decoders zeigt,

Fig. 30       eine schematische Darstellung der SBR-HF-Rekonstruktion zeigt,

Fig. 31       eine Zerstörung der harmonischen Struktur bei SBR zeigt,

Fig. 32       eine schematische Darstellung der HBE-HF-Rekonstruktion ist,

Fig. 33       eine harmonische Struktur bei HBE darstellt,

Fig. 34       eine schematische Darstellung der CM-BWE-HF-Rekonstruktion zeigt, und

Fig. 35       harmonische Struktur bei CM-BWE darstellt.

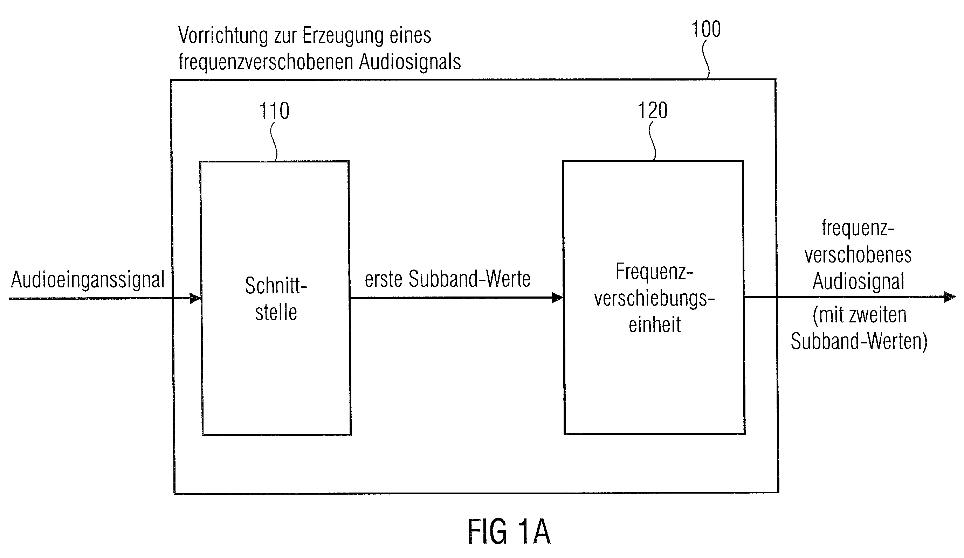

Fig. 1a zeigt eine Vorrichtung 100 zur Erzeugung eines frequenzverschobenen Audiosignals basierend auf einem Audioeingangssignal. Das Audioeingangssignal ist dabei für eine Mehrzahl von ersten Subbändern durch einen oder mehrere erste Subband-Werte darstellbar. Die Vorrichtung umfasst eine Schnittstelle 110 und eine Frequenzverschiebungseinheit 120. Die Schnittstelle 110 ist zum Empfang des Audioeingangssignals eingerichtet. Die Frequenzverschiebungseinheit 120 ist zur Erzeugung des frequenzverschobenen Audiosignals eingerichtet, wobei das frequenzverschobene Audiosignal für eine Mehrzahl von zweiten Subbändern jeweils einen oder mehrere zweite Subband-Werte aufweist. Ferner weist jeder der ersten und der zweiten Subband-Werte Information über jeweils einen Phasenwinkel auf. Die Frequenzverschiebungseinheit 120 ist ferner dafür eingerichtet, einen der zweiten Subband-Werte basierend auf einem der ersten Subband-Werte so zu erzeugen, dass der zweite Phasenwinkel dieses zweiten Subband-Werts sich von dem ersten Phasenwinkel dieses ersten Subband-Werts um eine Phasenwinkel-Differenz unterscheiden kann, wobei die Phasenwinkel-Differenz von einer Frequenzinformation abhängt, die angibt, um welche Frequenzdifferenz das Audioeingangssignal zu verschieben ist, also z.B. um welche Frequenzdifferenz die ersten Subband-Werte der Subbänder des Audioeingangssignals zu verschieben sind, um das frequenzverschobene Audiosignal zu erhalten, und wobei die Phasenwinkel-Differenz von einer Frequenz-Bandbreite von einem der ersten Subbänder abhängt.

In manchen Ausführungsformen kann die Schnittstelle dafür eingerichtet sein, die Frequenzinformation zu empfangen, die angibt, um welche Frequenzdifferenz die ersten Subband-Werte der Subbänder des Audioeingangssignals zu verschieben sind.

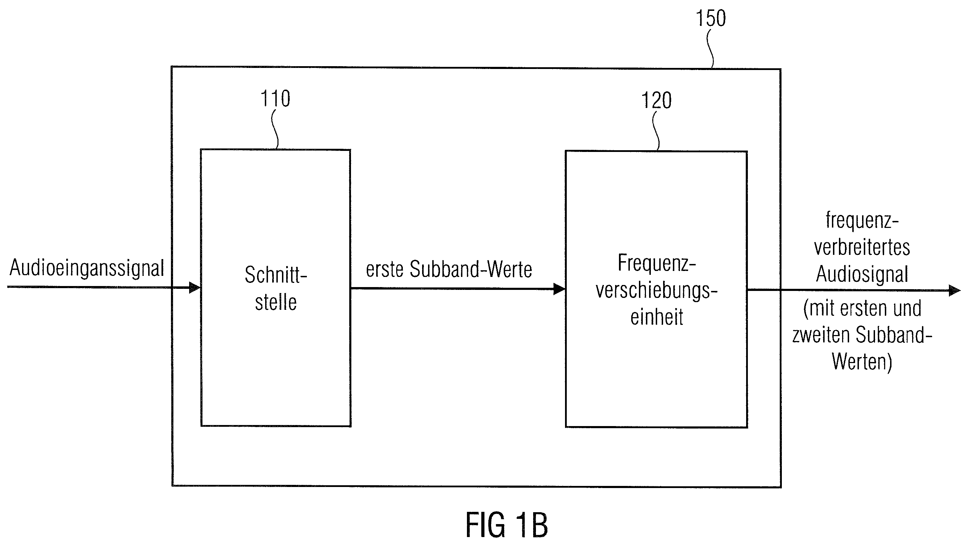

Fig. 1b zeigt eine Vorrichtung 150 gemäß einem Ausführungsbeispiel. Die Vorrichtung 150 ist dafür eingerichtet, ein frequenzverbreitertes Audiosignal zu erzeugen. Dabei ist die Vorrichtung 150 dafür eingerichtet, das frequenzverbreiterte Audiosignal dadurch zu erzeugen, dass die Vorrichtung 150 die zweiten Subband-Werte des frequenzverschobenen Audiosignals erzeugt, wobei das frequenzverbreiterte Audiosignal die ersten SubbandWerte des Audioeingangssignals und die zweiten Subband-Werte des frequenzverschobenen Audiosignals umfasst.

Im Folgenden werden Konzepte zur Bandbreitenerweiterung gemäß Ausführungsformen eingeführt, die als sogenannte harmonische Spektralbanderweiterung (engl. Harmonic Spectral Bandwidth Extension, HSBE) bezeichnet werden. Dabei handelt es sich um Konzepte, die die Vorteile von SBR mit denen der kontinuierlichen Einseitenbandmodulation verbindet. Es basiert auf der Signaldarstellung im MDCT-Bereich. Damit kann HSBE direkt in aktuellen Audiocodern wie HE-AAC oder USAC eingebunden werden, ohne wie bei SBR eine zusätzliche QMF Filterbank zu verwenden. Im Gegensatz zu den Zeitbereichsverfahren ist eine hochauflösende DFT zu berechnen und es wird kein analytisches Signal benötigt.

Nachfolgend wird Funktionsprinzip der harmonischen Spektralbanderweiterung erläutert. Die harmonische Spektralbanderweiterung nutzt eine Kopie des Basisbands zur Generierung des HF-Anteils. Das Basisband wird über einen Kopierprozess im hochfrequenten Bereich nachgebildet. Im Gegensatz zu CM-BWE, wo durch das Kopieren eine Lücke entsteht, in der einzelne harmonische Teiltöne fehlen, wird die Verschiebung des Basisbandes bei HSBE erweitert. Das Basisband wird zunächst ebenfalls nach oben kopiert, so dass die Frequenz von 0 Hz danach auf $f_g$ liegt. Die so entstandene Lücke zwischen der letzten Harmonischen der Frequenz $f < fg$ im Basisband und der Frequenz fg wird dann ausgeglichen, indem das kopierte Basisband wieder nach unten verschoben wird, so dass die harmonische Struktur wieder kontinuierlich verläuft. So wird eine Lücke durch Auslassen eines harmonischen Teiltons wie bei den Zeitbereichsverfahren vermieden. Der Bandbreitenerweiterungsprozess setzt sich dabei aus zwei Teilen zusammen. Der eine Teil wird durch einen Kopierprozess im MDCT-Bereich realisiert. Die tieffrequenten MDCT-Koeffizienten werden durch ein simples Kopieren repliziert. Der andere Teil der Bandbreitenerweiterung, also die Erhaltung der harmonischen Struktur, wird über eine Manipulation der Phase erreicht. Für diesen Schritt müssen daher Phaseninformationen vorhanden sein. Die harmonische Spektralbanderweiterung arbeitet grundsätzlich mit rein reellen MDCT-Koeffizienten. Zur Veränderung von Phaseninformationen findet daher eine Überführung in ein komplexes Spektrum statt. Dies wird durch die hier bereitgestellte MDCT-MDST-Transformation erreicht.

Damit sich während der Anpassung die hohen Frequenzen des Basisbands nicht mit den Frequenzen des replizierten Bandes überlagern, wird das HF-Band einer Hochpassfilterung unterworfen. Diese Filterung ist durch die Darstellung des Signals als MDCT-Koeffizienten sehr einfach, da die unerwünschten Koeffizienten zu Null gesetzt werden können. Diese Art der Verschiebung verursacht allerdings eine Bandbegrenzung des synthetisierten Signals. Es wird also nach der Rekonstruktion des HF-Bands nicht die ursprüngliche maximale Signalfrequenz $f_{max}$ erreicht, sondern nur die Frequenz $f_{syn}$. Die auftretende Lücke zwischen $f_{max}$ und $f_{syn}$ kann bei Bedarf mit Rauschen gefüllt werden.

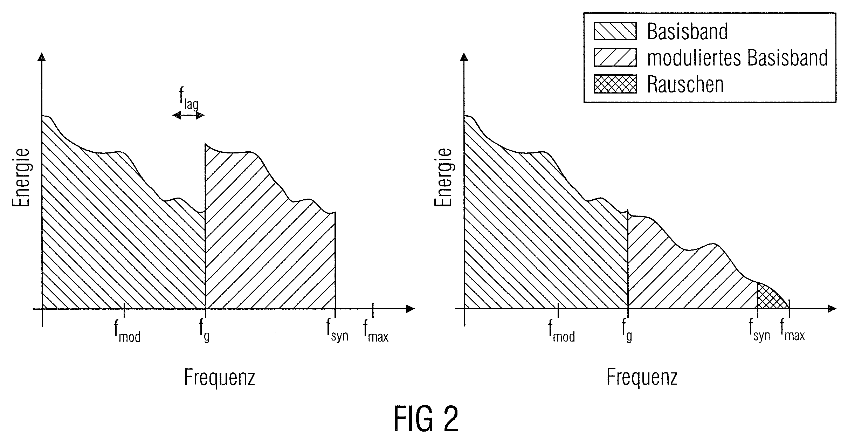

In Fig. 2 ist der Kopiervorgang inklusive der harmonischen Anpassung schematisch dargestellt. Dabei zeigt Fig. 2 eine schematische Darstellung der HSBE-HF-Rekonstruktion. In Fig. 2, links ein Kopieren und Verschieben des Basisbands gezeigt. In Fig. 2, rechts ist ein Spektrum nach der Anpassung der spektralen Einhüllenden gezeigt.

Die notwendige Adaption der Phase verursacht zusätzliche Störkomponenten im Signal. Diese werden durch die entwickelte Anti-Aliasing-Filterung der komplexen MDCT-/ MDST-Spektralwerte unterdrückt. Abschließend wird die spektrale Einhüllende durch ein geeignetes Verfahren wieder ihrem ursprünglichen Verlauf angepasst.

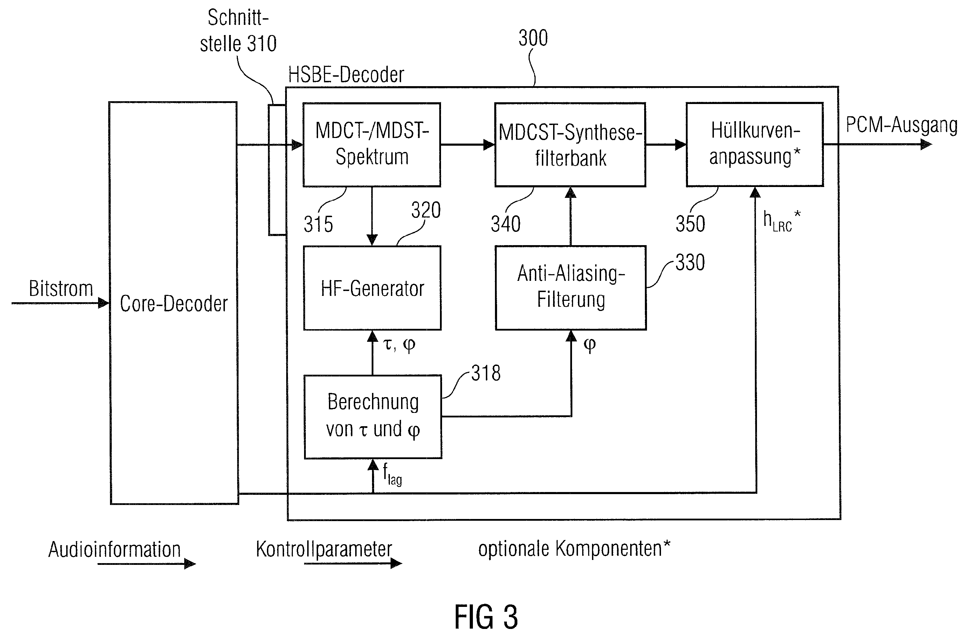

In Fig. 3 ist ein HSBE-Decoder, also ein mit HSBE erweiterter Decoder gezeigt, dass sich mit dem genannten Vorgehen ergibt.

Fig. 3 zeigt eine Vorrichtung 300 zur Erzeugung zur Erzeugung eines frequenzverschobenen Audiosignals gemäß einer Ausführungsform. In einer Ausführungsform kann es sich beispielsweise um einen HSBE-Decoder, also einen mit HSBE erweiterten Decoder handeln.

Die Vorrichtung 300 weist eine Schnittstelle 310 und eine Frequenzverschiebungseinheit 320 auf.

Zwischen der Schnittstelle 310 und der Frequenzverschiebungseinheit 320 befindet sich eine MDCT-/MDST-Transformationseinheit 315. Ferner weist die Vorrichtung 300 eine Filtereinheit 330 auf. Des Weiteren weist die Vorrichtung 300 eine Synthese-Transformationseinheit 340, z.B. in Form einer Filterbank und eine Hüllkurvenanpassungseinheit 350 auf. Ferner umfasst die Vorrichtung 300 in dem Ausführungsbeispiel der Fig. 3 eine Einheit zur Berechnung von $\tau$ und $\varphi$ (318).

Die MDCT-/MDST-Transformationseinheit 315 kann dafür eingerichtet sein, einen oder mehrere erste MDCT-Koeffizienten des Audioeingangssignals zu erhalten, die Koeffizienten einer Modifizierten Diskreten Kosinustransformation des Audioeingangssignals sind. Diese ersten MDCT-Koeffizienten kann die MDCT-/MDST-Transformationseinheit 315 zum Beispiel von der Schnittstelle 310 erhalten.

Die MDCT-/MDST-Transformationseinheit 315 ist dafür eingerichtet, basierend auf einem oder mehreren der ersten MDCT-Koeffizienten des Audioeingangssignals einen oder mehrere erste MDST-Koeffizienten des Audioeingangssignals zu bestimmen, die Koeffizienten einer Modifizierten Diskreten Sinustransformation sind.

Die Frequenzverschiebungseinheit 320 kann dann dafür eingerichtet sein, zweite Subband-Werte basierend auf jeweils einem der ersten Subband-Werte zu erzeugen, wobei jeder der ersten Subband-Werte auf einem der ersten MDCT-Koeffizienten und einem der ersten MDST-Koeffizienten, der basierend auf diesem ersten MDCT-Koeffizienten bestimmt wurde, basiert.

Die gezeigte Struktur der Vorrichtung 300, z.B. realisiert als ein HSBE-Decoder, richtet sich nach den implementierten Algorithmen. Für die Verwendung dieses Decoders in anderen Umgebungen kann es erforderlich sein, die Hüllkurvenrekonstruktion im Frequenzbereich vorzunehmen. Der entsprechende Block befindet sich dann direkt vor der MDCT-/MDST-Synthesefilterbank. An dieser Stelle können auch weitere Komponenten eingebunden werden, wie die in SBR genutzte Tonalitätsanpassung. Auf das allgemeine Funktionsprinzip der harmonischen Spektralbanderweiterung haben diese Verfahren allerdings keine Auswirkung.

Aus Fig. 3 ergibt sich auch der Decodierprozess eines Signals gemäß einer Ausführungsform, das in der MDCT-Domäne codiert wurde. Um einige Teile des Spektrums im gewünschten Umfang zu verschieben, werden die decodierten MDCT-Koeffizienten zunächst in eine kombinierte MDCT/MDSE Repräsentation transformiert. Dies ist hilfreich, denn die Modulation eines komplexen Spektrums wird größere Aliasing-Komponenten nur in jedem zweiten Subband erzeugen. Deshalb ist eine Kompensation nur in jedem zweiten Subband erforderlich, wobei diese Kompensation mit Hilfe des vorgeschlagenen Aliasing-Kompensationsverfahrens durchgeführt wird.

Der HF-Generator verschiebt die komplexen Frequenzeingaben aus der MDCT/MDST Transformations-Repräsentation entsprechend der gewünschten Verschiebung, entweder decodiert aus dem Bitstrom oder am Decodierer bestimmt oder durch externe Prozesse. Der verwendete Modulationsterm ist:

$$e^{-jb\,\varphi}\,\frac{\pi}{180°}\,,$$

wobei b der Blockindex ist, wobei φ die Frequenzverschiebung in Grad ist (eine Frequenzverschiebung um 180° entspricht einer Verschiebung in die Mitte des nächsten Subbands).

Danach wird die Aliasing-Reduzierung durchgeführt, und dann wird das komplexe Spektrum invers in die Zeitdomäne zurück transformiert und abgespielt.

Der verwendete Modulationsterm ist eine komplexe Exponentialfunktion. φ ist ein Winkel in Grad, der von der Frequenzdifferenz abhängt, um die die ersten Subband-Werte der Subbänder zu verschieben sind.

Nun wird die Überführung der MDCT zur MDST erläutert.

Die Einseitenbandmodulation zur Erhaltung der harmonischen Struktur wird zum Teil über eine Manipulation der Phase realisiert. Für die harmonische Spektralbanderweiterung ist daher der Phasengang von entscheidender Bedeutung. Wie bereits erläutert, arbeitet HSBE generell im reellen MDCT-Bereich.

Der Encoder stellt nur MDCT-Koeffizienten zur Verfügung, so dass für den Phasengang zusätzlich die MDST-Koeffizienten benötigt werden. Die Überführung der MDCT-Koeffizienten in die entsprechenden MDST-Koeffizienten ist möglich und wird nachfolgend erläutert.

Im Folgenden wird die exakte Berechnung der MDST erläutert.

Wie bei der DCT existiert bei der MDCT eine korrespondierende Funktion zur Berechnung der Sinusanteile im Signal: die diskrete modifizierte Sinustransformation (MDST). Für die MDST gelten die gleichen Eigenschaften wie für die MDCT, allerdings wird sie in der Audiocodierung kaum verwendet.

Für manche Anwendungen, wie beispielsweise bei HSBE, ist es aber dennoch sinnvoll, das MDST-Spektrum eines Signals zu berechnen. Durch die Kombination beider Spektren wird ein genaues Betrags- und Phasenspektrum erhalten (Cheng, 2004).

Die MDST wird ähnlich der MDCT in Gleichung 2.35 berechnet. Unterschiede bestehen in der Transformationsmatrix $\underset{\sim}{\mathbf{T}}$ und der Fenstermatrix $\underset{\sim}{\mathbf{F}}$. Die MDST-Transformationsmatrix wird mit dem Modulationskern der DST-IV (vgl. Gleichung 2.18) berechnet:

$$\underset{\sim}{\mathbf{T}}_{DST}(k, n) := \sin\left(\frac{\pi(n + 0,5)(k + 0,5)}{N}\right) \in \mathbb{R}^{N \times N} \tag{4.1a}$$

$$\underset{\sim}{\mathbf{T}}_{DST}^{-1} = \frac{2}{N} \cdot \underset{\sim}{\mathbf{T}}_{DST} \tag{4.1b}$$

Aufgrund anderer Symmetrieeigenschaften und anderer Randfortsetzungen der DST-IV im Vergleich zur DCT-IV müssen die Foldingmatrizen daran angepasst werden. Die Modifikation besteht in einem Vorzeichenwechsel des zweiten und vierten Quadranten der Fenstermatrix $\underset{\sim}{\mathbf{F}}$:

$$\underset{\sim}{\mathbf{F}}_{sin} = \begin{bmatrix} 0 & -w[\frac{N}{2} - 1] & w[\frac{N}{2}] & 0 \\ \cdot^{\cdot\cdot} & & & \cdot^{\cdot\cdot} \\ -w[0] & 0 & & w[N-1] \\ w[N] & & & w[2N-1] \\ \cdot_{\cdot\cdot} & & & \cdot_{\cdot\cdot} \\ 0 & w[N + \frac{N}{2} - 1] & w[N + \frac{N}{2}] & 0 \end{bmatrix} \tag{4.2}$$

Mit diesen Anpassungen lässt sich die MDST eines in Blöcke unterteilten Signals $\underset{\sim}{\mathbf{X}}$ wie folgt berechnen:

$$\underset{\sim}{\mathbf{X}}_{MDST} = \underset{\sim}{\mathbf{T}}_{DST} \cdot \underset{\sim}{\mathbf{D}} \cdot \underset{\sim}{\mathbf{F}}_{sin} \cdot \underset{\sim}{\mathbf{X}} \tag{4.3}$$

Für die inverse Transformation gilt dann:

$$\hat{\underline{x}} = \underline{F}_{sin}^{\mathsf{T}} \cdot \underline{D}^{-1} \cdot \underline{T}_{DST}^{-1} \cdot \underline{X} \tag{4.4}$$

Eine aus Kombination von MDCT- und MDST-Spektren berechnete komplexe Übertragungsfunktion ist notwendig, um beispielsweise den Phasengang zu manipulieren. Im Folgenden wird das implementierte Verfahren zur Überführung des MDCT-Spektrums in MDST-Koeffizienten vorgestellt.

Eine triviale und rechenintensive Methode ist die Überführung des Signals im MDCT-Bereich zurück in den Zeitbereich mit anschließender MDST:

$$\underline{X}_{MDST} = \underline{T}_{DST} \cdot \underline{D} \cdot \underline{F}_{sin} \cdot \underline{F}^{\mathsf{T}} \cdot \underline{D}^{-1} \cdot \underline{T}^{-1} \cdot \underline{X} \tag{4.5}$$

Diese Berechnung kann vereinfacht werden, um den benötigten Aufwand zu reduzieren. Dazu wird zunächst die Polyphasenmatrix $\underline{H}$ definiert als:

$$\underline{H} = \underline{T}_{DST} \cdot \underline{D} \cdot \underline{F}_{sin} \cdot \underline{F}^{\mathsf{T}} \cdot \underline{D}^{-1} \cdot \underline{T}^{-1} \tag{4.6}$$

Die Elemente der Matrix $\underline{H}$ bestehen jeweils aus Polynomen dritter Ordnung in z. Diese Eigenschaft kann genutzt werden, um $\underline{H}$ als Addition von drei Matrizen darzustellen:

$$\underline{H} = \underline{H}_0 z^0 + \underline{H}_1 z^{-1} + \underline{H}_2 z^{-2} \tag{4.7}$$

Die drei Teilmatrizen $\underline{H}_0$, $\underline{H}_1$ und $\underline{H}_2$ weisen charakteristische Merkmale auf, die zu einer effizienten Berechnung führen. Die Matrix $\underline{H}_1$ ist eine schwachbesetzte Matrix mit den Elementen 0,5 und -0,5. Zwischen den Matrizen $\underline{H}_0$ und $\underline{H}_2$ besteht ein direkter Zusammenhang, so dass sich die Matrix $\underline{H}_2$ als Spiegelung der Elemente von $\underline{H}_0$ an ihrer Nebendiagonalen erzeugen lässt. Die genaue Form und eine detaillierte Berechnung dieser Matrizen wird später dargestellt. Das MDST Spektrum des Blocks ($b$ - 1) kann nun folgendermaßen berechnet werden:

$$\underline{X}_{MDST}(b-1) = \underline{H}_0 \cdot \underline{X}(b) + \underline{H}_1 \cdot \underline{X}(b-1) + \underline{H}_2 \cdot \underline{X}(b-2) \tag{4.8}$$

Dabei ist $\underline{X}(b)$ die b-te Spalte der Matrix $\underline{X}$. An dieser Gleichung ist auch zu erkennen, dass zur Berechnung des MDST-Spektrums ein Delay von einem Block eingeführt wird. Liegt das MDCT-Spektrum des Blocks b vor, so steht erst das MDST-Spektrum des vorhergegangenen Blocks zur Verfügung. Mithilfe der so erlangten MDST-Koeffizienten kann ein Phasengang aus dem komplexen MDCT-/MDST-Spektrum berechnet und zur Erhaltung der harmonischen Struktur, wie oben erläutert, über eine Phasendrehung manipuliert werden.

Nachfolgend wird nun eine vereinfachte Berechnung der MDST erläutert.

Auch wenn nach dem hergeleiteten Verfahren die Berechnung der MDST stark vereinfacht ist, ist die Berechnung dieser Transformation sehr rechenintensiv. Zudem wird viel Speicherplatz zur Speicherung der Matrix $\underline{H}_0$ benötigt. Eine weitere Vereinfachung der Transformation ist also gesucht.

Bei genauerer Untersuchung der Matrizen $\underline{H}_0$ und $\underline{H}_2$ fällt auf, dass sie sehr viele Werte enthalten, die gegen Null tendieren. Die Koeffizienten mit den betragsmäßig größten Werten konzentrieren sich auf einen engen Bereich nahe der Hauptdiagonalen der Matrizen. Es liegt daher nahe, die übrigen Koeffizienten zu Null zu setzten, um damit sowohl Rechenleistung als auch Speicherbedarf zu sparen. Des Weiteren sind sich die Werte auf den Diagonalen sehr ähnlich. Sie unterscheiden sich im Wesentlichen nur durch ihr Vorzeichen voneinander. Einzig in den Bereichen nahe den Ecken nehmen die Koeffizienten größere Werte an.

Zur Vereinfachung wird zudem angenommen, dass die Werte unter- und oberhalb der Hauptdiagonalen gleich sind, also dass eine Achsensymmetrie der Matrix zur Hauptdiagonalen besteht. Es wird nun eine vereinfachte Matrix bestimmt, deren Werte aus der mittleren Spalte der Matrix $\underline{H}_0$ entnommen werden. Dazu wird aus der mittleren Spalte ein Bereich ausgeschnitten, der das Element der Hauptdiagonalen und eine beliebige Anzahl weiterer Elemente unterhalb der Hauptdiagonalen umfasst. Dieser Ausschnitt wird mit $\underline{h}[n]$ bezeichnet. Die mittlere Spalte der neuen Matrix wird nun um das aus $\underline{h}[n]$ und einer Punktspiegelung von $\underline{h}[n]$ am Hauptachsenelement $h_j$ gebildet, der Rest der Spalte ist Null. Die anderen Spalten der vereinfachten Matrix werden nun durch eine zyklische Verschiebung dieser Spalte gebildet. Das Vorzeichen jeder zweiten Spalte wird angepasst. Mit diesen Methoden zur Vereinfachung der vollbesetzten Matrix $\underset{\sim}{\mathbf{H}}_0$ kann nun mit sehr wenigen Koeffizienten die schwachbesetzte Matrix $\underset{\sim}{\mathbf{H}}'_0$ erstellt werden. Eine Besonderheit dieser Matrix ist ihre symmetrische Toeplitzähnliche Struktur. Sie entsteht durch die zyklische Verschiebung der beschnittenen und an der Hauptdiagonalen gespiegelten Impulsantwort $h[n]$ mit:

$$h[n] = \left[ h_{i,j}, h_{i+1,j}, \ldots, h_{i+\sigma-1,j}, h_{i+\sigma,j} \right], \quad i, j = \frac{N}{2} - 1 \tag{4.9}$$

Dabei ist $i$ der Zeilen- und $j$ der Spaltenindex der Matrix $\underset{\sim}{\mathbf{H}}_0$ und $\sigma$ der Fensterindex der die Länge des Ausschnitts bestimmt. Die Länge dieses Ausschnitts ist stets $2\sigma +1$. Für die Struktur der Matrix $\underset{\sim}{\mathbf{H}}'_0$ gilt mit $\sigma = 1$ und $N = 6$ beispielsweise:

$$\underset{\sim}{\mathbf{H}}'_0 = \begin{bmatrix} -h[0] & h[1] & 0 & 0 & 0 & 0 \\ -h[1] & h[0] & -h[1] & 0 & 0 & 0 \\ 0 & h[1] & -h[0] & h[1] & 0 & 0 \\ 0 & 0 & -h[1] & h[0] & -h[1] & 0 \\ 0 & 0 & 0 & h[1] & -h[0] & h[1] \\ 0 & 0 & 0 & 0 & -h[1] & h[0] \end{bmatrix} \tag{4.10}$$

Es ist zu beachten, dass beginnend mit der ersten Spalte jede zweite Spalte mit -1 multipliziert ist. In den folgenden Betrachtungen entspricht der Fensterindex $\sigma$ circa 10% der Transformationslänge $N$, also $\sigma = \lceil 0, 1 \cdot N \rfloor$. Damit ist der benötigte Speicherplatz für die Transformationsmatrix durch die Spiegelung der Werte von $h[n]$ auf 20% gesunken.

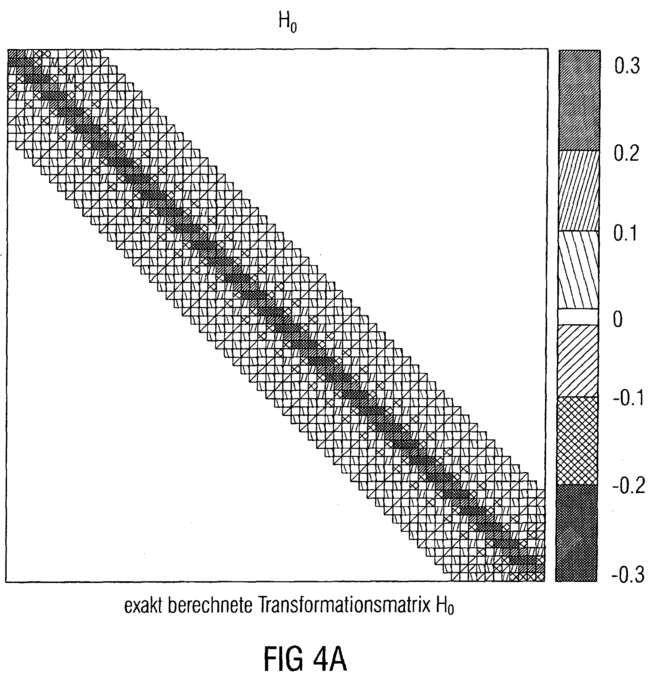

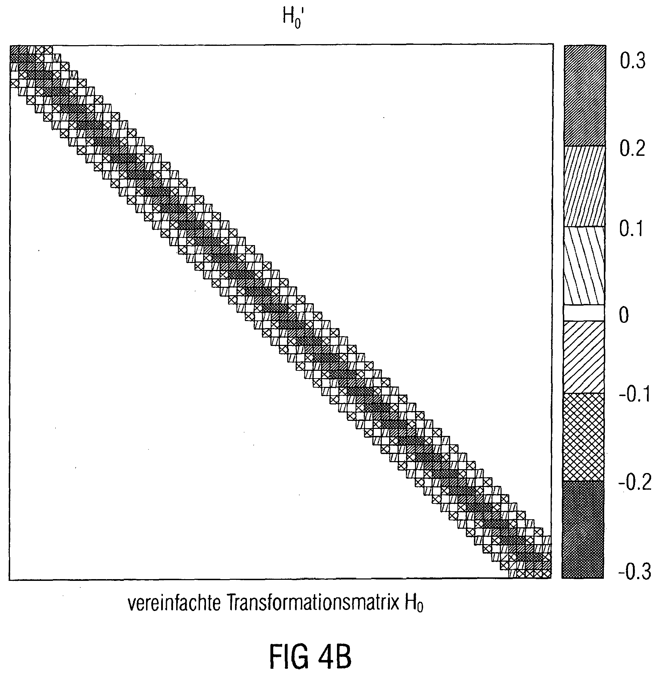

Fig. 4A und 4B stellen eine Abschätzung der MDCT-MDST-Transformationsmatrix dar. In Fig. 4A ist eine vollbesetzte Transformationsmatrix $\underset{\sim}{\mathbf{H}}_0$ für $N = 64$ gezeigt. In Fig. 4B ist eine vereinfachte Transformationsmatrix $\underset{\sim}{\mathbf{H}}'_0$ für $N = 64$ dargestellt.

In Fig. 4A ist die vollbesetzte Matrix $\underset{\sim}{\mathbf{H}}_0$ zu sehen und im Vergleich dazu in Fig. 4B die vereinfachte Matrix $\underset{\sim}{\mathbf{H}}'_0$ in symmetrischer Toeplitz-ähnlicher Struktur. Wie zu erkennen ist, ist durch die Vereinfachung ein großer Teil der Koeffizienten abseits der Hauptdiagonalen von $\underset{\sim}{\mathbf{H}}'_0$ gleich Null.

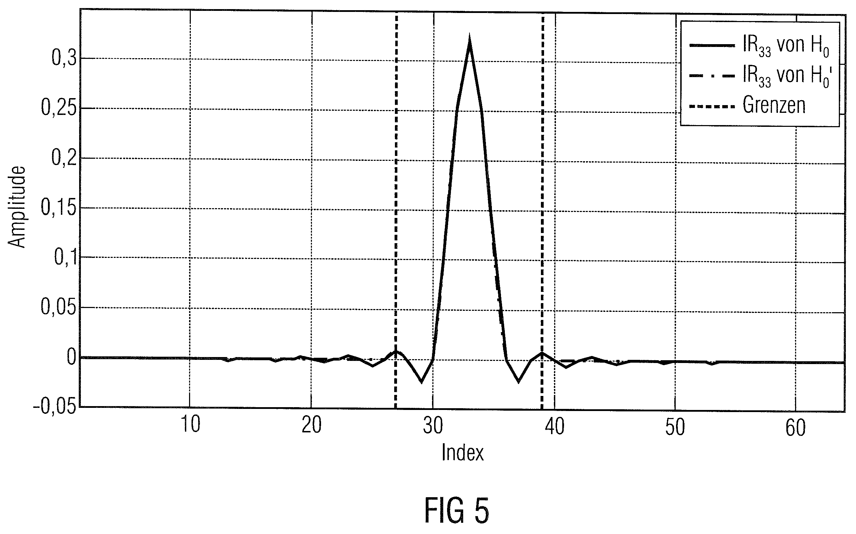

Fig. 5 stellt die Impulsantworten der MDCT-MDST-Transformationsmatrizen dar. Im Speziellen ist in Fig. 5 die ursprüngliche Impulsantwort der 33. Spalte der Matrix $\underset{\sim}{\mathbf{H}}_0$ dargestellt (durchgezogene Linie). Im Vergleich dazu ist zusätzlich die entsprechende durch den Kopiervorgang und Spiegelung entstandene Impulsantwort der neuen Matrix $\underset{\sim}{\mathbf{H}}'_0$ zu sehen. Das Ausschneiden der Werte erfolgt mit einem Rechteckfenster mit dem Fensterindex $\sigma = 6$.

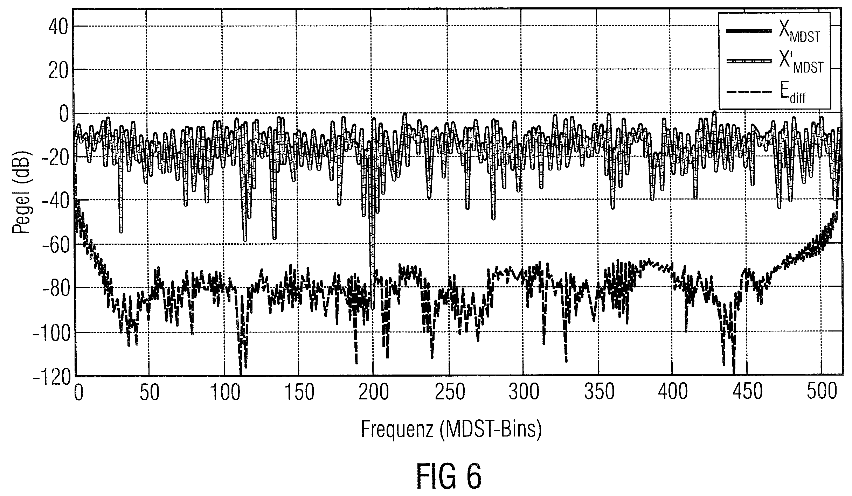

Diese Art der Vereinfachung der MDCT-MDST-Transformation liefert nicht das exakte MDST-Spektrum, wie es durch die Berechnung nach Gleichung 4.8 entsteht. Durch die durchgeführte Vereinfachung der Matrizen $\underset{\sim}{\mathbf{H}}_0$ und $\underset{\sim}{\mathbf{H}}_2$ wird dem Spektrum ein Fehler hinzugefügt. Dieser bewirkt eine Reduzierung des Signal-Rausch-Abstands auf circa -70 dB, wie in Fig. 6 gezeigt ist. Fig. 6 zeigt eine Schätzung des MDST-Spektrums für weißes Rauschen. An den Randbereichen des Spektrums steigt der Fehler der Abschätzung des MDST-Spektrums. Dieser Effekt ist der ungenauen Abschätzung der Matrixkoeffizienten nahe den Enden der Hauptdiagonalen geschuldet. Der erzeugte Fehler wird durch die Hochpassfilterung des HSBE-Algorithmus reduziert und ist somit nur noch in hohen Frequenzen vorhanden.

Nun wird die Anpassung der harmonischen Struktur des Frequenzspektrums erläutert.

Ein Vorteil des HSBE-Verfahrens ist die Beibehaltung der harmonischen Struktur nach der Bandbreitenerweiterung. Wie bereits erwähnt, geschieht dies durch eine Phasenmanipulation im komplexen MDCT-/MDST-Bereich. Betrachtet wird dazu das kopierte Spektralband mit der *Bandbreite* $B = f_{max} - f_g$. Ziel ist es, das Spektrum so nach unten zu verschieben, dass die erste Harmonische in diesem Band (beispielsweise mit der Frequenz $f_{H,n} > f_g$) nach der Verschiebung auf der Frequenz der höchsten Harmonischen im Basisband der Frequenz $f_{H,\alpha} < f_g$ zu liegen kommt. Der Abstand der Frequenzen $f_{H,n}$ und $f_{H,\alpha}$ wird als Lag-Frequenz $f_{lag}$ bezeichnet.

Über diese Frequenz wird die Anpassung der harmonischen Struktur geregelt. Diese Frequenz kann auch als entsprechendes ganzzahliges und nichtganzzahliges Vielfaches von MDCT-Teilbändern dargestellt werden, um die das Frequenzband nach unten zu verschieben ist. Damit wird eine maximale Flexibilität des entwickelten Verfahrens ermöglicht. Nachdem die oben genannte Bedingung erreicht ist, werden alle MDCT-Koeffizienten mit einer diskreten Frequenz kleiner $f_g$ auf Null gesetzt, damit sich Basisband und verschobenes Band nicht überlagern.

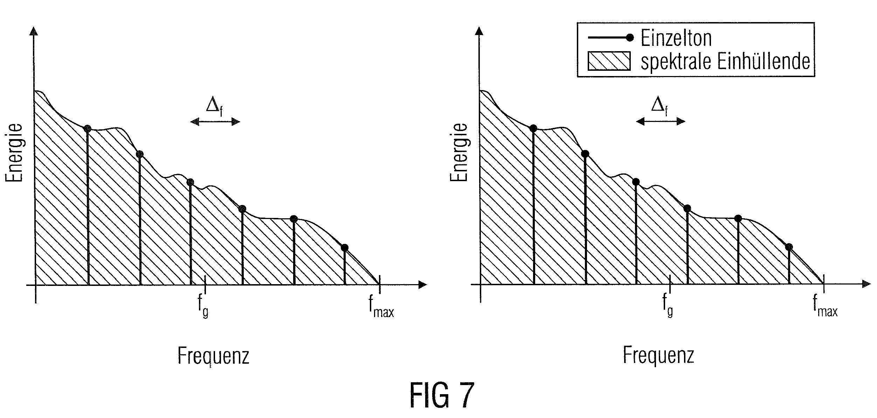

In Fig. 7 ist das gewünschte Ergebnis des HSBE-Verfahrens für ein tonales Signal schematisch dargestellt. Fig. 7 zeigt dabei die Harmonische Struktur bei HSBE. In Fig. 7, links ist das ursprüngliches Breitbandspektrum gezeigt. In Fig. 7, rechts ist das Spektrum nach der HSBE HF-Rekonstruktion gezeigt.

Dabei bleibt die ursprüngliche harmonische Struktur erhalten. Durch die erläuterte Verschiebung des hochfrequenten replizierten Bandes zu Frequenzen kleiner der Grenzfrequenz fg wird kein harmonischer Teilton ausgelassen. Die Verschiebung des Spektrums kann damit als Einseitenbandmodulation des hochpassgefilterten Basisbandsignals mit der Modulationsfrequenz $f_{mod}$ interpretiert werden. Es gilt:

$$f_{mod} = f_g - f_{lag} \qquad (4.11)$$

Es ist dabei darauf zu achten, dass bei Frequenzen $f_{lag}$ größer der halben Bandbreite eines MDCT-Bands durch die Verschiebung MDCT-Koeffizient nahe $f = f_{max}$ zu Null werden. Diese können mit Rauschen aufgefüllt werden. Ist die Frequenz $f_{lag}$ kleiner der halben Bandbreite eines MDCT-Bands ist dies nicht nötig, da kein MDCT-Koeffizient zu Null gesetzt wird.

Nachfolgend wird die Anpassung nicht-ganzzahliger Teilbänder erläutert.

Die Erhaltung der harmonischen Struktur ist dann kompliziert, wenn ein MDCT-Band im Vergleich zu der Frequenzdifferenz aufeinanderfolgender Teiltöne der harmonischen Struktur eine hohe Bandbreite aufweist. Wird die Modulation nur mit Frequenzen durchgeführt, die ein ganzzahliges Vielfaches der Bandbreite eines MDCT-Bandes darstellen, so ist die Auflösung der harmonischen Rekonstruktion dann stark begrenzt und eine feine harmonische Struktur kann damit folglich nicht wiederhergestellt werden. Es ist daher notwendig, eine hohe Genauigkeit der Modulation zu ermöglichen, so dass das Spektrum des Basisbands nicht nur um ganzzahlige Vielfache der MDCT-Band-Bandbreite moduliert werden kann, sondern auch um Bruchteile davon.

Mit dem folgenden Ansatz ist es möglich, das Spektrum innerhalb der Bandbreite eines MDCT-Teilbands zu verschieben. Das Verfahren basiert auf einer Modifizierung der Phase des komplexen MDCT-/MDST-Spektrums. Die Phase wird dabei in Abhängigkeit des zeitlichen Verlaufs des Signals um eine normierte Frequenzverschiebung $\varphi$ gedreht. Diese zeitliche Rotation des Phasenwinkels ermöglicht so eine sehr feine Verschiebung des Spektrums. Es gilt:

$$\underline{X}_{mod}(b) = \underline{X}(b) \cdot e^{-j \cdot b \cdot \varphi \cdot \frac{\pi}{180°}} \qquad (4.12)$$

Dabei ist $\underline{X}(b)$ die b-te Spalte der komplexen Matrix $\underline{X} = \underline{X}_{MDCT} + j \cdot \underline{X}_{MDST}$ und $\varphi$ die normierte Frequenzverschiebung in Grad. Theoretisch sind für $\varphi$ beliebige Winkel möglich, aber aus praktischen Gründen ist der Wertebereich stark begrenzt und liegt im Intervall $[-90, 90] \subset \mathbb{Z}$. Es ist mit diesem Intervall möglich, Modulationen zu berechnen, die die Bandbreite eines MDCT-Bands abdecken. Durch die Festlegung der normierten Frequenzverschiebung auf das angegebene Intervall kann das Spektrum um je die halbe MDCT-Band-Bandbreite zu hohen oder zu niedrigen Frequenzen verschoben werden.

Für die komplexe Exponentialfunktion $e^{-j \cdot b \cdot \varphi \cdot \frac{\pi}{180°}}$, die von b und $\varphi$ abhängt, kann also zunächst ein Ergebniswert berechnet werden. $\varphi$ ist ein Winkel in Grad, der von der Frequenzdifferenz abhängt, um die die ersten Subband-Werte der Subbänder zu verschieben sind. Ein zu ermittelnder zweiter Subband-Wert kann dann dadurch ermittelt werden, dass einer der ersten Subband-Werte in $\underline{X}(b)$ mit dem Ergebniswert multipliziert wird.

Im Folgenden wird die Anpassung ganzzahliger Teilbänder erklärt.

Der eingeschränkte Wertebereich des Phasenwinkels $\varphi$ erlaubt mit der eingeführten Modulation nur die Verschiebung des Spektrums von maximal der Bandbreite eines MDCT-Bands. Für Verschiebungen des Spektrums größer der Bandbreite eines MDCT-Bandes wird diese Verschiebung in zwei Teile aufgeteilt, in ein ganzzahliges Vielfaches der MDCT-Band-Bandbreite und einen Bruchteil dieser Bandbreite. Es wird dann zunächst das Spektrum um die notwendige Frequenz kleiner der Bandbreite eines MDCT-Bands nach Gleichung 4.12 moduliert und anschließend das Spektrum um ganze Spektralwerte verschoben.

Im Folgenden wird die Verschiebung betrachtet, die genau einem Vielfachen der Bandbreite eines MDCT-Bands entspricht. In diesem Fall gibt es einen Phasenwinkel $\varphi'$, der ein ganzzahliges Vielfaches von 180° ist. Damit kann die Verschiebung des Spektrums um ganze MDCT-Spektralwerte als Spezialfall des oben eingeführten Verfahrens für nichtganzzahlige Teilbänder betrachtet werden. Die Auswertung der komplexen Modulationsfunktion in Gleichung 4.12 liefert dann folgende Ergebnisse. Ist das Produkt aus dem Blockindex $b$ und $\varphi'$ ein geradzahliges Vielfaches von 180°, ist das Ergebnis der Modulationsfunktion immer 1, andernfalls -1. Mit dieser Kenntnis ist es nicht notwendig, die Funktion in Gleichung 4.12 für die Anpassung ganzzahliger Teilbänder auszuwerten, es genügt eine simple Fallunterscheidung. Es gilt:

$$\underline{\mathbf{X}}_{mod}(b, 0:N - \tau - 1) = \begin{cases} -\underline{\mathbf{X}}(b, \tau:N - 1) & \text{wenn } \left(b \cdot \frac{\varphi'}{180°}\right) \in [1, 3, 5, \dots] \\ \underline{\mathbf{X}}(b, \tau:N - 1) & \text{sonst} \end{cases}$$

$$(4.13)$$

mit dem ganzzahligen Modulationsindex $\tau$:

$$\tau = \frac{\varphi'}{180°}$$

$$(4.14)$$

Dabei ist $\underline{\mathbf{X}}(b, \tau:N - 1)$ wieder die b-te Spalte der komplexen Matrix $\underline{\mathbf{X}} = \underline{\mathbf{X}}_{MDCT} + \mathrm{j} \cdot \underline{\mathbf{X}}_{MDST}$ mit dem Unterschied, dass hier nur die Vektorelemente beginnend bei $\tau$ bis zum letzten Element $N$ genutzt werden. Dieses Ausschneiden von Vektorelementen entspricht der oben angesprochenen Hochpassfilterung des komplexen MDCT-/MDST-Spektrums.

Für die Anwendung der Modulation wird die Modulationsfrequenz in Abhängigkeit von $f_{lag}$ in den Modulationsindex $\tau$ und den Phasenwinkel $\varphi$ überführt. Dazu wird zunächst die Frequenz $f_{lag}$ auf die Hälfte der Abtastfrequenz $f_s$ normiert. Anschließend wird die äquivalente Verschiebung in MDCT-Bändern $\varphi_{lag}$ ermittelt und der Modulationsindex $\tau$ sowie der Phasenwinkel $\varphi$ berechnet:

$$\omega_{lag} = f_{lag} \cdot {}^2/f_s \qquad (4.15)$$

$$\varphi_{lag} = N \cdot \omega_{lag} \qquad (4.16)$$

$$\tau = \lceil \varphi_{lag} \rfloor \qquad (4.17)$$

$$\varphi = \lceil (\varphi_{lag} - \tau) \cdot 180° \rfloor \qquad (4.18)$$

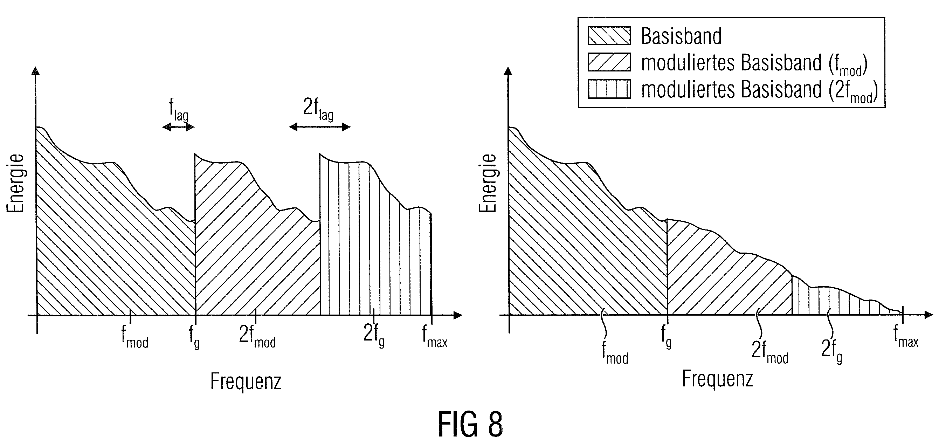

Durch die Kombination beider Verfahren ist es möglich, variable Patchverhältnisse zu realisieren. Das Patchverhältnis ist dabei das Verhältnis der maximal möglichen Signalfrequenz $f_{max}$ zur Grenzfrequenz des Basisbands $fg$. Ein Patchverhältnis von 2 : 1 besagt beispielsweise, dass eine einzelne Kopie des Basisbands erstellt und moduliert wird (vgl. Fig. 2). Patchverhältnisse größer 2 : 1 treten bei niedrigen oder schwankenden Übertragungsraten auf. Solche Verhältnisse werden ähnlich wie bei der CM-BWE (siehe oben) realisiert, indem das Basisband mehrmals kopiert und moduliert wird. Hier ist auch zu beachten, dass mit jeder Kopie des Basisbands die erforderliche Lag-Frequenz um $f_{lag}$ erhöht wird, wie in Fig. 8 für ein Patchverhältnis von 2,5 : 1 dargestellt ist.

Fig. 8 stellt ein Schema der erweiterten HSBE-HF-Rekonstruktion dar. In Fig. 8 links ist Kopieren und Verschieben des Basisbands dargestellt. In Fig. 8, rechts ist das Spektrum nach der Anpassung der spektralen Einhüllenden zu sehen.

Nachfolgend werden Konzepte zur Unterdrückung auftretender Störkomponenten beschrieben. Die hier beschriebenen Konzepte können beispielsweise in der Filtereinheit 330 der Fig. 3 zur Anwendung kommen.

Die Modulation des Spektrums im MDCT-Bereich ist nicht problemlos möglich. Durch eine Modulation des Spektrums ist eine perfekte Rekonstruktion bei der inversen MDCT nicht mehr möglich. Die Ursache liegt in den entstandenen Time-Domain-Aliasing-Komponenten. Durch die Modulation des Spektrums wird die Energie dieser Störkomponenten umverteilt. Die TDAC Eigenschaft der MDCT wird dadurch verletzt und kann diese Komponenten bei der inversen Transformation dann nicht mehr auslöschen. Bei einer Betrachtung des modulierten Signals nach der inversen MDCT zeigen sich im DFT-Betragsfrequenzgang aus diesem Grund Störkomponenten. Diese Aliasing-Komponenten weisen bei Verschiebung des Spektrums um $\varphi = 0°$ und $\tau > 0$ nur eine sehr geringe Amplitude auf und liegen im ersten beziehungsweise letzten MDCT-Band. In diesem Fall ist es nicht notwendig, diese Komponenten zu reduzieren. Bei Verschiebungsfaktoren $\varphi \neq 0°$ ist die Amplitude der entstehenden Störkomponenten wesentlich größer. Sie sind dann deutlich hörbar. Eine Behandlung dieser Komponenten findet daher statt.

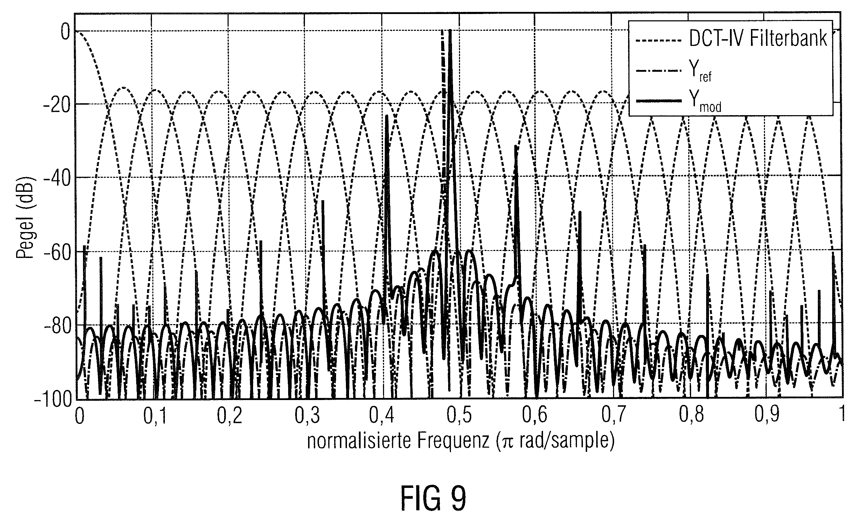

Fig. 9 zeigt Aliasing-Komponenten für $\varphi = 45°$: $y_{ref}$ ist dabei ein ursprünglicher Sinuston; $y_{mod}$ ist ein modulierter Sinuston mit Aliasing-Komponenten, zur besseren Darstellung ist die DCT-IV Filterbank gestreckt.

Im Einzelnen ist in Fig. 9 ist der Betragsfrequenzgang eines mit $\varphi = 45°$ verschobenen Sinustons ($y_{mod}$) zu sehen. Die Frequenz des ursprünglichen Sinustons ($y_{ref}$) entspricht der Bandmitte des 12. MDCT-Bands. Das gesamte Spektrum ist durch den gewählten Phasenwinkel um ein Viertel der Bandbreite eines MDCT-Bands zu hohen Frequenzen hin moduliert. Wie zu erkennen ist, liegen die acht dominanten Aliasing-Komponenten in jeweils jedem zweiten Band unter- und oberhalb des 12. MDCT-Bands. Diese Eigenschaft der Aliasing-Komponenten ist für jedes beliebige Signal gegeben. Das liegt daran, da sich jedes Signal in eine gewichtete Summe von Sinus- und Cosinusschwingungen zerlegen lässt (siehe oben). Für jede dieser Teilschwingungen entsteht bei der Modulation nach Gleichung 4.12 dieses spezielle Muster der Aliasing-Komponenten. Mit dieser Kenntnis lässt sich ein Verfahren entwickeln, das erlaubt, jedes beliebige Signal von den unerwünschten Störkomponenten zu befreien. Dabei genügt es, die Aliasing-Komponenten, die durch die Modulation eines Sinussignals entstehen, zu analysieren und auszulöschen.

Im Folgenden werden Konzepte zur Anti-Aliasing Filterung bereitgestellt.

Durch die zeitliche Überlappung der Blöcke für das TDA entstehen im Frequenzbereich zusätzliche Signalanteile. Diese sind als Störanteile im Spektrum des bandbreitenerweiterten Signals vorhanden, da sie bei der inversen Transformation durch die Verschiebung im Frequenzbereich nicht ausgelöscht werden. Diese als Spitzen im FFT-Spektrum erkennbaren Störer (vgl. Fig. 9) werden bei einer MDCT durch die geringe Sperrbanddämpfung der DCT-IV-Filterbank von nur circa 15 dB durch eine Summe von Anteilen in mehreren der überlappenden MDCT-Bänder dargestellt. Die Energie der Störer im hochauflösenden DFT-Spektrum kann daher als Summenbildung der Energie mehrerer MDCT-Bänder betrachtet werden.

Aufgrund dieses Zusammenhangs wird ein Filter zur Minderung der Störkomponenten im MDCT-Bereich bereitgestellt. Das Filter basiert dabei auf einer sequentiellen Summierung der mit den Filterkoeffizienten gewichteten Frequenzwerte. Die Ausdehnung des Filters um einen zentrierten Frequenzwert repräsentiert dabei den Frequenzbereich, in dem die Störkomponenten ausgelöscht werden. Für jede dominante Aliasing-Komponente wird ein Filterkoeffizient benötigt, der diese minimiert. Das Filter hängt von der Frequenzverschiebung $\varphi$ ab. Es gilt:

$$\underline{\mathbf{X}}_{AntiAlias}(b) = \underline{\mathbf{X}}(b) * \underline{\mathbf{h}}(\varphi) \qquad (4.19)$$

Dabei ist $\underline{\mathbf{h}}(\varphi)$ das reelle Anti-Aliasing-Filter für einen bestimmten Phasenwinkel $\varphi$ und $\underline{\mathbf{X}}(b)$ das komplexe MDCT-/MDST-Spektrum. Das Spektrum nach der Filterung ($\underline{\mathbf{X}}_{AntiAlias}(\mathbf{b})$) ist hierbei länger als das ursprüngliche Spektrum $\underline{\mathbf{X}}(b)$. Daher ist das Spektrum zu beschneiden, damit es wieder der Transformationslänge $N$ entspricht. Es wird der Teil des Spektrums entfernt, in dem das Filter ein- und ausschwingt. Dazu wird am Anfang und am Ende das Faltungsprodukt im komplexen MDCT-/MDST-Bereich jeweils um die halbe Filterlänge beschnitten.

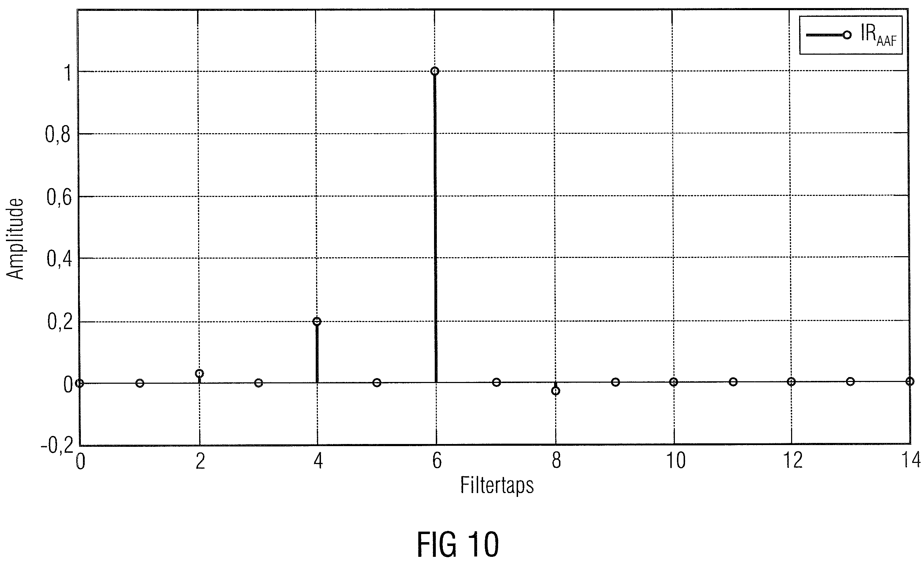

In Fig. 10 ist die Filterimpulsantwort des Anti-Aliasing-Filters (AAF) für $\varphi = 90°$ zu sehen. Am Beispiel eines einzelnen Sinustons ist es mit dem gezeigten Filter möglich, insgesamt sieben dominante Aliasing-Komponenten auszulöschen. Dabei liegen drei Komponenten unter der Frequenz des Sinustons. Diese Komponenten, die entsprechend ihrer Lage zur Frequenz des Sinustons als Komponenten bis zur dritten Ordnung bezeichnet werden, werden durch die Filterkoeffizienten (*engl.: filtertaps*) 0, 2 und 4 behandelt. Die Filtertaps 8, 10, 12 und 14 beseitigen vier Störkomponenten bei Frequenzen oberhalb des Sinustons, also der Komponenten bis zur vierten Ordnung. Insgesamt weist das Filter 15 Koeffizienten auf, wobei jeder zweite Wert Null ist. Das entspricht der Beobachtung oben, dass nur in jedem zweiten Band Aliasing-Komponenten auftreten.

Die Filterkoeffizienten der Fig. 10 weisen somit eine geordnete Reihenfolge auf. Jeder Filterkoeffizient in dieser Reihenfolge hat, der auf einen Filterkoeffizienten folgt, der ungleich Null ist, hat den Wert Null.

Mit einer solchen Filterstruktur ist es generell möglich, beliebig viele Aliasing-Komponenten zu unterdrücken. Es genügt jedoch, die Komponenten bis zur vierten Ordnung auszulöschen. Damit wird ein Signalrauschabstand von mindestens 70 dB erreicht, was als ausreichend erachtet werden kann. Zudem fallen Aliasing-Komponenten hoher Ordnung nur bei sehr großen Phasenwinkeln $\varphi$ auf. Die Beschränkung auf die Auslöschung bis zur vierten Ordnung ist daher ein guter Kompromiss zwischen erreichbarem SNR und Berechnungsaufwand für die Aliasing-Cancelation.

Nachfolgend wird die Optimierung der Anti-Aliasing-Filter erläutert.

Ein wichtiger Bestandteil der beschriebenen Aliasing-Cancelation sind die verwendeten Anti-Aliasing-Filter. Von der Wahl der geeigneten Filterkoeffizienten hängt die erreichbare Minderung der Amplitude der einzelnen Störkomponenten maßgeblich ab. Es ist daher notwendig, diese Filter so zu optimieren, dass eine möglichst hohe Unterdrückung gewährleistet ist. Ein bewährtes Verfahren dazu ist die numerische Optimierung der Filterkoeffizienten mittels sukzessiver Approximation.

Die sukzessive Approximation ist ein Iterationsverfahren der numerischen Mathematik und bezeichnet den Vorgang der schrittweisen Annäherung eines Rechenproblems an die exakte Lösung. Dabei wird ein Rechenverfahren wiederholt angewendet und das Ergebnis eines Schritts als Ausgangswert für den jeweils nächsten Schritt verwendet. Die Folge der Ergebnisse soll konvergieren. Wenn der akzeptable Fehler zur exakten Lösung minimal ist, ist das Ergebnis hinreichend genau bestimmt (Jordan-Engeln und Reutter, 1978).

Zu Beginn des Optimierungsvorgangs wird ein Analysesignal mit Gleichung 4.12 um einen bestimmten Phasenwinkel $\varphi$ moduliert. Das Analysesignal ist aus den oben genannten Gründen ein Sinuston. Die Frequenz des Tons liegt idealerweise bei einem Viertel der zugrundeliegenden Abtastfrequenz. Das hat den Vorteil, dass die entstehenden Aliasing-Komponenten bis zur vierten Ordnung den größtmöglichen Abstand zu den Rändern des Spektrums aufweisen und nicht mit anderen Störkomponenten interferieren. Für die Optimierung ist eine MDCT-Transformationslänge von 32 Abtastwerten ideal. Daraus ergibt sich, dass die Frequenz des Sinustons der Bandmitte des sechzehnten MDCT-Bands entspricht. Die Beschränkung auf diese Transformationslänge bietet einige Vorteile. Zu einem wird dadurch der Berechnungsaufwand der MDCT reduziert. Zum anderen werden die Aliasing-Komponenten bis zur vierten Ordnung ohne Interferenzen mit maximalem Abstand zueinander erzeugt. Das ist besonders für die notwendige Signalspitzenerkennung von Vorteil. Die Signalspitzenerkennung detektiert automatisch die zu unterdrückenden Aliasing-Komponenten im hochauflösenden DFT-Betragsfrequenzgang.

Nach der Modulation des Analysesignals werden nacheinander die Aliasing-Komponenten in einer alternierenden Reihenfolge optimiert. Dies ist notwendig, da sich die Störkomponenten gegenseitig beeinflussen. Dabei wird von der schwächsten Komponente vierter Ordnung bis zur dominantesten erster Ordnung vorgegangen. Damit ist sichergestellt, dass die Aliasing-Komponenten erster Ordnung die größtmögliche Dämpfung erhalten. Für die Direktkomponente, also den Spektralwert wofür die Aliasing-Komponenten ausgelöscht werden sollen, wird im Filter eine Eins gesetzt. Dieser Wert wird während der Optimierung nicht verändert.

Die eigentliche nummerische Optimierung erfolgt nach dem dargestellten Prinzip der sukzessiven Approximation. Dabei wird dem zu optimierenden Filterkoeffizienten ein Anfangswert zugewiesen, alle anderen Koeffizienten bis auf die Direktkomponente bleiben Null. Anschließend wird das komplexe MDCT-/MDST-Spektrum mit diesem Filter gefaltet und der Betragsfrequenzgang auf eine Reduktion der betreffenden Störkomponente untersucht. Ist dies der Fall, wird der Filterkoeffizient entsprechend der eingestellten Schrittweite erhöht. Dieses Vorgehen aus Untersuchung und Erhöhung wird so lange wiederholt, bis keine stärkere Unterdrückung dieser Aliasing-Komponente mehr möglich ist. Anschließend wird mit den folgenden Filterkoeffizienten auf gleiche Weise verfahren, wobei bereits optimierte Filterkoeffizienten beibehalten werden.

Durch die Beeinflussung der Aliasing-Komponenten untereinander ist es sinnvoll, mehrere Iterationen dieses Vorgehens durchzuführen. Bei jeder Iteration wird dabei die Schrittweite verkleinert, mit der die Filterkoeffizienten erhöht werden. Damit steigt bei jedem Durchlauf die Qualität der optimierten Filter. Es zeigt sich, dass für ein optimales Filterset bestehend aus je einem Filter pro Phasenwinkel, drei Iterationen ausreichen. Damit ist es möglich, die Aliasing-Komponenten auf < -90 dB zu reduzieren.

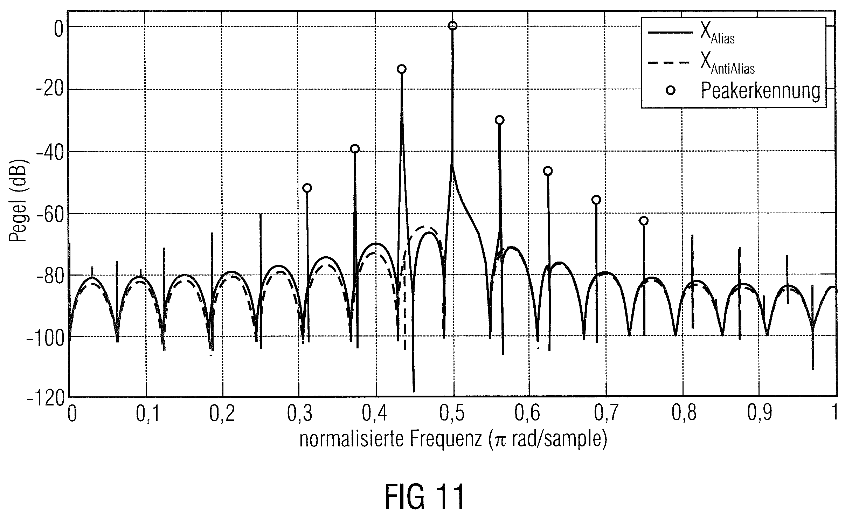

Fig. 11 stellt den Einfluss der Anti-Aliasing-Filterung auf ein Sinussignal für $\varphi$ = 90° dar. $X_{Alias}$ ist dabei ein mit $\varphi$ = 90° moduliertes Sinussignal; $X_{AntiAlias}$ ist ein gefiltertes Signal mit unterdrückten Störkomponenten.

Im Speziellen, ist in Fig. 11 der Einfluss der Anti-Aliasing-Filterung auf ein mit $\varphi$ = 90° moduliertes Sinussignal im Betragsfrequenzgang zu sehen. $X_{Alias}$ ist dabei das Spektrum des modulierten Signals und $X_{AntiAlias}$ das des modulierten Signals, gefaltet mit dem optimierten Filter für den entsprechenden Phasenwinkel. Die mit *Peakerkennung* gekennzeichneten Spitzen im Spektrum sind die durch die Signalspitzenerkennung detektierten Aliasing-Komponenten inklusive der Direktkomponente (vierte erkannte Spitze von links). Die numerische Optimierung der Filter reduziert die Störkomponenten in diesem Beispiel im Schnitt auf -103 dB.

Es genügt, einmalig einen Satz von Filtern für jeden Phasenwinkel im Wertebereich zu erstellen. Für die Filterung des Signals kann dann das benötigte Filter aus einer Datenbank geladen werden.

Beispielsweise können die Filterkoeffizienten des Filters in Abhängigkeit von dem Phasenwinkel aus einer Datenbank oder einem Speicher einer Vorrichtung zur Erzeugung eines frequenzverschobenen Audiosignals ausgelesen werden.

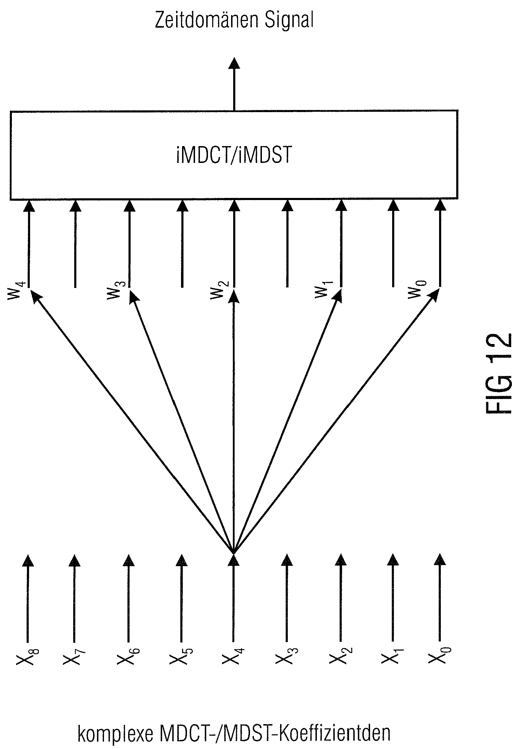

Fig. 12 zeigt die Butterfly-Struktur. Die Gewichte werden durch sukzessive Näherungen bestimmt. Fig. 12 zeigt dabei die Aliasing-Reduzierung für das Subband $X_4$ (schwarze Linie). Dasselbe Verfahren ist für alle modifizierten Subbänder entsprechend durchzuführen. Zur Reduzierung der Aliasing-Komponente, die durch die Modulation von $X_4$ verursacht wird, ist $X_4$ mit den Gewichten wo bis $w_4$ zu multiplizieren und zu den Subband-Signalen $X_0$, $X_2$, $X_4$, $X_6$ und $X_8$ zu addieren. Es ist zu beachten, dass das Gewicht $w_2$ immer 1 ist.

Umgekehrt bedeutet dies: Um einen gefilterten Subband-Wert eines der Subbänder zu erzeugen, ist eine Summe aus dem ungefilterten Subband-Wert dieses Subbands und weiteren Summanden zu bilden. (das Gewicht/der Filterkoeffizient $w_2$, der auf den ungefilterten Subband-Wert dieses Subbands angewandt würde, ist $w_2$=1). Die weiteren Summanden sind gewichtete Subband-Werte, nämlich jeweils ein Subband-Wert anderer Subbänder, die mit den anderen Gewichten/Filterkoeffizienten multipliziert bzw. gewichtet wurden.

Im Folgenden wird die Rekonstruktion der spektralen Einhüllenden beschrieben.

Die Rekonstruktion der spektralen Einhüllenden erfolgt über eine LPC-Filterung. Dabei werden im Encoder durch ein lineares Prädiktionsfilter die tonalen Anteile des Signals entfernt und als LPC-Koeffizienten separat übertragen. Die dazu benötigten Filterkoeffizienten können durch die Levinson-Durbin-Rekursion berechnet werden (Larsen und Aarts, 2004). Als Ergebnis erhält das Basisband im Decoder eine weiße Spektralcharakteristik. Nach der Bandbreitenerweiterung mittels HSBE wird eine inverse Filterung mit den LPCKoeffizienten durchgeführt und so dem Signal die ursprüngliche spektrale Einhüllende wieder aufgeprägt.

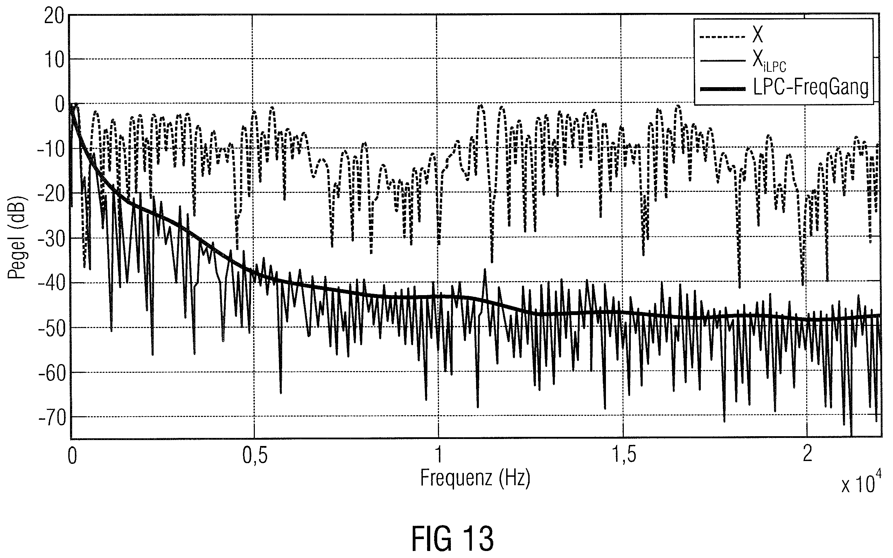

Fig. 13 zeigt eine HSBE-LPC-Hüllkurvenanpassung. Dabei stellt $X$ ein BWE-Signal vor der Hüllkurvenanpassung dar. $X_{iLPC}$ ist ein BWE-Signal nach der Hüllkurvenanpassung.

Im Speziellen sind in Fig. 13 die DFT-Betragsfrequenzgänge eines mit HSBE bandbreitenerweiterten Signals zu sehen. Vor der Rekonstruktion der spektralen Einhüllenden weist das Signal $X$ die angesprochene weiße Signalcharakteristik auf. Nach der Anpassung der Einhüllenden durch die inverse LPC-Filterung entspricht die Einhüllende der ursprünglichen Spektralcharakteristik. In der Fig. 13 ist zudem die Übertragungsfunktion des genutzten LPC-Filters zu sehen. Für eine hinreichend genaue Beschreibung der spektralen Einhüllenden reichen schon wenige Filterkoeffizienten aus, in diesem Beispiel werden 14 LPC-Filtertaps verwendet. Die Hüllkurvenrekonstruktion ist kein fester Bestandteil von HSBE und kann durch andere Verfahren ausgetauscht werden.

Im Rahmen einer Evaluation wird hier nun eine Auswertung der bereitsgestellten Konzepte durchgeführt. Dazu zählt sowohl ein Vergleich zwischen dem neuen Verfahren der harmonischen Spektralbanderweiterung und der Bandbreitenerweiterung mittels CM-BWE als auch die Untersuchung der Effizienz von HSBE bezüglich der Möglichkeiten und Grenzen sowie dem algorithmischen Berechnungsaufwand.

Zunächst wird hier nun ein Vergleich der Spektralbandreplikationsverfahren präsentiert.

Die Bandbreitenerweiterung mittels kontinuierlicher Einseitenbandmodulation ist ein Zeitbereichsverfahren. Für die Anwendung wird daher stets ein Zeitsignal benötigt. Da nach der Bandbreitenerweiterung eine Hüllkurven- und Tonalitätsanpassung stattfindet, wofür jeweils ein Signal im Spektralbereich benötigt wird, muss bei Anwendung des CM-BWE-Verfahrens das bandbreitenerweiterte Signal wieder in den Frequenzbereich transformiert werden. Diese Transformation in den Zeit- und wieder in den Frequenzbereich entfällt bei der harmonischen Spektralbanderweiterung, da sie im MDCT-/MDST-Bereich arbeitet.

Zusätzlich ist das Zeitsignal vor Anwendung der kontinuierlichen Einseitenbandmodulation in ein analytisches Signal umzuwandeln. Die Berechnung des benötigten analytischen Signals ist problematisch, da sie über einen Hilbert-Transformator realisiert wird. Die ideale Übertragungsfunktion der Hilbert-Transformation ist die Vorzeichenfunktion. Diese Funktion kann im Zeitbereich nur durch ein unendlich langes Filter dargestellt werden. Mit einem realisierbaren Filter mit endlicher Impulsantwort ist nur eine Annäherung des idealen Hilbert-Transformators möglich. Zudem ist das Signal nach der angenäherten Hilbert-Transformation nicht perfekt analytisch. Die Güte des berechneten pseudo-analytischen Signals hängt daher von der Länge des verwendeten Filters ab.

Auch für die Anwendung der harmonischen Spektralbanderweiterung ist eine zusätzliche Transformation nötig. Da HSBE im Frequenzbereich arbeitet, ist für die Berechnung der Phasenmodulation ein komplexes Spektrum erforderlich. In der Decoder-Struktur liegen vor Anwendung der Bandbreitenerweiterung jedoch nur MDCT-Koeffizienten vor. Daher ist eine Überführung der MDCT-Koeffizienten in den MDST-Bereich durchzuführen, um ein komplexes Spektrum zu erhalten und somit die benötigte Phaseninformation zu erlangen. Dies wird hier beispielhaft als über eine Matrixmultiplikation realisiert angesehen, die durch Vereinfachung einer inversen MDCT-Transformation und anschließender MDST-Transformation entstanden ist. Wie gezeigt, lässt sich der dazu benötigte Berechnungsaufwand stark minimieren und dennoch eine exakte Berechnung der MDST-Koeffizienten durchführen.

Wird der schematische Aufbau des Betragsfrequenzgangs nach Anwendung von CM-BWE und HSBE betrachtet, dann ist erkenntlich, dass ein Teil des Spektrums bei CM-BWE durch weißes Rauschen aufgefüllt werden muss. In diesem Bereich geht die harmonische Struktur verloren, da hier einzelne harmonische Teiltöne nicht repliziert werden können. Diese Problematik ist bei Anwendung von HSBE nicht gegeben. Die harmonische Struktur wird ohne Lücken fortgesetzt.

Im Folgenden wird nun die Komplexität der harmonischen Spektralbanderweiterung betrachtet.

Die Effizienz der neuen harmonischen Spektralbanderweiterung hängt von dem benötigten Berechnungsaufwand und Speicherplatz ab. Die Untersuchung dieser Faktoren basiert auf der Implementierung des Algorithmus in der Programmiersprache C. Bei der algorithmischen Umsetzung wird viel Wert auf eine Minimierung der Anzahl der Berechnungsschritte gelegt. Zu den rechenintensivsten Schritten gehören dennoch die Transformation der MDCT-Koeffizienten in MDST-Spektralwerte sowie die Anti-Aliasing-Filterung. Die Modulation zur harmonisch richtigen Replikation des Spektrums ist vergleichsweise einfach, da die Verschiebung um den Modulationsindex $\tau$ nur einem Kopiervorgang entspricht und die Phasendrehung um den Winkel $\varphi$ sich auf eine komplexe Multiplikation pro Spektralwert reduzieren lässt. Die Anpassung der spektralen Einhüllenden fließt in diese Betrachtung nicht mit ein. Da sie kein Evaluation wesentlicher Bestandteil des HSBE-Verfahrens ist, wird sie nicht algorithmisch umgesetzt.

In die Auswertung fließen alle relevanten Befehle wie Additionen (ADD), Multiplikationen (MULT) und die bei der Anti-Aliasing-Filterung durchgeführten Multiply-and-Accumulate (MAC) Befehle ein. In Tabelle 5.1 sind die Ergebnisse für die Modulation und Filterung des Spektrums zusammengefasst. Sie beziehen sich auf die Funktion local_HSBEpatching(), worin die entsprechenden Algorithmen implementiert sind.

Tabelle 5.1

| N | 2 | 4 | 8 | 16 | 32 | 64 | 128 | 256 | 512 | 1024 | 2048 |
|------|----|----|----|-----|-----|-----|------|------|------|------|-------|
| ADD | 4 | 8 | 16 | 32 | 64 | 128 | 256 | 512 | 1024 | 2048 | 4096 |
| ABS | 1 | 1 | 1 | 1 | 1 | 1 | 1 | 1 | 1 | 1 | 1 |
| MULT | 6 | 12 | 24 | 48 | 96 | 192 | 384 | 768 | 1536 | 3042 | 6144 |
| MAC | 16 | 32 | 64 | 128 | 256 | 512 | 1024 | 2048 | 4096 | 8192 | 16384 |

Tabelle 5.1 stellt die Komplexität der Modulation und Anti-Aliasing-Filterung von HSBE tabellarisch dar. Die Auflistung beinhaltet die Anzahl der relevanten Operationen in Abhängigkeit der Transformationslänge $N$. Für die Modulation des Spektrums werden insgesamt 10241 Operationen für $N = 2048$ benötigt, davon $2N$ Additionen und $3N$ Multiplikationen. Wesentlich höher fällt der Aufwand für die benötigte Aliasing-Cancelation aus. Hier werden 16384 MAC-Operationen durchgeführt. Das entspricht der Anzahl der nicht-Null Elemente des Anti-Aliasing-Filters multipliziert mit der Transformationslänge, in diesem Fall also $8N$ (Vergleiche die Ausführungen zur Anti-Aliasing Filterung oben). Mit diesem Ergebnis ergibt sich für den Rechenaufwand der Modulation sowie der AAF ein linearer Zusammenhang mit der Komplexität $O(N)$.

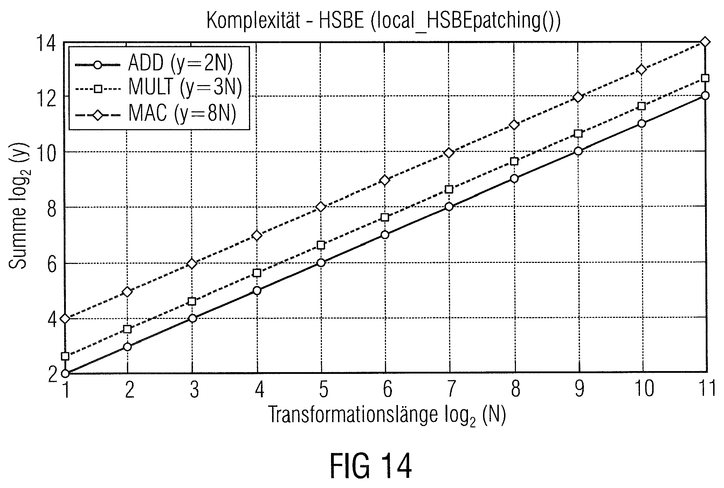

In Fig. 14 ist dieser Zusammenhang grafisch dargestellt. Dabei stellt Fig. 14 die Komplexität der Modulation und Anti-Aliasing-Filterung von HSBE dar.

Ein zentrales Element der harmonischen Spektralbanderweiterung ist die Transformation des Signals mittels MDCT und MDST. Ähnlich der schnellen Fouriertransformation wird auch für diese Transformationen ein schneller Algorithmus verwendet. Die Struktur der zugrundeliegenden schnellen DCT-IV wird weiter unten erläutert. Die Ergebnisse der Auswertung beziehen sich auf die Funktion fmdcst1d(), in der die schnelle MDCT/MDST nach dem oben beschriebenen Polyphasenansatz implementiert ist. Die Analyse der MDCT und MDST ist in Tabelle 5.2 zusammengefasst.

Tabelle 5.2 - Komplexität der schnellen MDCT/MDST

| N | 2 | 8 | 32 | 128 | 512 | 2048 |
|------|----|-----|------|------|-------|--------|
| ADD | 5 | 106 | 1046 | 6630 | 35974 | 181094 |
| MULT | 7 | 40 | 204 | 956 | 4348 | 19452 |

Die Auswertung dieser Ergebnisse zeigt, dass insgesamt circa $9 \cdot N$ ld $N$ Operationen für die Berechnung einer MDCT beziehungsweise MDST benötigt werden. Bei der inversen Transformation werden $N$ Multiplikationen mehr durchgeführt. Das liegt daran, dass hier die zur Transformation notwendige Skalierung vorgenommen wird. Die entsprechende Auswertung ist in Tabelle 5.3 zusammengefasst.

Tabelle 5.3 - Komplexität der schnellen inversen MDCT/MDST

| N | 2 | 8 | 32 | 128 | 512 | 2048 |
|------|----|-----|------|------|-------|--------|
| ADD | 5 | 106 | 1046 | 6630 | 35974 | 181094 |
| MULT | 9 | 48 | 236 | 1084 | 4860 | 21500 |
| DIV | 1 | 1 | 1 | 1 | 1 | 1 |

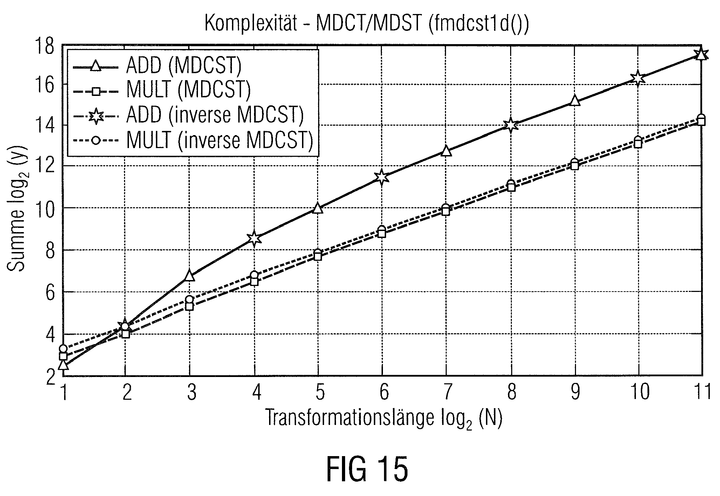

Daraus ergibt sich eine Komplexität von $O(N \log N)$ für die Vorwärts- als auch die Invers-Transformation. Der implementierte Algorithmus erfüllt damit wie erwartet die Anforderung an eine schnelle Transformation. Die Ergebnisse dieser Auswertung sind in Fig. 15 gezeigt.

Fig. 15 zeigt die Komplexität der schnellen MDCT/MDST. Es ist zu beachten, dass für die Überführung des Signals aus dem komplexen MDCT-/MDST-Bereich in den Zeitbereich zwei inverse Transformationen berechnet werden müssen. Die Anzahl der benötigten Operationen verdoppelt sich.

Die exakte Überführung der MDCT-Koeffizienten in MDST-Spektralwerte stellt in HSBE den rechenintensivsten Vorgang dar. Hier entsteht nicht nur ein konstantes Delay von einem Block, sondern auch die größte Rechenzeit. Auch wenn der benötigte Aufwand durch das eingeführte Verfahren verringert ist, ergeben sich hier die meisten Operationen, wie in Tabelle 5.4 zusammengefasst.

Tabelle 5.4 - Komplexität der exakten MDCT-MDST-Transformation

| N | 2 | 8 | 32 | 128 | 512 | 2048 |
|---|---|---|---|---|---|---|
| **ADD** | 6 | 120 | 2016 | 32640 | 523776 | 8386560 |
| **MULT** | 12 | 144 | 2112 | 33024 | 525312 | 8392704 |

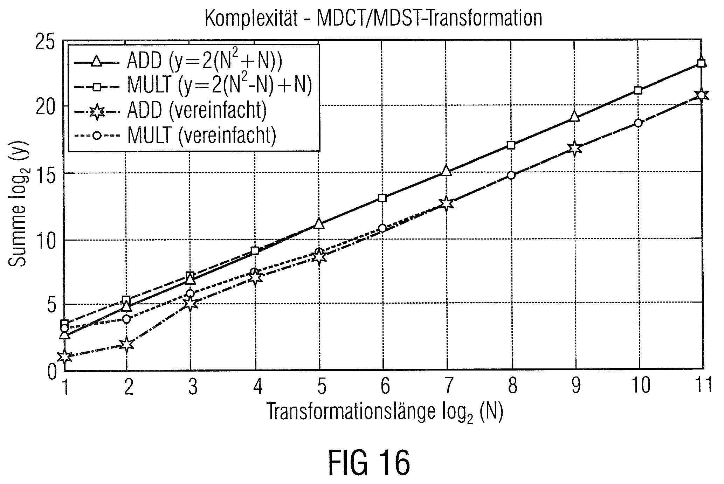

Für die Multiplikation der vollbesetzten Matrizen $\underset{\sim}{H}_0$ und $\underset{\sim}{H}_2$ an den Spektralvektor werden in Summe jeweils $N^2$ Multiplikationen und N(N - 1) Additionen benötigt. Die schwachbesetzte Matrix $\underset{\sim}{H}_1$ ermöglicht eine effiziente Implementierung, so dass hier $2N$ Multiplikationen und $N$ Additionen durchgeführt werden müssen. Für die exakte Überführung der MDCT-Werte in MDST-Koeffizienten werden insgesamt $4N^2 + N$ Additionen und Multiplikationen berechnet. Damit besteht für die Komplexität des implementierten Algorithmus eine quadratische Abhängigkeit von der Transformationslänge. Sie kann mit $O(N^2)$ angegeben werden. Das vereinfachte Verfahren benötigt in etwa entsprechend dem Verhältnis $2\sigma+1/N$ weniger Operationen. Der entsprechende Zusammenhang ist in Fig. 16 dargestellt. Fig. 16 zeigt dabei die Komplexität der MDCT-MDST-Transformation.

Neben der algorithmischen Komplexität spielt die Speicherauslastung für die Betrachtung der Effizienz eine wichtige Rolle. Je nach Endgerät, auf dem der Audiodecoder ausgeführt wird, steht unter Umständen nur sehr begrenzt Speicherplatz zur Verfügung. Es ist daher notwendig, die Auslastung des Hauptspeichers so gering wie möglich zu halten. In Tabelle 5.5 sind die verwendeten Ressourcen aufgelistet. Die Modulbeschreibung richtet sich dabei nach der gleichnamigen C-Quelldatei. Betrachtet werden dabei nur die wesentlichen Puffer, die zum Speichern und Verarbeiten von Signalvektoren und -matrizen benötigt werden.

Tabelle 5.5 - Speicherverbrauch durch HSBE:

| Modul | Elemente | Größe in Byte | Größe in KiB |
|---|---|---|---|
| **hsbelib** | 20480 | 81920 | 80 |
| **Hmatrix** | 4194304 (205) | 16777216 (820) | 16384 (0,80) |
| **hsbeCanv** | 15 | 60 | 0,05 |
| **fastDCSTIV** | 3072 | 12288 | 12 |
| **fastDCSTIII** | 4096 | 16384 | 16 |
| **AAFdatabase** | 2715 | 10860 | 10,61 |
| **gesamt** | 4224682 (30583) | 16898728 (122332) | 16502,66 (119,46) |

Angabe in (): beinhaltet die vereinfachte Berechnung der MDCT-MDST-Transformation

Die Implementierung der harmonischen Spektralbanderweiterung basiert auf der single-precision Gleitkomma-Arithmetik (einfache Genauigkeit), eine Gleitkommazahl wird also mit 32 Bit dargestellt. Die in Tabelle 5.5 angegebene Anzahl bezieht sich damit auf die Anzahl der in diesem Modul benötigten Gleitkommazahlen. Wie der Tabelle zu entnehmen ist, fällt die Speicherauslastung für den eigentlichen HSBE-Algorithmus mit circa 109 KiB für die Modulation, Aliasing-Canelation und MDCT/MDST vergleichsweise gering aus. Die Datenbank für die Anti-Aliasing-Filter ist als Look-Up-Tabelle hinterlegt und benötigt für die insgesamt 2715 Filterkoeffizienten knapp 11 KiB. Den bestimmenden Einfluss auf den Speicherplatzbedarf bildet die Transformationsmatrix $\underset{\sim}{H}_0$ Für diese Matrix werden ungefähr 16 MiB Arbeitsspeicher verwendet. Durch die oben vorgestellten Vereinfachungen der MDCT-/MDST-Transformation reduziert sich der benötigte Speicherbedarf der Matrix $\underset{\sim}{H}_0$ sehr stark. Für behandelte Beispiel mit $\sigma = \lceil 0,1 \cdot N \rfloor$ werden damit gerade noch circa 0,8 KiB Arbeitsspeicher in Anspruch genommen.

Die hier bereitgestellte Bandbreitenerweiterung mittels harmonischer Spektralbanderweiterung ermöglicht mit den vorgestellten Techniken die harmonisch korrekte Erweiterung des Spektrums. Nachfolgend werden die Möglichkeiten und Grenzen der bereitgestellten Konzepte aufgezeigt.

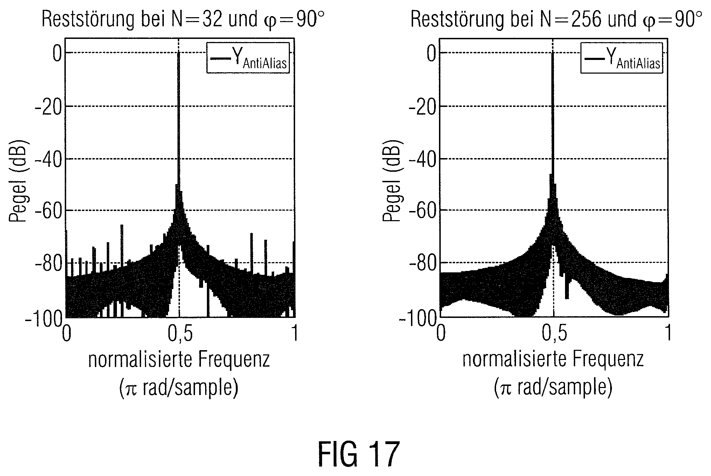

Generell können unterschiedlich lange Signale verarbeitet werden. Für die Berechnung der implementierten schnellen MDCT/MDST ist es jedoch zwingend erforderlich, dass die Transformationslänge $N$ eine positive ganzzahlige Potenz der Zahl Zwei darstellt. Die maximal mögliche Blocklänge ist in Anlehnung an AAC auf $2^{11}$, also 2048, begrenzt. Bei HSBE ist es auch möglich, die Blocklänge während der Laufzeit zu variieren. Das ist insbesondere für die Transientenbehandlung in modernen Audiocodern notwendig. Der SNR wird maßgeblich durch die Blocklänge bestimmt. Dabei gilt, dass große Transformationslängen zu einem besseren Ergebnis führen, als sehr kurze Blocklängen. Das liegt an den durch die Modulation auftretenden Aliasing-Komponenten. Zwar werden durch die Anti-Aliasing-Filterung Störer bis zur vierten Ordnung unterdrückt, dennoch verbleiben einige unerwünschte Komponenten im Signal. Bei sehr kleinen Blocklängen erstrecken sich diese Aliasing-Komponenten über eine große Bandbreite und sind deutlich hörbar. Bei großen Transformationslängen wird die Bandbreite entsprechend kleiner und die Aliasing-Komponenten werden maskiert. Als Grenze hat sich in verschiedenen Versuchen eine Blocklänge von 256 herausgestellt. Ab dieser Länge werden die Artefakte kaum mehr wahrgenommen, sowie in Fig. 17 gezeigt.

Fig. 17 zeigt eine Reststörung bei HSBE in Abhängigkeit der Transformationslänge. In Fig. 17 links ist ein Spektrum nach der inversen MDCT mit $N = 32$ und $\varphi = 90$ gezeigt. In Fig. 17, rechts ist ein Spektrum nach der inversen MDCT mit $N = 256$ und $\varphi = 90$ gezeigt.

Zu sehen sind die Betragsfrequenzgänge eines mit dem Phasenwinkel $\varphi$ modulierten Sinus-Signals. Wie deutlich zu erkennen ist, treten bei kleinen Blockgrößen (in Fig. 17, links) auch nach der Aliasing-Cancelation deutlich Störkomponenten auf. Sie liegen im Bereich von circa -70 dB und bestimmen den SNR. Bei Blockgrößen größer 256 (in Fig. 17, rechts) werden diese Anteile durch das Nutzsignal verdeckt.

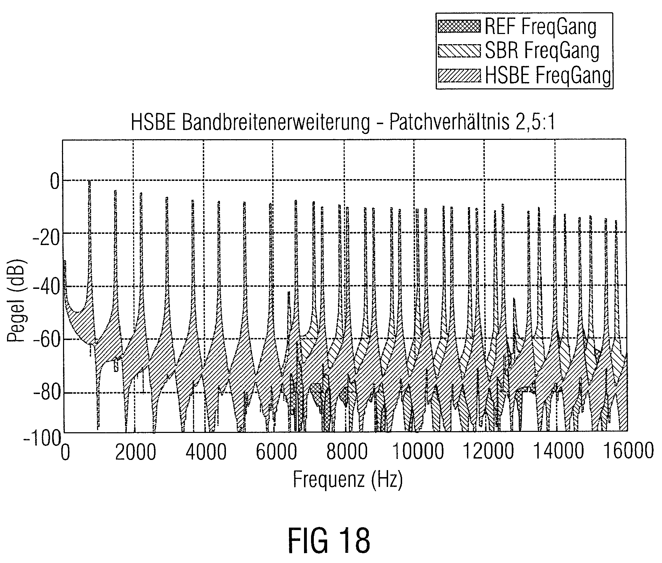

Insgesamt liefert die harmonische Spektralbanderweiterung eine sehr genaue Rekonstruktion der harmonischen Struktur des Signals. Für eine Transformationslänge von 256 und einer Abtastfrequenz der Audiodaten entsprechend dem CD-Standard von 44100 Hz liegt die Auflösung des entwickelten Verfahrens im Bereich von circa 0,5 Hz. Das bedeutet, dass das Spektrum bis auf ein halbes Hertz genau moduliert werden kann. Für kleinere Abtastfrequenzen oder größere Blocklängen steigt die Auflösung und die Modulation ist in noch feineren Bereichen durchführbar. Das Resultat der Anwendung von HSBE auf ein Multi-Sinussignal ist in Fig. 18 dargestellt.

Fig. 18 zeigt einen Vergleich der HSBE mit der SBR. REF FreqGang bezeichnet ein Spektrum des ursprünglichen Multi-Sinussignals. SBR FreqGang bezeichnet ein mittels SBR bandbreitenerweitertes Signal; HSBE FreqGang bezeichnet ein mittels HSBE bandbreitenerweitertes Signal.

Wie in den gezeigten Betragsfrequenzgängen zu erkennen ist, wird mit dem entwickelten HSBE-Verfahren das Spektrum exakt rekonstruiert. Nach der Bearbeitung des bandbegrenzten Signals mit HSBE (HSBE FreqGang) liegt das Spektrum genau über dem ursprünglichen Spektrum (REF FreqGang). Im Vergleich dazu ist das entsprechende Spektrum gezeigt, das nicht harmonisch angepasst ist (SBR FreqGang). Dieses Signal ist zwar mit dem HSBE-Algorithmus berechnet, jedoch ist die zugrundeliegende Lag-Frequenz Null. Dadurch wird eine Bandbreitenerweiterung bewirkt, die im Wesentlichen dem SBR-Verfahren entspricht. Hier ist die Verschiebung der harmonischen Struktur an der Grenzfrequenz $f$g = 6400Hz und dem Doppelten dieser Frequenz deutlich zu sehen.

Nachfolgend werden Herleitungen bereitgestellt.

Zunächst erfolgt eine Herleitung der Überführung der DFT in die DCT-II. Im Speziellen wird die DCT-II aus der DFT in Gleichung 2.10 mit Gleichung 2.12 hergeleitet (siehe hierzu auch Rao und Yip, 2001). Es gilt:

$$\check{X}[k] = \sum_{n=0}^{2N-1} \check{x}[n] e^{-j\frac{2\pi}{2N}kn} \tag{A.1a}$$

$$= \sum_{n=0}^{N-1} \check{x}[n] \left[ e^{-j\frac{\pi}{N}kn} + e^{-j\frac{\pi}{N}k(2N-1-n)} \right] \tag{A.1b}$$

$$= \sum_{n=0}^{N-1} \check{x}[n] e^{j\frac{\pi}{2N}k} \left[ e^{-j\frac{\pi}{N}k(n+0,5)} + e^{-j\frac{\pi}{N}k(2N-0,5-n)} \right] \tag{A.1c}$$

$$= 2 e^{j\frac{\pi}{2N}k} \sum_{n=0}^{N-1} \check{x}[n] \cos\left( \frac{\pi(n+0.5)k}{N} \right), \quad \forall k \in [0, N-1] \tag{A.1d}$$

mit:

$$e^{-j\frac{\pi}{N}k(n+0,5)} + e^{-j\frac{\pi}{N}k(2N-0,5-n)} = \dots$$
$$= \cos\left( \frac{\pi}{N}k(n+0,5) \right) - j\sin\left( \frac{\pi}{N}k(n+0,5) \right) + \dots$$
$$+ \cos\left( \frac{\pi}{N}k(2N-0,5-n) \right) - j\sin\left( \frac{\pi}{N}k(2N-0,5-n) \right) \tag{A.2a}$$

$$= \cos\left( k\left( \frac{\pi}{N}n + 0,5\frac{\pi}{N} \right) \right) + \cos\left( -k\left( \frac{\pi}{N}n + 0,5\frac{\pi}{N} \right) + 2\pi k \right) + \dots$$
$$- j\sin\left( k\left( \frac{\pi}{N}n + 0,5\frac{\pi}{N} \right) \right) - j\sin\left( -k\left( \frac{\pi}{N}n + 0,5\frac{\pi}{N} \right) + 2\pi k \right) \tag{A.2b}$$
$$= 2\cos\left( \frac{\pi}{N}k(n+0,5) \right) \tag{A.2c}$$

und den Eigenschaften der Sinus- und Cosinusfunktion:

$$\cos(-x) = \cos(x) \tag{A.3a}$$

$$\cos(2\pi + x) = \cos(x) \tag{A.3b}$$

$$\sin(-x) = -\sin(x) \tag{A.3c}$$

$$\sin(2\pi + x) = \sin(x) \qquad\qquad (A.3d)$$

Dieser Zusammenhang kann auch genutzt werden, um die DCT effektiv mit Hilfe der FFT zu berechnen (vergleiche hierzu Ahmed u. a., 1974).

Im Folgenden wird auf die Foldingmatrizen eingegangen.

Die zur Berechnung der MDCT (vgl. Gleichung 2.35) notwendigen Foldingmatrizen $\mathbf{F}_a$ und $\mathbf{F}_s$ setzten sich aus einer Delaymatrix und der Fenstermatrix $\mathbf{F}$ zusammen. Die Fenstermatrix enthält die Koeffizienten der Fensterfunktion $w[n]$ angeordnet in Diamantstruktur. Es gilt:

$$\mathbf{F}_a = \mathbf{D} \cdot \mathbf{F} \qquad\qquad (A.4a)$$

$$= \begin{bmatrix} 0 & w[\frac{N}{2}-1]z^{-1} & w[\frac{N}{2}]z^{-1} & 0 \\ \ddots & & & \ddots \\ w[0]z^{-1} & 0 & & w[N-1]z^{-1} \\ w[N] & & & -w[2N-1] \\ \ddots & & & \ddots \\ 0 & w[N+\frac{N}{2}-1] & -w[N+\frac{N}{2}] & 0 \end{bmatrix} \qquad (A.4b)$$

$$(A.4c)$$

$$\mathbf{F}_s = \mathbf{F}^\mathsf{T} \cdot \mathbf{D}^{-1} \qquad\qquad (A.5a)$$

$$= \begin{bmatrix} 0 & w[0] & w[N]z^{-1} & 0 \\ \ddots & & & \ddots \\ w[\frac{N}{2}-1] & 0 & & w[N+\frac{N}{2}-1]z^{-1} \\ w[\frac{N}{2}] & & & -w[N+\frac{N}{2}]z^{-1} \\ \ddots & & & \ddots \\ 0 & w[N-1] & -w[2N-1]z^{-1} & 0 \end{bmatrix} \qquad (A.5b)$$

mit:

$$\mathbf{F} = \begin{bmatrix} 0 & w[\frac{N}{2}-1] & w[\frac{N}{2}] & 0 \\ \ddots & & & \ddots \\ w[0] & 0 & & w[N-1] \\ w[N] & & & -w[2N-1] \\ \ddots & & & \ddots \\ 0 & w[N+\frac{N}{2}-1] & -w[N+\frac{N}{2}] & 0 \end{bmatrix} \qquad (A.6)$$

und:

$$\underset{\sim}{\mathbf{D}} = \begin{bmatrix} z^{-1} & & & & & 0 \\ & \ddots & & & & \\ & & z^{-1} & & & \\ & & & 1 & & \\ & & & & \ddots & \\ 0 & & & & & 1 \end{bmatrix} \qquad (A.7a)$$

$$\underset{\sim}{\mathbf{D}}^{-1} = \begin{bmatrix} 1 & & & & & 0 \\ & \ddots & & & & \\ & & 1 & & & \\ & & & z^{-1} & & \\ & & & & \ddots & \\ 0 & & & & & z^{-1} \end{bmatrix} \qquad (A.7b)$$

Um die Kausalität zu bewahren, ist die inverse Delaymatrix $\underset{\sim}{\mathbf{D}}^{-1}$ mit dem Delay $z^{-1}$ multipliziert worden. Das Delay der MDCT-Filterbank ist darin begründet (Schuller und Smith, 1996).

**Transformationsmatrix H**

Die Transformationsmatrix $\underset{\sim}{\mathbf{H}}$ wird zur Überführung des MDCT Spektrums in das zugehörige MDST Spektrum benötigt. Es gilt:

$$\underset{\sim}{\mathbf{H}} = \underset{\sim}{\mathbf{T}}_{DST} \cdot \underset{\sim}{\mathbf{D}} \cdot \underset{\sim}{\mathbf{F}}_{sin} \cdot \underset{\sim}{\mathbf{F}}^{\mathrm{T}} \cdot \underset{\sim}{\mathbf{D}}^{-1} \cdot \underset{\sim}{\mathbf{T}}^{-1} \qquad (A.8)$$

Die genaue Zerlegung wird nun am Beispiel von $N = 4$ gezeigt:

$$\underset{\sim}{\mathbf{T}'} = \begin{bmatrix} a_{1,1} & a_{1,2} & a_{1,3} & a_{1,4} \\ a_{2,1} & a_{2,2} & a_{2,3} & a_{2,4} \\ a_{3,1} & a_{3,2} & a_{3,3} & a_{3,4} \\ a_{4,1} & a_{4,2} & a_{4,3} & a_{4,4} \end{bmatrix} \cdot \begin{bmatrix} z^{-1} & 0 & 0 & 0 \\ 0 & z^{-1} & 0 & 0 \\ 0 & 0 & 1 & 0 \\ 0 & 0 & 0 & 1 \end{bmatrix}$$

$$= \begin{bmatrix} a_{1,1}z^{-1} & a_{1,2}z^{-1} & a_{1,3} & a_{1,4} \\ a_{2,1}z^{-1} & a_{2,2}z^{-1} & a_{2,3} & a_{2,4} \\ a_{3,1}z^{-1} & a_{3,2}z^{-1} & a_{3,3} & a_{3,4} \\ a_{4,1}z^{-1} & a_{4,2}z^{-1} & a_{4,3} & a_{4,4} \end{bmatrix} = \underset{\sim}{\mathbf{T}}_{DST} \cdot \underset{\sim}{\mathbf{D}} \qquad (A.9a$$

$$\underset{\sim}{\mathbf{F}'} = \begin{bmatrix} 0 & -w[1] & w[2] & 0 \\ -w[0] & 0 & 0 & w[3] \\ w[4] & 0 & 0 & w[7] \\ 0 & w[5] & w[6] & 0 \end{bmatrix} \cdot \begin{bmatrix} 0 & w[0] & w[4] & 0 \\ w[1] & 0 & 0 & w[5] \\ w[2] & 0 & 0 & -w[6] \\ 0 & w[3] & -w[7] & 0 \end{bmatrix}$$

$$= \begin{bmatrix} w'_{1,1} & 0 & 0 & w'_{1,4} \\ 0 & w'_{2,2} & w'_{2,3} & 0 \\ 0 & w'_{3,2} & w'_{3,3} & 0 \\ w'_{4,1} & 0 & 0 & w'_{4,4} \end{bmatrix} = \underset{\sim}{\mathbf{F}}_{sin} \cdot \underset{\sim}{\mathbf{F}}^{\mathsf{T}} \qquad\qquad (A.9b)$$

$$\underset{\sim}{\mathbf{T}}'^{-1} = \begin{bmatrix} 1 & 0 & 0 & 0 \\ 0 & 1 & 0 & 0 \\ 0 & 0 & z^{-1} & 0 \\ 0 & 0 & 0 & z^{-1} \end{bmatrix} \cdot \begin{bmatrix} b_{1,1} & b_{1,2} & b_{1,3} & b_{1,4} \\ b_{2,1} & b_{2,2} & b_{2,3} & b_{2,4} \\ b_{3,1} & b_{3,2} & b_{3,3} & b_{3,4} \\ b_{4,1} & b_{4,2} & b_{4,3} & b_{4,4} \end{bmatrix}$$

$$= \begin{bmatrix} b_{1,1} & b_{1,2} & b_{1,3} & b_{1,4} \\ b_{2,1} & b_{2,2} & b_{2,3} & b_{2,4} \\ b_{3,1}z^{-1} & b_{3,2}z^{-1} & b_{3,3}z^{-1} & b_{3,4}z^{-1} \\ b_{4,1}z^{-1} & b_{4,2}z^{-1} & b_{4,3}z^{-1} & b_{4,4}z^{-1} \end{bmatrix} = \underset{\sim}{\mathbf{D}}^{-1} \cdot \underset{\sim}{\mathbf{T}}^{-1} \qquad\qquad (A.9c)$$

Die Matrizen mit den Verzögerungsgliedern $z^{-1}$ können als Addition von je zwei Matrizen dargestellt werden. Damit ergibt sich:

$$\underset{\sim}{\mathbf{T}}'(z) = \underset{\sim}{\mathbf{T}}'(z^0) + \underset{\sim}{\mathbf{T}}'(z^{-1})$$

$$= \begin{bmatrix} 0 & 0 & a_{1,3} & a_{1,4} \\ 0 & 0 & a_{2,3} & a_{2,4} \\ 0 & 0 & a_{3,3} & a_{3,4} \\ 0 & 0 & a_{4,3} & a_{4,4} \end{bmatrix} + \begin{bmatrix} a_{1,1}z^{-1} & a_{1,2}z^{-1} & 0 & 0 \\ a_{2,1}z^{-1} & a_{2,2}z^{-1} & 0 & 0 \\ a_{3,1}z^{-1} & a_{3,2}z^{-1} & 0 & 0 \\ a_{4,1}z^{-1} & a_{4,2}z^{-1} & 0 & 0 \end{bmatrix} \qquad\qquad (A.10a)$$

$$\underset{\sim}{\mathbf{T}}'^{-1}(z) = \underset{\sim}{\mathbf{T}}'^{-1}(z^0) + \underset{\sim}{\mathbf{T}}'^{-1}(z^{-1})$$

$$= \begin{bmatrix} b_{1,1} & b_{1,2} & b_{1,3} & b_{1,4} \\ b_{2,1} & b_{2,2} & b_{2,3} & b_{2,4} \\ 0 & 0 & 0 & 0 \\ 0 & 0 & 0 & 0 \end{bmatrix} + \begin{bmatrix} 0 & 0 & 0 & 0 \\ 0 & 0 & 0 & 0 \\ b_{3,1}z^{-1} & b_{3,2}z^{-1} & b_{3,3}z^{-1} & b_{3,4}z^{-1} \\ b_{4,1}z^{-1} & b_{4,2}z^{-1} & b_{4,3}z^{-1} & b_{4,4}z^{-1} \end{bmatrix}$$

$$(A.10b)$$

Mit dieser Zerlegung und der Matrix $\underset{\sim}{\mathbf{F}}'$ kann die Gleichung A.8 folgendermaßen geschrieben werden:

$$\underset{\sim}{\mathbf{H}}(z) = \underset{\sim}{\mathbf{T}'}(z) \cdot \underset{\sim}{\mathbf{F}'} \cdot \underset{\sim}{\mathbf{T}'^{-1}}(z) \tag{A.11a}$$

$$= \left( \underset{\sim}{\mathbf{T}'}(z^0) + \underset{\sim}{\mathbf{T}'}(z^{-1}) \right) \cdot \underset{\sim}{\mathbf{F}'} \cdot \left( \underset{\sim}{\mathbf{T}'^{-1}}(z^0) + \underset{\sim}{\mathbf{T}'^{-1}}(z^{-1}) \right) \tag{A.11b}$$

$$= \left( \underset{\sim}{\mathbf{T}'}(z^0) \cdot \underset{\sim}{\mathbf{F}'} + \underset{\sim}{\mathbf{T}'}(z^{-1}) \cdot \underset{\sim}{\mathbf{F}'} \right) \cdot \left( \underset{\sim}{\mathbf{T}'^{-1}}(z^0) + \underset{\sim}{\mathbf{T}'^{-1}}(z^{-1}) \right) \tag{A.11c}$$

$$= \underset{\sim}{\mathbf{T}'}(z^0) \cdot \underset{\sim}{\mathbf{F}'} \cdot \underset{\sim}{\mathbf{T}'^{-1}}(z^0) + \underset{\sim}{\mathbf{T}'}(z^{-1}) \cdot \underset{\sim}{\mathbf{F}'} \cdot \underset{\sim}{\mathbf{T}'^{-1}}(z^0) + \dots$$

$$+ \underset{\sim}{\mathbf{T}'}(z^0) \cdot \underset{\sim}{\mathbf{F}'} \cdot \underset{\sim}{\mathbf{T}'^{-1}}(z^{-1}) + \underset{\sim}{\mathbf{T}'}(z^{-1}) \cdot \underset{\sim}{\mathbf{F}'} \cdot \underset{\sim}{\mathbf{T}'^{-1}}(z^{-1}) \tag{A.11d}$$

Die einzelnen Terme der Gleichung werden nun anhand ihrer Abhängigkeit von z substituiert:

$$\underset{\sim}{\mathbf{H}}(z^0) = \underset{\sim}{\mathbf{T}'}(z^0) \cdot \underset{\sim}{\mathbf{F}'} \cdot \underset{\sim}{\mathbf{T}'^{-1}}(z^0) \tag{A.12a}$$

$$\underset{\sim}{\mathbf{H}}(z^{-1}) = \underset{\sim}{\mathbf{T}'}(z^{-1}) \cdot \underset{\sim}{\mathbf{F}'} \cdot \underset{\sim}{\mathbf{T}'^{-1}}(z^0) + \underset{\sim}{\mathbf{T}'}(z^0) \cdot \underset{\sim}{\mathbf{F}'} \cdot \underset{\sim}{\mathbf{T}'^{-1}}(z^{-1}) \tag{A.12b}$$

$$\underset{\sim}{\mathbf{H}}(z^{-2}) = \underset{\sim}{\mathbf{T}'}(z^{-1}) \cdot \underset{\sim}{\mathbf{F}'} \cdot \underset{\sim}{\mathbf{T}'^{-1}}(z^{-1}) \tag{A.12c}$$

und in Gleichung A.11a eingesetzt:

$$\underset{\sim}{\mathbf{H}}(z) = \underset{\sim}{\mathbf{H}}(z^0) + \underset{\sim}{\mathbf{H}}(z^{-1}) + \underset{\sim}{\mathbf{H}}(z^{-2}) \tag{A.13}$$

womit sich die vereinfachte Schreibweise aus Gleichung 4.7 ergibt:

$$\underset{\sim}{\mathbf{H}} = \underset{\sim}{\mathbf{H}}_0 z^0 + \underset{\sim}{\mathbf{H}}_1 z^{-1} + \underset{\sim}{\mathbf{H}}_2 z^{-2} \tag{A.14}$$

Die numerische Analyse der drei Teilmatrizen $\underset{\sim}{\mathbf{H}}_0$, $\underset{\sim}{\mathbf{H}}_1$ und $\underset{\sim}{\mathbf{H}}_2$ liefert einige wichtige Erkenntnisse, die dazu beitragen, den Berechnungsaufwand der Matrix $\underset{\sim}{\mathbf{H}}$ deutlich zu reduzieren. Zunächst fällt auf, dass $\underset{\sim}{\mathbf{H}}_1$ eine schwach-besetzte Matrix ist. Sie weist für unterschiedliche Transformationslängen *N* immer die gleiche Form auf und besitzt ausschließlich die Elemente 0, 5 und -0, 5. Es gilt:

$$\underset{\sim}{\mathbf{H}}_1 = \begin{bmatrix} 0,5 & -0,5 & 0 & & \dots & & 0 \\ 0,5 & 0 & -0,5 & 0 & & & \\ 0 & 0,5 & 0 & -0,5 & 0 & & \vdots \\ & \ddots & \ddots & \ddots & \ddots & \ddots & \\ \vdots & & 0 & 0,5 & 0 & -0,5 & 0 \\ & & & 0 & 0,5 & 0 & -0,5 \\ 0 & & \dots & & 0 & 0,5 & 0,5 \end{bmatrix} \tag{A.15}$$

Zwischen den Matrizen $\underset{\sim}{\mathbf{H}}_0$ und $\underset{\sim}{\mathbf{H}}'_0$ besteht ein direkter Zusammenhang, so dass:

$$\underline{H}_2 = \underline{\Pi}_N \cdot \underline{H}_0^\mathsf{T} \cdot \underline{\Pi}_N \qquad\qquad (A.16)$$

mit:

$$\underline{\Pi}_N = \begin{bmatrix} 0 & \dots & 0 & 1 \\ 0 & \dots & 1 & 0 \\ \vdots & \cdot^{\cdot^{\cdot}} & \vdots & \vdots \\ 1 & \dots & 0 & 0 \end{bmatrix} \qquad\qquad (A.17)$$

Dabei ist $\underline{P}_{s\,N}$ eine $N \times N$ Matrix, die von links multipliziert die Reihenfolge der Zeilen vertauscht und von rechts multipliziert die Reihenfolge der Spalten umdreht. Damit kann Gleichung A.16 als Spiegelung der Werte von Matrix $\underline{H}_0$ an ihrer Nebendiagonalen interpretiert werden. Mit diesen Eigenschaften lässt sich nun der Aufwand zur Berechnung von $\underline{H}$ von ursprünglich $4N^3$ notwendigen Operationen (vgl. Gleichung A.11d) auf ein Viertel davon reduzieren.

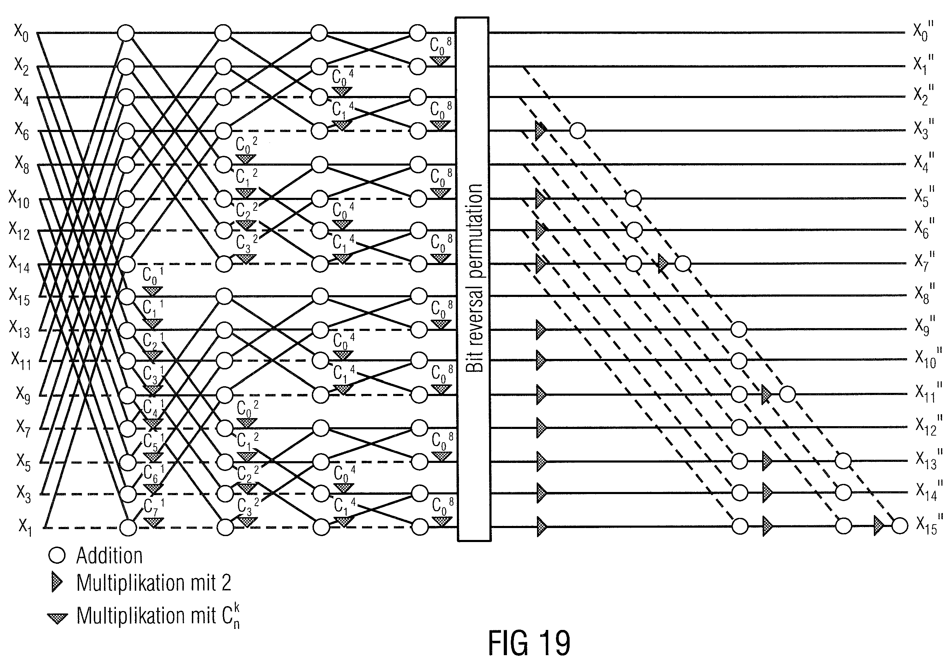

Im Folgenden wird die schnelle DCT-IV erläutert. Die Implementierung der DCT-IV richtet sich nach dem Algorithmus der schnellen DCT-IV. Der Vorteil dieser Umsetzung ist die effiziente Berechnung der Transformation und dem damit verbundenen kurzen algorithmischen Delay. Kern der DCT-IV sind zwei parallel geschaltete DCT-III Transformationen nach Gleichung 2.14c. Diese setzt sich ähnlich der FFT aus einer sogenannten Butterfly- und einer Pipeline-Struktur zusammen (Rao und Yip, 2001). Die Komplexität dieses Algorithmus liegt bei $O(N \log N)$ und ist vergleichbar mit dem benötigten Rechenaufwand der FFT. Der genaue Aufbau der DCT-III ist in Fig. 19 dargestellt. Speziell zeigt Fig. 19 eine schnelle universelle DCT-III/DST-III Struktur (Rao und Yip, 2001)

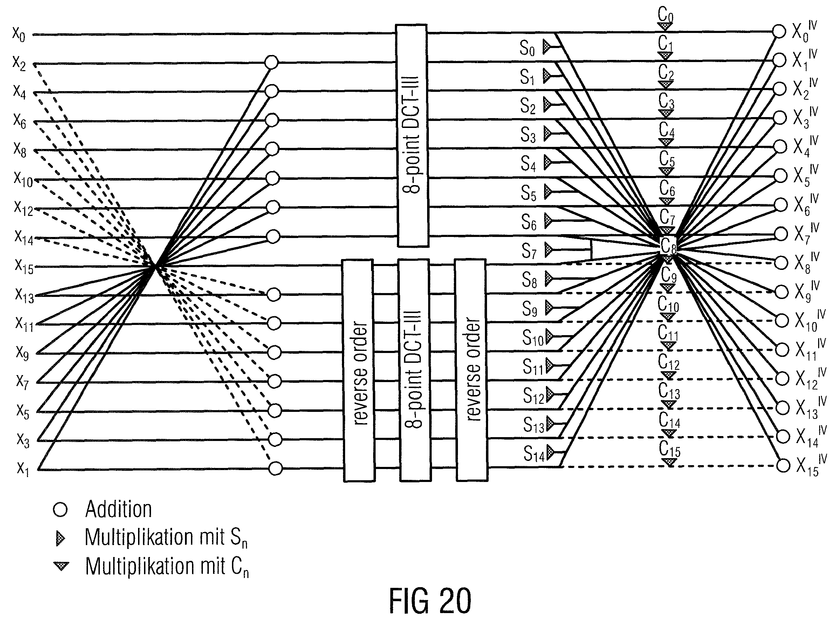

Die Eingangsfolge $x_n$ wird damit in die DCT-II Spektralwerte $\underline{F}a$ überführt. Da die DCT-III die inverse Transformation zur DCT-II darstellt, lassen sich beide Transformationen über diese Struktur berechnen. Diese universelle Struktur zur Berechnung der DCT-III/DST-III und der zugehörigen inversen Transformationen DCT-II und DST-II bildet die Basis für die DCT-IV nach Gleichung 2.14d. In Fig. 20 ist der Aufbau der implementierten DCT-IV zu sehen. Dabei zeigt Fig. 20 eine schnelle DCT-IV Struktur (Rao und Yip, 2001)

Die gezeigten Strukturen können beispielsweise in der Programmiersprache C umgesetzt werden. Die entsprechenden Funktionen sind dct_processor() für die universelle DCT-III/DST-III (DCT-II/DST-II) sowie fdcstivld() für die schnelle DCT-IV/DST-IV. In Matlab ist keine schnelle Variante dieser Transformationen implementiert, da hier die Performance des Algorithmus keine Rolle spielt.

Der folgende Abschnitt dient zur Beschreibung Matlab Funktionen, sowie Funktionen der Programmiersprache C.

**Matlab-Funktionen:**

**decoder_hsbe()**

Beschreibung:

decoder_hsbe() ist ein Decoder für die harmonische Spektralbanderweiterung (HSBE). Ein Tiefpasssignal im MDCT Bereich wird dabei so spektral erweitert, das die harmonische Struktur des Signals erhalten bleibt. Zur Rekonstruktion der Hüllkurve wird eine inverse LPC Filterung durchgeführt. Mittels inverser MDCT wird das Signal in den Zeitbereich überführt.

Prototyp:

[y varargout] = decoder_hsbe(X_core, T_idct, G, sideinfo, ...
aaf_dat, b_noisefill, b_useMDST);

Output:

| | |
|---|---|
| y | rekonstruiertes Zeitsignal |
| varargout(1) | erweitertes MDCT Spektrum vor der Hüllkurvenanpassung |
| varargout(2) | erweitertes MDST Spektrum vor der Hüllkurvenanpassung |
| varargout(3) | komplexes Spektrum vor der Hüllkurvenanpassung |

Input:

| | |
|---|---|
| X_core | Basisband des Signals im MDCT Bereich |
| T_idct | inverse DCT-IV Transformationsmatrix |
| G | inverse Foldingmatrix für die iMDCT in Diamantform |
| sideinfo | Seiteninformationen |
| aaf_dat | Datenbank mit den Anti-Aliasing-Filterkoeffizienten |

Optional:

| | |
|---|---|
| b_noisefill | Boolean, gibt an, ob Rauschen addiert werden soll. Standard: false |
| b_useMDST | Boolean, gibt an, ob vorgerechnete MDST genutzt werden soll. Falls true muss X_core komplex sein. Standard: false |

**AAFCreator.m**

Beschreibung:

Anti-Aliasing-Filter (AAF) FIR-Filter Creation-Tool "AAFCreator": AAF FIR-Filter Creation-Tool berechnet Anti-Aliasing-Filter die zur Aliasing-Cancelation beim Teilbandschieben des HSBE Algorithmus benötigt werden. Die Filter liegen als FIR-Filter in einer Datenbank vor. Die Datenbank wird als .mat Datei gespeichert und beinhaltet ein eindimensionales struct. Jeder Eintrag in der Datenbank besteht aus derWinkelangabe für die das FIR-Filter zu benutzen ist und den Filterkoeffizienten als Vektor.

Prototyp:

Matlab-Script, kein Funktionsname vorhanden.

Output:

| | |
|---|---|
| .bmp | Bitmaps mit der AAF-Impulsantwort und dem Resultat der Aliasing-Cancelation |
| .mat | Datenbank mit den AAF-Filtern im MAT-Datei Format |
| .wav | AAF-Impulsantwort als RIFF-Audio-Datei |

Input:

| | |
|---|---|
| fs | Abtastfrequenz des Testsignals |
| NMDCT | Transformationslänge $N$ |
| sig_typ | Testsignaltyp |
| f | Frequenz des Testsignal |
| t | Zeitdauer des Testsignals |

| phi | Phasenwinkel $\varphi$, mehrere Winkel sind möglich. |
| num_opt | Anzahl der Optimierungsdurchgänge |
| num_alias | höchste Ordnung der zu unterdrückenden Aliasing-Komponenten |
| b_save_wav | Boolean, gibt an, ob .wav Dateien gespeichert werden sollen. |
| b_save_bmp | Boolean, gibt an, ob .bmp Dateien gespeichert werden sollen. |
| b_break | Boolean, gibt an, ob bei Zwischenergebnissen pausiert werden soll. |
| path_bmp | Pfad für die .bmp Dateien |
| path_wav | Pfad für die .wav Dateien |

**AADoptimizer()**

Beschreibung:

AAFoptimizer() generiert einen Anti-Aliasing-Filter (AAF) als FIR-Filter. Der Algorithmus optimiert numerisch die durch eine Signalspitzenkennung detektierten Aliasing-Komponenten mittels sukzessiver Approximation.

Prototyp:

$$[\text{fir } x\_antialias] = \text{AAFoptimizer}(x, X\_cmpx, T\_imdct, ...T\_imdst, \text{varargin});$$

Output:

| fir | Filterimpulsantwort des Anti-Aliasing-Filters im Zeitbereich |
| x_antialias | durch fir aliasing-befreites Eingangssignal x |

Input:

| X | mit Aliasing-Komponenten versehenes Zeitsignal |
| X_cmpx | komplexe Darstellung von x im MDCT/MDST-Bereich |
| T_imdct | inverse MDCT-Matrix |
| T_imdst | inverse MDST-Matrix |

Optional:

| varargin(1) | höchste Ordnung der zu unterdrückenden Aliasing-Komponenten Standard: 4 |
| varargin(2) | Anzahl der Optimierungsdurchgänge; Standard: 3 |
| varargin(3) | Phasenwinkel $\varphi$ mit dem x moduliert wurde; Standard: 0 |
| varargin(4) | Boolean, gibt an, ob Plots erstellt werden sollen. Standard: false |
| varargin(5) | Boolean, gibt an, ob die erstellten Plots gespeichert werden sollen. Standard: false |
| varargin(6) | Pfad für die .bmp Dateien Standard: null |

**C-Funktionen**

**HSBEprocessing()**

Beschreibung:

HSBEprocessing() ist die Hauptschnittstelle der erstellten Statischen Bibliothek hsbe.lib für die Bandbreitenerweiterung mittels HSBE. In der aktuellen Version 1.0 wird ein Signalausschnitt im Zeitbereich per MDCT/MDST transformiert und spektral so ausgeweitet, dass die harmonische Struktur erhalten bleibt. Das komplexe bandbreitenerweiterte Signal wird wieder in den Zeitbereich überführt und ausgegeben. Eine Hüllkurvenrekonstruktion wie in der Matlab-Funktion decoder_hsbe() findet nicht statt.

Prototyp:

HSBE_RESULT HSBEprocessing(HSBE_HANDLE HSBEhandle,...
float *pSamplesIn, float *pSamplesOut, ...
unsigned short nSamplesIn, float frequencyOffset);

Output:

HSBE_RESULT     Fehlercode

pSamplesOut       Zeiger zum Vektor des bandbreitenerweiterten Zeitsignals

Input:

HSBEhandle         HSBE handle struct
pSamplesIn          Zeiger auf den Vektor des Eingangssignals
nSamplesIn          Transformationslänge N
frequencyOffset    Lag-Frequenz *flag* als normalisierte Frequenz

**HSBEinit()**

Beschreibung:

HSBEinit() ist die Funktion zur Initialisierung von HSBE. Hier wird der benötigte Arbeitsspeicher reserviert, die Fensterfunktion berechnet und die MDCT-MDST-Transformationsmatrix $\underset{\sim}{\mathbf{H}}$ berechnet. Zudem werden in das Handle alle erforderlichen Parameter für HSBEprocessing() eingetragen.

Prototyp:

HSBE_RESULT HSBEinit(HSBE_HANDLE *HSBEhandle,...
unsigned short nSamplesIn, float f_core, float f_hsbe,...
unsigned char windowtype, char flags);

Output:

HSBE_RESULT     Fehlercode

HSBEhandle         Zeiger auf das HSBE handle struct

Input:

HSBEhandle     Zeiger auf das HSBE handle struct
nSamplesIn      Transformationslänge *N*
f_core            Grenzfrequenz $f_g$ des Basisbands als normalisierte Frequenz

| f_hsbe | maximale zu rekonstruierende Frequenz als normalisierte Frequenz |
| windowtype | Typ der zu verwendenden Fensterfunktion |
| flags | Kontroll-Flags |

**HSBEfree()**

Beschreibung:

HSBEfree() gibt die durch HSBEinit() angeforderten Ressourcen wieder frei.

Prototyp:

HSBE_RESULT HSBEfree(HSBE_HANDLE *HSBEhandle);

Output:

| HSBE_RESULT | Fehlercode |
| HSBEhandle | Zeiger auf das HSBE handle struct |

Input:

HSBEhandle Zeiger auf das HSBE handle struct

Obwohl manche Aspekte im Zusammenhang mit einer Vorrichtung beschrieben wurden, versteht es sich, dass diese Aspekte auch eine Beschreibung des entsprechenden Verfahrens darstellen, so dass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist. Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Bedeutung der Abkürzungen:**

| | |
|---|---|
| AAC | Advanced Audio Coding |
| AAF | Anti-Aliasing-Filter |
| ac-3 | Dolby Digital Adaptive Transform Coder 3 |
| BWE | Bandbreitenerweiterung (engl.: Bandwidth Extension) |
| CD | Compact Disc |
| CM-BWE | Bandbreitenerweiterung mittels kontinuierlicher Modulation (engl.: Continuously Modulated Bandwidth Extension) |
| DCT | Diskrete Cosinustransformation |
| DFT | Diskrete Fouriertransformation |
| DST | Diskrete Sinustransformation |
| DVD | Digital Versatile Disc |
| FFT | Schnelle Fouriertransformation (engl.: Fast Fourier Transform) |
| FIR | Endliche Impulsantwort (engl.: Finite Impulse Response) |
| HBE | harmonische Bandbreitenerweiterung (engl.: Harmonic Bandwidth Extension) |
| HE-AAC | MPEG-4 Hoch-effizientes Advanced Audio Coding (engl.: MPEG-4 High Efficiency Advanced Audio Coding) |
| HF | Hochfrequenz |
| HSBE | Harmonische Spektralbanderweiterung (engl.: Harmonic Spectral Bandwidth Extension) |
| JPEG | Joint Photographic Experts Group |
| KiB | Kibibyte $2^{10}$ Byte = 1024 Byte |
| LOT | Überlappende Orthogonale Transformation (engl.: Lapped Orthogonal Transform) |
| LPC | Lineare prädiktive Codierung (engl.: Linear Predictive Coding) |
| LTI | linear Zeit-invariant (engl.: linear time-invariant) |
| MDCT | modifizierte diskrete Cosinustransformation |
| MDST | modifizierte diskrete Sinustransformation |
| MiB | Mebibyte = $2^{20}$ Byte = 1048576 Byte |
| mp3 | MPEG-1 Audio Layer III |
| PC | Personal Computer |
| PCM | Pulse Code Modulation |

PR          perfekte Rekonstruktion
QMF         Quadratur-Spiegel-Filter (engl.: Quadrature Mirror Filter)
SBR         Spektralbandreplikation (engl.: Spectral Band Replication)
SNR         Signal-Rausch-Verhältnis (engl.: Signal-To-Noise Ratio)
TDA         Zeitdomänen-Verzerrung (engl.: Time Domain Aliasing)
TDAC        Zeitdomänen-Aliasing-Kompensierung (engl.: Time Domain Aliasing Cancelation)
USAC        Unified Speech and Audio Coding
VoIP        Voice over Internet Protocol

**Bedeutung der verwendeten Symbole:**

e       Eulersche Zahl

j       imaginäre Einheit

Im      Imaginärteil einer Funktion

ld      Logarithmus zur Basis Zwei

log     Logarithmus zur Basis Zehn

*       konjugiert komplex

Re      Realteil einer Funktion

$\mathcal{O}$   Landau-Symbol zur Komplexitätsabschätzung

T       transponiert

$\lceil \cdot \rfloor$   Rundungsoperator

$\lfloor \cdot \rfloor$   Rundungsoperator für Abrunden

$\mathbb{R}$   Menge der reellen Zahlen

$\mathbb{N}$   Menge der nicht-negativen ganzen Zahlen

$\mathbb{N}^+$ $\mathbb{Z}$   Menge der positiven ganzen Zahlen
          Menge der ganzen Zahlen

$\epsilon$   Normierungsfaktor, $\mathbf{\underset{\sim}{H}}_0$

$\sigma$   Streckungsfaktor, Fensterindex, $\mathbf{\underset{\sim}{H}}_1$

$\tau$   Modulationsindex, $\mathbf{\underset{\sim}{H}}_2$

$\varphi$   Phasenwinkel, $\mathbf{\underset{\sim}{H}}'_0$

$\omega$   normierte Frequenz, $\mathbf{\underset{\sim}{F}}_a$

b       Blockindex, $\mathbf{\underset{\sim}{F}}_s$

B       Bandbreite, $\mathbf{\underset{\sim}{F}}$

f       Frequenz, $\mathbf{\underset{\sim}{D}}^{-1}$

k       diskreter Frequenzindex, $\mathbf{\underset{\sim}{F}}'$

m       diskreter Phasenindex, $\mathcal{O}$

M       Phasenanzahl, $\mathbb{R}$

n       diskreter Zeitindex, $\mathbb{N}$

N       Transformationslänge, $\mathbb{N}^+$

t       Zeit, $\mathbb{Z}$

W       komplexer Drehzeiger

h[n]    Impulsantwort eines FIR-Filters

H[z]    Übertragungsfunktion von *h[n]* im z-Bereich

$p_m[n]$   m-te Phase eines diskreten Signals

w[n]    Fensterfunktion im diskreten Zeitbereich

x[n]    reelles Signal im diskreten Zeitbereich

x(t)    reelles Signal im kontinuierlichen Zeitbereich

$X(f)$      Signals im kontinuierlichen Frequenzbereich

$X[k]$      Signals im diskreten Frequenzbereich

$\underline{h}$      Impulsantwort $h[n]$ in Vektorschreibweise

$\underline{H}$      $H[z]$ in Vektorschreibweise

$\underline{x}$      Signal $x[n]$ in Vektorschreibweise

$\underset{\sim}{D}$ $\underset{\sim}{F}$      Delaymatrix

Fenstermatrix in Diamantform

$\underset{\sim}{F}_{a,s}$      Foldingmatrix

$\underset{\sim}{H}$      Polyphasen-Transformationsmatrix

$\underset{\sim}{P}_{a,s}$      Polyphasenmatrix

$\underset{\sim}{T}$      Transformationsmatrix

$\underset{\sim}{\underline{x}}$ $\underset{\sim}{X}$      Blockmatrix des Signalvektors $\underline{x}$

transformiertes Signal

Literatur:

[Ahmed u. a. 1974] Ahmed, N. ; Natarajan, T. ; Rao, K.R.: Discrete Cosine Transform. In: Computers, IEEE Transactions on C-23 (1974), Januar, Nr. 1

[Bosi und Goldberg 2003] Bosi, M. ; Goldberg, R. E.: Introduction to Digital Audio Coding and Standards. 2. Auflage. Boston; Dordrecht; London : Kluwer Academic Publishers, 2003

[Britanak u. a. 2007] Britanak, V. ; Yip, P. C. ; Rao, K. R.: Discrete Cosine and Sine Transforms: General Properties, Fast Algorithms and Integer Approximations. Amsterdam; u.a. : Elsevier, 2007

[Burrus und Parks 1985] Burrus, C. S. ; Parks, T.: DFT/FFT and Convolution Algorithms: Theory and Implementation. New York : John Wiley & Sons Ltd., 1985

[Cheng 2004] Cheng, C.: Method for Estimating Magnitude and Phase in the MDCT Domain. In: Audio Engineering Society Convention 116, Mai 2004

[Dolson 1986] Dolson, M: The Phase Vocoder: A Tutorial. In: Computer Music Journal 10 (1986), Nr. 4

[Ekstrand 2002] Ekstrand, P.: Bandwidth Extension of Audio Signals by Spectral Band Replication. In: Proceedings of 1st IEEE Benelux Workshop on MPCA, Leuven, Belgium. Bd. 1, November 2002

[Fastl und Zwicker 2007] Fastl, H. ; Zwicker, E.: Psychoacoustics: Facts and Models. 3. Auflage. Berlin; Heidelberg; New York : Springer, 2007

[Jordan-Engeln und Reutter 1978] Jordan-Engeln, G. ; Reutter, F.: Numerische Mathematik für Ingenieure. 2. überarb. Auflage. Mannheim : Bibliographisches Institut, 1978

[Kiencke und Jäkel 2005] Kiencke, U. ; Jäkel, H.: Signale und Systeme. 3. überarb. Auflage. München; Wien : Oldenburg Verlag, 2005

[Larsen und Aarts 2004] Larsen, E. ; Aarts, R. M.: Audio Bandwidth Extension: Application of Psychoacoustics, Signal Processing and Loudspeaker Design. Chichester : John Wiley & Sons Ltd., 2004

[Lochmann 1990] Lochmann, D.: Digitale Nachrichtentechnik: Digitale Modulation und Signalverarbeitung. Bd. 1. Berlin : VBE Verlag Technik, 1990

[Malvar 1992] Malvar, H. S.: Signal Processing with Lapped Transforms. Boston; London: Artech House, 1992

[Malvar und Staelin 1989] Malvar, H. S. ; Staelin, D. H.: The LOT: transform coding without blocking effects. In: Acoustics, Speech and Signal Processing, IEEE Transactions on 37 (1989), April, Nr. 4

[Nagel und Disch 2009] Nagel, F. ; Disch, S.: A harmonic bandwidth extension method for audio codecs. In: Acoustics, Speech and Signal Processing, 2009. ICASSP 2009. IEEE International Conference on, April 2009

[Nagel u. a. 2010] Nagel, F. ; Disch, S. ; Wilde, S.: A continuous modulated single sideband bandwidth extension. In: Acoustics Speech and Signal Processing (ICASSP), 2010 IEEE International Conference on, März 2010

[Princen und Bradley 1986] Princen, J. ; Bradley, A.: Analysis/Synthesis filter bank design based on time domain aliasing cancellation. In: Acoustics, Speech and Signal Processing, IEEE Transactions on 34 (1986), oct, Nr. 5

[Princen u. a. 1987] Princen, J. ; Johnson, A. ; Bradley, A.: Subband/Transform coding using filter bank designs based on time domain aliasing cancellation. In: Acoustics, Speech, and Signal Processing, IEEE International Conference on ICASSP '87. Bd. 12, April 1987

[Rao und Yip 2001] Rao, K. R. ; Yip, P. C.: The Transform and Data Compression Handbook. London; New York; Washington, D.C. : CRC Press, 2001

[Schuller und Smith 1996] Schuller, G. D. T. ; Smith, M. J. T.: New framework for modulated perfect reconstruction filter banks. In: Signal Processing, IEEE Transactions on 44 (1996), August, Nr. 8

[Weinzierl 2008] Weinzierl, S.: Handbuch der Audiotechnik Berlin; Heidelberg: Springer, 2008

[Wilde 2009] Wilde, Stephan: Entwicklung von Zeitbereichsverfahren zur Bandbreitenerweiterung von Audiosignalen, Friedrich-Alexander-Universität Erlangen-Nürnberg, Diplomarbeit, 2009

[Yost 1994] Yost,W. A.: Fundamentals of Hearing: An Introduction. 3. Auflage. San Diego; New York; Boston; London; Sydney; Tokyo : Academic Press, 1994

[Zölzer 2005] Zölzer, U.: Digitale Audiosignalverarbeitung. 3. überarb. und erw. Auflage. Stuttgart; Leipzig; Wiesbaden : Teubner, 2005

**Patentansprüche**

1.  Eine Vorrichtung (100; 150; 300) zur Erzeugung eines frequenzverschobenen Audiosignals basierend auf einem Audioeingangssignal, wobei das Audioeingangssignal für eine Mehrzahl von ersten Subbändern durch einen oder mehrere erste Subband-Werte dargestellt ist, wobei die Vorrichtung (100; 150; 300) umfasst:

    eine Schnittstelle (110; 310) zum Empfang des Audioeingangssignals, und
    eine Frequenzverschiebungseinheit (120; 320) zur Erzeugung des frequenzverschobenen Audiosignals, wobei das frequenzverschobene Audiosignal für eine Mehrzahl von zweiten Subbändern jeweils einen oder mehrere zweite Subband-Werte aufweist,
    wobei jeder der ersten und der zweiten Subband-Werte Information über jeweils einen Phasenwinkel aufweist, und
    wobei die Frequenzverschiebungseinheit (120; 320) dafür eingerichtet ist, einen der zweiten Subband-Werte basierend auf einem der ersten Subband-Werte so zu erzeugen, dass der zweite Phasenwinkel dieses zweiten Subband-Werts sich von dem ersten Phasenwinkel dieses ersten Subband-Werts um eine Phasenwinkel-Differenz unterscheidet,
    wobei die Phasenwinkel-Differenz von einer Frequenzinformation abhängt, die angibt, um welche Frequenzdifferenz das Audioeingangssignal zu verschieben ist, um das frequenzverschobene Audiosignal zu erhalten, **dadurch gekennzeichnet, dass** die Phasenwinkel-Differenz von einer Frequenz-Bandbreite von einem der ersten Subbänder abhängt.

2.  Eine Vorrichtung (100; 150; 300) nach Anspruch 1, wobei die Frequenzverschiebungseinheit (120; 320) dafür eingerichtet ist, basierend auf der Frequenzinformation für jedes der zweiten Subbänder eines der ersten Subbänder zu bestimmen, wobei die Frequenzverschiebungseinheit (120; 320) ferner dafür eingerichtet ist, die ein oder mehreren der zweiten Subband-Werte des jeweiligen zweiten Subbands basierend auf einem oder mehreren der ersten Subband-Werte des jeweils bestimmten ersten Subbands zu erzeugen, wobei die Frequenzverschiebungseinheit (120; 320) dafür eingerichtet ist, jeweils einen der zweiten Subband-Werte des jeweiligen zweiten Subbands basierend auf jeweils einem der ersten Subband-Werte des jeweils bestimmten ersten Subbands so zu erzeugen, dass die Information über den Phasenwinkel des jeweiligen zweiten Subband-Werts von der Information über den Phasenwinkel des jeweiligen ersten Subband-Werts und von einem Verhältnis der Frequenzdifferenz, um die das Audioeingangssignal zu verschieben ist, zu der Frequenzbandbreite dieses Subbands, abhängt.

3. Eine Vorrichtung (100; 150; 300) nach Anspruch 1 oder 2,
wobei jeder der ersten Subband-Werte und jeder der zweiten Subband-Werte als komplexe Zahlen darstellbar sind,
wobei die Frequenzverschiebungseinheit (120; 320) dafür eingerichtet ist, einen Ergebniswert einer komplexen Exponentialfunktion zu bestimmen, und
wobei die Frequenzverschiebungseinheit (120; 320) dafür eingerichtet ist, wenigstens einen der zweiten Subband-Werte basierend auf einem der ersten Subband-Werte dadurch zu erzeugen, dass eine erste komplexe Zahl, die den einen der ersten Subband-Werte darstellt, mit dem Ergebniswert multipliziert wird, um eine zweite komplexe Zahl zu erhalten, die den einen der zweiten Subband-Werte darstellt.

4. Eine Vorrichtung (100; 150; 300) nach Anspruch 3,
wobei die Frequenzverschiebungseinheit (120; 320) dafür eingerichtet ist, den Ergebniswert der komplexen Exponentialfunktion zu bestimmen, wobei die komplexe Exponentialfunktion die Form:

$$e^{-j \cdot b \cdot \varphi \cdot \frac{\pi}{180°}}$$

aufweist,
wobei j eine imaginäre Einheit ist, wobei b ein ganzzahliger Wert ist, und wobei $\varphi$ ein Winkel in Grad ist, der von der Frequenzdifferenz abhängt, um die die ersten Subband-Werte der Subbänder zu verschieben sind.

5. Eine Vorrichtung (100; 150; 300) nach einem der vorherigen Ansprüche,
wobei die Frequenzverschiebungseinheit (120; 320) dafür eingerichtet ist, den einen der zweiten Subband-Werte basierend auf der einem der ersten Subband-Werte zu erzeugen, und
wobei die ersten Subband-Werte erste MDCT-Koeffizienten des Audioeingangssignals sind, die Koeffizienten einer Modifizierten Diskreten Kosinustransformation des Audioeingangssignals sind, oder wobei die ersten Subband-Werte erste QMF-Koeffizienten des Audioeingangssignals sind, die Koeffizienten einer QMF-Transformation des Audioeingangssignals sind.

6. Eine Vorrichtung (100; 150; 300) nach einem der vorherigen Ansprüche,
wobei die Vorrichtung (100; 150; 300) ferner eine MDCT-/MDST-Transformationseinheit (315) umfasst,
wobei die MDCT-/MDST-Transformationseinheit (315) dafür eingerichtet ist, einen oder mehrere erste MDCT-Koeffizienten des Audioeingangssignals zu erhalten, die Koeffizienten einer Modifizierten Diskreten Kosinustransformation des Audioeingangssignals sind,
wobei die MDCT-/MDST-Transformationseinheit (315) dafür eingerichtet ist, basierend auf einem oder mehreren der ersten MDCT-Koeffizienten des Audioeingangssignals einen oder mehrere erste MDST-Koeffizienten des Audioeingangssignals zu bestimmen, die Koeffizienten einer Modifizierten Diskreten Sinustransformation sind, und
wobei die Frequenzverschiebungseinheit (120; 320) dafür eingerichtet ist, jeden der zweiten Subband-Werte basierend auf jeweils einem der ersten Subband-Werte zu erzeugen, wobei jeder der ersten Subband-Werte auf einem der ersten MDCT-Koeffizienten und einem der ersten MDST-Koeffizienten, der basierend auf diesem ersten MDCT-Koeffizienten bestimmt wurde, basiert.

7. Eine Vorrichtung (100; 150; 300) nach Anspruch 6,
wobei die Frequenzverschiebungseinheit (120; 320) dafür eingerichtet ist, jeden der zweiten Subband-Werte basierend auf jeweils einem der ersten Subband-Werte zu erzeugen, wobei jeder der ersten MDCT-Koeffizienten und jeder der ersten MDST-Koeffizienten reellwertig ist, und wobei jeder der ersten Subband-Werte eine Summe einer der ersten MDCT-Koeffizienten und einer der mit der imaginären Einheit $j$ multiplizierten ersten MDST-Koeffizienten, der basierend auf diesem ersten MDCT-Koeffizienten bestimmt wurde, darstellt.

8. Eine Vorrichtung (100; 150; 300) nach einem der Ansprüche 6 oder 7,

wobei die MDCT-/MDST-Transformationseinheit (315) dafür eingerichtet ist, basierend auf einem oder mehreren der ersten MDCT-Koeffizienten des Audioeingangssignals die einen oder mehreren ersten MDST-Koeffizienten des Audioeingangssignals zu bestimmen,

wobei die ersten MDCT-Koeffizienten des Audioeingangssignals als MatrixKoeffizienten einer MDCT-Koeffizientenmatrix $\underline{X}$, die eine oder mehrere Spalten umfasst, darstellbar sind,

wobei das Audioeingangssignal in Blöcke unterteilt ist,

wobei jeder der Spalten der MDCT-Koeffizientenmatrix $\underline{X}$ einen der Blöcke des Audioeingangssignals darstellt,

wobei jede der Spalten der MDCT-Koeffizientenmatrix $\underline{X}$ ein MDCT-Spektrum des jeweiligen Blocks des Audioeingangssignals bildet, und

wobei die MDCT-/MDST-Transformationseinheit (315) die Matrixkoeffizienten einer Transformationsmatrix $\underline{H}$ so zu bestimmen, dass durch Matrixmultiplikation der Transformationsmatrix $\underline{H}$ mit der MDCT-Koeffizientenmatrix $\underline{X}$ eine MDST-Koeffizientenmatrix $\underline{X}_{MDST}$ erhalten wird, deren Matrix-Koeffizienten die ersten MDST-Koeffizienten darstellen.

9. Eine Vorrichtung (100; 150; 300) nach einem der Ansprüche 6 oder 7,
wobei die MDCT-/MDST-Transformationseinheit (315) dafür eingerichtet ist, basierend auf einem oder mehreren der ersten MDCT-Koeffizienten des Audioeingangssignals die einen oder mehreren ersten MDST-Koeffizienten des Audioeingangssignals zu bestimmen,
wobei die ersten MDCT-Koeffizienten des Audioeingangssignals als MatrixKoeffizienten einer MDCT-Koeffizientenmatrix $\underline{X}$ die eine oder mehrere Spalten umfasst, darstellbar sind,

wobei das Audioeingangssignal in Blöcke unterteilt ist, wobei jeder der Spalten der MDCT-Koeffizientenmatrix $\underline{X}$ einen der Blöcke des Audioeingangssignals darstellt,
und wobei die MDCT-/MDST-Transformationseinheit (315) dafür eingerichtet ist, eine Formel

$$\underline{X}_{MDST}(b-1) = \underline{H}_0 \cdot \underline{X}(b) + \underline{H}_1 \cdot \underline{X}(b-1) + \underline{H}_2 \cdot \underline{X}(b-2)$$

anzuwenden, um die ersten MDST-Koeffizienten zu bestimmen,

wobei $\underline{X}(b)$ die b-te Spalte der Matrix $\underline{X}$ ist,

wobei $\underline{X}(b-1)$ die b-1 -te Spalte der Matrix $\underline{X}$ ist,

wobei $\underline{X}(b-2)$ die b-2 -te Spalte der Matrix $\underline{H}_0$ ist,

wobei $\underline{H}_0$ eine erste Teilmatrix ist,

wobei $\underline{H}_1$ eine zweite Teilmatrix ist,

wobei $\underline{H}_2$ eine dritte Teilmatrix ist, und
wobei $\underline{X}_{MDST}(b-1)$ ein MDST Spektrum des Blocks b-1 darstellt, das die ersten MDST-Koeffizenten umfasst.

10. Eine Vorrichtung (100; 150; 300) nach Anspruch 9,
wobei die MDCT-/MDST-Transformationseinheit (315) dafür eingerichtet ist, die Formel

$$\underline{X}_{MDST}(b-1) = \underline{H}_0 \cdot \underline{X}(b) + \underline{H}_1 \cdot \underline{X}(b-1) + \underline{H}_2 \cdot \underline{X}(b-2)$$

anzuwenden, um die ersten MDST-Koeffizienten zu bestimmen,

wobei zwei oder mehrere Matrixkoffizienten der ersten Teilmatrix $\underline{H}_0$ den Wert 0 haben, wobei zwei oder mehrere Matrixkoffizienten der zweiten Teilmatrix $\underline{H}_1$ den Wert 0 haben, und wobei zwei oder mehrere Matrixkoffizienten der dritten Teilmatrix $\underline{H}_2$ den Wert 0 haben.

11. Eine Vorrichtung (100; 150; 300) nach Anspruch 9 oder 10,
wobei die MDCT-/MDST-Transformationseinheit (315) dafür eingerichtet ist, die Formel

$$\underline{\mathbf{X}}_{MDST}(b-1) = \underline{\mathbf{H}}_0 \cdot \underline{\mathbf{X}}(b) + \underline{\mathbf{H}}_1 \cdot \underline{\mathbf{X}}(b-1) + \underline{\mathbf{H}}_2 \cdot \underline{\mathbf{X}}(b-2)$$

anzuwenden, um die ersten MDST-Koeffizienten zu bestimmen,

wobei die zweite Teilmatrix $\underline{\mathbf{H}}_1$ die folgende Form aufweist:

$$\underline{\mathbf{H}}_1 = \begin{bmatrix} 0,5 & -0,5 & 0 & & \ldots & & 0 \\ 0,5 & 0 & -0,5 & 0 & & & \\ 0 & 0,5 & 0 & -0,5 & 0 & & \vdots \\ & \ddots & \ddots & \ddots & \ddots & \ddots & \\ \vdots & & 0 & 0,5 & 0 & -0,5 & 0 \\ & & & 0 & 0,5 & 0 & -0,5 \\ 0 & & \ldots & & 0 & 0,5 & 0,5 \end{bmatrix},$$

wobei " ... " bedeutet, dass dieselben Werte vorausgehender Matrixkoeffizienten der zweiten Teilmatrix $\underline{\mathbf{H}}_1$ in nachfolgenden Matrixkoeffizienten der zweiten Teilmatrix $\underline{\mathbf{H}}_1$ fortgesetzt werden.

12. Eine Vorrichtung (100; 150; 300) nach einem der vorherigen Ansprüche, wobei die Vorrichtung (100; 150; 300) ferner eine Filtereinheit (330) aufweist, wobei die Filtereinheit (330) dafür ausgelegt ist, die zweiten Subband-Werte durch Anwendung eines Filters, der eine Mehrzahl von Filterkoeffizienten aufweist, derart zu filtern, dass Störkomponenten der zweiten Subband-Werte, die bei der Erzeugung der zweiten Subband-Werte basierend auf den ersten Subband-Werten entstanden sind, verringert werden.

13. Eine Vorrichtung (100; 150; 300) nach Anspruch 12,
wobei die Frequenzverschiebungseinheit (120; 320) dafür eingerichtet ist, den einen der zweiten Subband-Werte basierend auf dem einem der ersten Subband-Werte so zu erzeugen, dass der zweite Phasenwinkel dieses zweiten Subband-Werts sich von dem ersten Phasenwinkel dieses ersten Subband-Werts um die Phasenwinkel-Differenz unterscheidet,
wobei die Filtereinheit (330) dafür ausgelegt ist, die zweiten Subband-Werte durch Anwendung des Filters zu filtern, und wobei ein oder mehrere der Filterkoeffizienten von der Phasenwinkel-Differenz abhängen.

14. Eine Vorrichtung (100; 150; 300) nach Anspruch 13,
wobei die Vorrichtung (100; 150; 300) ferner einen Speicher oder eine Datenbank aufweist,
wobei ein oder mehrere der Filterkoeffizienten von der Phasenwinkel-Differenz abhängen,
wobei die Filtereinheit (330) dafür eingerichtet ist, die Filterkoeffizienten in Abhängigkeit von der Phasenwinkel-Differenz aus dem Speicher oder der Datenbank auszulesen, und
wobei die Filtereinheit (330) dafür ausgelegt ist, die zweiten Subband-Werte durch Anwendung des Filters, der die aus dem Speicher oder der Datenbank ausgelesenen Filterkoeffizienten aufweist, zu filtern.

15. Eine Vorrichtung (100; 150; 300) nach einem der Ansprüche 12 bis 14,
wobei die Filtereinheit (330) dafür eingerichtet ist, jeden der ein oder mehreren zweiten Subband-Werte jedes der zweiten Subbänder zu filtern, um ein oder mehrere gefilterte Subband-Werte für jedes der zweiten Subbänder zu erhalten,
wobei die Filtereinheit (330) dafür ausgelegt ist, jeden der gefilterten Subband-Werte dadurch zu bestimmen, dass eine Summe aus einem ersten Summanden und ein oder mehreren weiteren Summanden gebildet wird,
wobei der erste Summand einer der zweiten Subband-Werte eines der zweiten Subbänder ist,
wobei die ein oder mehreren weiteren Summanden ein oder mehrere gewichtete Subband-Werte sind, und
wobei die Filtereinheit (330) dafür eingerichtet ist, die ein oder mehreren gewichteten Subband-Werte jeweils durch Multiplikation eines der Filterkoeffizienten mit jeweils einem weiteren Subband-Wert eines anderen der weiteren Subbänder zu bestimmen.

**16.** Eine Vorrichtung (100; 150; 300) nach einem der vorherigen Ansprüche 12 bis 15,
wobei die Filtereinheit (330) dafür ausgelegt ist, die zweiten Subband-Werte durch Anwendung des Filters, der die Mehrzahl von Filterkoeffizienten aufweist, derart zu filtern, dass Störkomponenten der zweiten Subband-Werte verringert werden,
wobei die Filterkoeffizienten des Filters eine geordnete Reihenfolge aufweisen, und wobei in dieser Reihenfolge auf jeden Filterkoeffizienten, der ungleich 0 ist, ein Filterkoeffizient folgt, der gleich 0 ist.

**17.** Eine Vorrichtung (100; 150; 300) nach einem der vorherigen Ansprüche, wobei die Schnittstelle (110; 310) dafür eingerichtet ist, die Frequenzinformation zu empfangen, die angibt, um welche Frequenzdifferenz die ersten Subband-Werte der Sub-bänder des Audioeingangssignals zu verschieben sind.

**18.** Eine Vorrichtung (100; 150; 300) nach einem der vorherigen Ansprüche,
wobei die Vorrichtung (100; 150; 300) ferner eine Synthese-Transformationseinheit (340) umfasst, und
wobei die Synthese-Transformationseinheit dafür eingerichtet ist, durch Transformation der zweiten Subband-Werte in eine Mehrzahl von Zeitdomänen-Abtastwerten das frequenzverschobene Audiosignal zu erhalten.

**19.** Eine Vorrichtung (150) nach einem der vorherigen Ansprüche,
wobei die Vorrichtung (150) dafür eingerichtet ist, ein frequenzverbreitertes Audiosignal zu erzeugen,
wobei die Vorrichtung (150) dafür eingerichtet ist, das frequenzverbreiterte Audiosignal dadurch zu erzeugen, dass die Vorrichtung (150) die zweiten Subband-Werte des frequenzverschobenen Audiosignals erzeugt, wobei das frequenzverbreiterte Audiosignal die ersten Subband-Werte des Audioeingangssignals und die zweiten Subband-Werte des frequenzverschobenen Audiosignals umfasst.

**20.** Eine Vorrichtung (150) nach Anspruch 19,
wobei die Vorrichtung (150) ferner eine Synthese-Transformationseinheit umfasst (340), und
wobei die Synthese-Transformationseinheit dafür eingerichtet ist, durch Transformation der ersten Subband-Werte und der zweiten Subband-Werte in eine Mehrzahl von Zeitdomänen-Abtastwerten das frequenzverbreiterte Audiosignal zu erhalten.

**21.** Eine Vorrichtung (150) nach einem der vorherigen Anspruch 19 oder 20, wobei die Vorrichtung (150) ferner eine Hüllkurven-Anpassungseinheit (350) umfasst, die dafür eingerichtet ist, das frequenzverbreiterte Audiosignal so zu filtern, dass dem frequenzverbreiterten Signal eine spektrale Einhüllende aufgeprägt wird.

**22.** Eine Vorrichtung (150) nach Anspruch 21, wobei die Hüllkurven-Anpassungseinheit (350) dafür eingerichtet ist, das frequenzverbreiterte Audiosignal durch inverse Filterung mit LPC-Koeffizienten zu filtern, um dem frequenzverbreiterten Signal die spektrale Einhüllende aufzuprägen.

**23.** Ein Verfahren zur Erzeugung eines frequenzverschobenen Audiosignals basierend auf einem Audioeingangssignal, wobei das Audioeingangssignal für eine Mehrzahl von ersten Subbändern durch einen oder mehrere erste Subband-Werte dargestellt ist, wobei das Verfahren umfasst:

Empfangen des Audioeingangssignals, und
Erzeugen des frequenzverschobenen Audiosignals, wobei das frequenzverschobene Audiosignal für eine Mehrzahl von zweiten Subbändern jeweils einen oder mehrere zweite Subband-Werte aufweist,
wobei jeder der ersten und der zweiten Subband-Werte Information über jeweils einen Phasenwinkel aufweist, und
wobei einer der zweiten Subband-Werte basierend auf einem der ersten Subband-Werte so erzeugt wird, dass der zweite Phasenwinkel dieses zweiten Subband-Werts sich von dem ersten Phasenwinkel dieses ersten Subband-Werts um eine Phasenwinkel-Differenz unterscheidet,
wobei die Phasenwinkel-Differenz von einer Frequenzinformation abhängt, die angibt, um welche Frequenzdifferenz das Audioeingangssignal zu verschieben ist, um das frequenzverschobene Audiosignal zu erhalten, **dadurch gekennzeichnet, dass** die Phasenwinkel-Differenz von einer Frequenz-Bandbreite von einem der ersten Subbänder abhängt.

**24.** Computerprogramm, das eingerichtet ist, das Verfahren nach Anspruch 23 durchzuführen, wenn das Computerprogramm auf einem Computer oder Signalprozessor ausgeführt wird.

**Claims**

1. A device (100; 150; 300) for producing a frequency-shifted audio signal based on an audio input signal, wherein the audio input signal, for a plurality of first subbands, is represented by one or several first subband values, the device (100; 150; 300) comprising:

an interface (110; 310) for receiving the audio input signal, and
a frequency-shifting unit (120; 320) for producing the frequency-shifted audio signal, the frequency-shifted audio signal, for a plurality of second subbands, comprising one or several second subband values each,
wherein each of the first and second subband values comprises information on a respective phase angle, and
wherein the frequency-shifting unit (120; 320) is configured to produce one of the second subband values based on one of the first subband values such that the second phase angle of this second subband value differs from the first phase angle of this first subband value by a phase angle difference, the phase angle difference being dependent on frequency information indicating by which frequency difference the audio input signal is to be shifted in order to obtain the frequency-shifted audio signal, **characterized in that** the phase angle difference is dependent on a frequency bandwidth of one of the first subbands.

2. A device (100; 150; 300) in accordance with claim 1, wherein the frequency-shifting unit (120; 320) is configured to determine one of the first subbands based on the frequency information for each of the second subbands, the frequency-shifting unit (120; 320) being further configured to produce the one or several of the second subband values of the respective second subband based on one or several of the first subband values of the respective first subband determined, the frequency-shifting unit (120; 320) being configured to produce one of the second subband values each of the respective second subband based on one of the first subbands each of the respective first subband determined such that the information on the phase angle of the respective second subband value is dependent on the information on the phase angle of the respective first subband value and on a ratio of the frequency difference by which the audio input signal is to be shifted and the frequency bandwidth of this subband.

3. A device (100; 150; 300) in accordance with claims 1 or 2,
wherein each of the first subband values and each of the second subband values may be represented as complex numbers,
wherein the frequency-shifting unit (120, 320) is configured to determine a result value of a complex exponential function, and
wherein the frequency-shifting unit (120; 320) is configured to produce at least one of the second subband values based on one of the first subband values by multiplying a first complex number representing the one of the first subband values by the result value in order to obtain a second complex number representing the one of the second subband values.

4. A device (100; 150; 300) in accordance with claim 3,
wherein the frequency-shifting unit (120; 320) is configured to determine the result value of the complex exponential function, the complex exponential function being as follows:

$$e^{-j \cdot b \cdot \varphi \cdot \frac{\pi}{180°}},$$

j being an imaginary unit, b being an integer, and φ being an angle in degrees, which is dependent on the frequency difference by which the first subband values of the subbands are to be shifted.

5. A device (100; 150; 300) in accordance with any of the preceding claims,
wherein the frequency-shifting unit (120; 320) is configured to produce the one of the second subband values based on the one of the first subband values, and
wherein the first subband values are first MDCT coefficients of the audio input signal which are the coefficients of a modified discrete cosine transform of the audio input signal, or wherein the first subband values are first QMF coefficients of the audio input signal which are coefficients of a QMF transform of the audio input signal.

6. A device (100; 150; 300) in accordance with any of the preceding claims,
wherein the device (100; 150; 300) additionally comprises an MDCT/MDST transform unit (315),
wherein the MDCT/MDST transform unit (315) is configured to obtain one or several first MDCT coefficients of the audio input signal which are coefficients of a modified discrete cosine transform of the audio input signal,
wherein the MDCT/MDST transform unit (315) is configured to determine, based on one or several of the first MDCT coefficients of the audio input signal, one or several first MDST coefficients of the audio input signal which are coefficients of a modified discrete sine transform, and
wherein the frequency-shifting unit (120; 320) is configured to produce each of the second subband values based on one of the first subband values each, wherein each of the first subband values is based on one of the first MDCT coefficients and one of the first MDST coefficients having been determined based on this first MDCT coefficient.

7. A device (100; 150; 300) in accordance with claim 6,
wherein the frequency-shifting unit (120; 320) is configured to produce each of the second subband values based on one of the first subband values each, wherein each of the first MDCT coefficients and each of the first MDST coefficients is of a real value, and wherein each of the first subband values represents a sum of one of the first MDCT coefficients and one of the first MDST coefficients multiplied by the imaginary unit $j$ having been determined based on this first MDCT coefficient.

8. A device (100; 150; 300) in accordance with any of claims 6 or 7,
wherein the MDCT/MDST transform unit (315) is configured to determine the one or several first MDST coefficients of the audio input signal based on one or several of the first MDCT coefficients of the audio input signal,
wherein the first MDCT coefficients of the audio input signal may be represented as matrix coefficients of an MDCT coefficient matrix $\underline{\underline{X}}$ which comprises one or several columns,
wherein the audio input signal is subdivided into blocks,
wherein each of the columns of the MDCT coefficient matrix $\underline{\underline{X}}$ represents one of the blocks of the audio input signal,
wherein each of the columns of the MDCT coefficient matrix $\underline{\underline{X}}$ forms an MDCT spectrum of the respective block of the audio input signal, and
wherein the MDCT/MDST transform unit (315) determines the matrix coefficients of a transform matrix H such that, by a matrix multiplication of the transform matrix $\underline{\underline{H}}$ by the MDCT coefficient matrix $\underline{\underline{X}}$, an MDST coefficient matrix $\underline{\underline{X}}_{MDST}$ is obtained the matrix coefficients of which represent the first MDST coefficients.

9. A device (100; 150; 300) in accordance with any of claims 6 or 7,
wherein the MDCT/MDST transform unit (315) is configured to determine the one or several first MDST coefficients of the audio input signal based on one or several of the first MDCT coefficients of the audio input signal,
wherein the first MDCT coefficients of the audio input signal may be represented as matrix coefficients of an MDCT coefficient matrix $\underline{\underline{X}}$ which comprises one or several columns,
wherein the audio input signal is subdivided into blocks, wherein each of the columns of the MDCT coefficient matrix $\underline{\underline{X}}$ represents one of the blocks of the audio input signal,
and wherein the MDCT/MDST transform unit (315) is configured to apply the following formula:

$$\underline{\underline{X}}_{MDST}(b-1) = \underline{\underline{H}}_0 \cdot \underline{\underline{X}}(b) + \underline{\underline{H}}_1 \cdot \underline{\underline{X}}(b-1) + \underline{\underline{H}}_2 \cdot \underline{\underline{X}}(b-2)$$

in order to determine the first MDST coefficients,

wherein $\underline{X}(b)$ is the $b^{th}$ column of the matrix $\underline{\underline{X}}$

wherein $\underline{X}(b-1)$ is the $b-1^{th}$ column of the matrix $\underline{\underline{X}}$,

wherein $\underline{X}(b-2)$ is the $b-2^{th}$ column of the matrix $\underline{\underline{X}}$,

wherein $\underline{\underline{H}}_0$ is a first sub-matrix,

wherein $\underline{\underline{H}}_1$ is a second sub-matrix,

wherein $\underline{\underline{H}}_2$ is a third sub-matrix, and
wherein $\underline{X}_{MDST}^{(b-1)}$ represents an MDST spectrum of block b-1 which comprises the first MDST coefficients.

10. A device (100; 150; 300) in accordance with claim 9,
wherein the MDCT/MDST transform unit (315) is configured to apply the following formula:

$$\underline{X}_{MDST}(b-1) = \underline{H}_0 \cdot \underline{X}(b) + \underline{H}_1 \cdot \underline{X}(b-1) + \underline{H}_2 \cdot \underline{X}(b-2)$$

in order to determine the first MDST coefficients,

wherein two or several matrix coefficients of the first sub-matrix $\underline{H}_0$ comprise a value of 0, wherein two or several matrix coefficients of the second sub-matrix $\underline{H}_1$ comprise a value of 0, and wherein two or more matrix coefficients of the third sub-matrix $\underline{H}_2$ comprise a value of 0.

11. A device (100; 150; 300) in accordance with claims 9 or 10,
wherein the MDCT/MDST transform unit (315) is configured to apply the following formula:

$$\underline{X}_{MDST}(b-1) = \underline{H}_0 \cdot \underline{X}(b) + \underline{H}_1 \cdot \underline{X}(b-1) + \underline{H}_2 \cdot \underline{X}(b-2)$$

in order to determine the first MDST coefficients,
wherein the second sub-matrix $\underline{H}_1$ is as follows:

$$\underline{H}_1 = \begin{bmatrix} 0,5 & -0,5 & 0 & & \cdots & & 0 \\ 0,5 & 0 & -0,5 & 0 & & & \\ 0 & 0,5 & 0 & -0,5 & 0 & & \vdots \\ & \ddots & \ddots & \ddots & \ddots & \ddots & \\ \vdots & & 0 & 0,5 & 0 & -0,5 & 0 \\ & & & 0 & 0,5 & 0 & -0,5 \\ 0 & & \cdots & & 0 & 0,5 & 0,5 \end{bmatrix} ,$$

wherein "..." means that the same values of previous matrix coefficients of the second sub-matrix $\underline{H}_1$ are continued in subsequent matrix coefficients of the second sub-matrix $\underline{H}_1$.

12. A device (100; 150; 300) in accordance with any of the preceding claims, wherein the device (100; 150; 300) additionally comprises a filter unit (330), the filter unit (330) being configured to filter the second subband values by applying a filter which comprises a plurality of filter coefficients such that spurious components of the second subband values having formed when producing the second subband values based on the first subband values are reduced.

13. A device (100; 150; 300) in accordance with claim 12,
wherein the frequency-shifting unit (120; 320) is configured to produce the one of the second subband values based on the one of the first subband values such that the second phase angle of this second subband value differs from the first phase angle of this first subband value by the phase angle difference,
wherein the filter unit (330) is configured to filter the second subband values by applying the filter, and wherein one or several of the filter coefficients are dependent on the phase angle difference.

14. A device (100; 150; 300) in accordance with claim 13,
wherein the device (100; 150; 300) additionally comprises a storage or a database,
wherein one or several of the filter coefficients are dependent on the phase angle difference,
wherein the filter unit (330) is configured to read out the filter coefficients from the storage or the database in dependence on the phase angle difference, and wherein the filter unit (330) is configured to filter the second subband values by applying the filter which comprises the filter coefficients read out from the storage or the database.

15. A device (100; 150; 300) in accordance with any of claims 12 to 14,
wherein the filter unit (330) is configured to filter each of the one or several second subband values of each of the second subbands in order to obtain one or several filtered subband values for each of the second subbands,

wherein the filter unit (330) is configured to determine each of the filtered subband values by calculating a sum of a first addend or one or several further addends,

wherein the first addend is one of the second subband values of one of the second subbands,

wherein the one or several further addends is/are one or several weighted subband values, and

wherein the filter unit (330) is configured to determine the one or several weighted subband values each by multiplication of one of the filter coefficients by one further subband value each of another of the further subbands.

**16.** A device (100; 150; 300) in accordance with any of claims 12 to 15,

wherein the filter unit (330) is configured to filter the second subband values by applying the filter which comprises the plurality of filter coefficients such that spurious components of the second subband values are reduced,

wherein the filter coefficients of the filter are of an ordered sequence, and wherein, in this sequence, every filter coefficient unequal to zero is followed by a filter coefficient equaling zero.

**17.** A device (100; 150; 300) in accordance with any of the preceding claims, wherein the interface (110; 310) is configured to receive the frequency information indicating by which frequency difference the first subband values of the subbands of the audio input signal are to be shifted.

**18.** A device (100; 150; 300) in accordance with any of the preceding claims,

wherein the device (100; 150; 300) additionally comprises a synthesis transform unit (340), and

wherein the synthesis transform unit is configured to obtain the frequency-shifted audio signal by transforming the second subband values to a plurality of time domain samples.

**19.** A device (150) in accordance with any of the preceding claims,

wherein the device (150) is configured to produce a frequency-broadened audio signal,

wherein the device (150) is configured to produce the frequency-broadened audio signal by the device (150) producing the second subband values of the frequency-shifted audio signal, the frequency-broadened audio signal including the first subband values of the audio input signal and the second subband values of the frequency-shifted audio signal.

**20.** A device (150) in accordance with claim 19,

wherein the device (150) additionally comprises a synthesis transform unit (340), and

wherein the synthesis transform unit is configured to obtain the frequency-broadened audio signal by transforming the first subband values and the second subband values to a plurality of time domain samples.

**21.** A device (150) in accordance with any of the preceding claims 19 or 20, wherein the device (150) additionally comprises an envelope adaptation unit (350) configured to filter the frequency-broadened audio signal such that a spectral envelope is impressed onto the frequency-broadened signal.

**22.** A device (150) in accordance with claim 21, wherein the envelope adaptation unit (350) is configured to filter the frequency-broadened audio signal by means of inverse filtering using LPC coefficients in order to impress the spectrum envelope onto the frequency-broadened signal.

**23.** A method of producing a frequency shifted audio signal based on an audio input signal, wherein the audio input signal, for a plurality of first subbands, is represented by one or several first subband values, the method comprising:

receiving the audio input signal, and

producing the frequency-shifted audio signal, the frequency-shifted audio signal, for a plurality of second subbands, comprising one or several second subband values each,

wherein each of the first and second subband values comprises information on a respective phase angle, and

wherein one of the second subband values is produced based on one of the first subband values such that the second phase angle of this second subband value differs from the first phase angle of this first subband value by a phase angle difference, the phase angle difference being dependent on frequency information indicating by which frequency difference the audio input signal is to be shifted in order to obtain the frequency-shifted audio signal, **characterized in that** the phase angle difference is dependent on a frequency bandwidth of one of the first subbands.

**24.** A computer program configured to perform the method in accordance with claim 23 when the computer program is executed on a computer or signal processor.

**Revendications**

1. Dispositif (100; 150; 300) pour générer un signal audio décalé en fréquence sur base d'un signal audio d'entrée, le signal audio d'entrée étant représenté pour une pluralité de premières sous-bandes par une ou plusieurs premières valeurs de sous-bande, dans lequel le dispositif (100; 150; 300) comporte:

   une interface (110; 310) pour recevoir le signal audio d'entrée, et
   une unité de décalage de fréquence (120; 320) destinée à générer le signal audio décalé en fréquence, ledit signal audio décalé en fréquence présentant, pour chacune d'une pluralité de deuxièmes sous-bandes, une ou plusieurs deuxièmes valeurs de sous-bande,
   dans lequel chacune des premières et des deuxièmes valeurs de sous-bande présente une information sur chaque fois un angle de phase, et
   dans lequel l'unité de décalage de fréquence (120; 320) est conçue pour générer l'une des deuxièmes valeurs de sous-bande sur base d'une des premières valeurs de sous-bande de sorte que le deuxième angle de phase de cette deuxième valeur de sous-bande diffère du premier angle de phase de cette première valeur de sous-bande d'une différence d'angle de phase, la différence d'angle de phase dépendant d'une information de fréquence qui indique la différence de fréquence de laquelle doit être décalé le signal audio d'entrée pour obtenir le signal audio décalé en fréquence,
   **caractérisé par le fait que** la différence d'angle de phase dépend d'une largeur de bande de fréquences de l'une des premières sous-bandes.

2. Dispositif (100; 150; 300) selon la revendication 1, dans lequel l'unité de décalage de fréquence (120; 320) est conçue pour déterminer, sur base de l'information de fréquence, pour chacune des deuxièmes sous-bandes l'une des premières sous-bandes, dans lequel l'unité de décalage de fréquence (120; 320) est par ailleurs conçue pour générer les une ou plusieurs des deuxièmes valeurs de sous-bande de la deuxième sous-bande respective sur base d'une ou plusieurs des premières valeurs de sous-bande de la première sous-bande déterminée respective, dans lequel l'unité de décalage de fréquence (120; 320) est conçue pour générer chaque fois l'une des deuxièmes valeurs de sous-bande de la deuxième sous-bande respective sur base de chaque fois l'une des premières valeurs de sous-bande de la première sous-bande déterminée respective de sorte que l'information sur l'angle de phase de la deuxième valeur de sous-bande respective dépende de l'information sur l'angle de phase de la première valeur de sous-bande respective et d'un rapport entre la différence de fréquence de laquelle doit être décalé le signal audio d'entrée et la largeur de bande de fréquences de cette sous-bande.

3. Dispositif (100; 150; 300) selon la revendication 1 ou 2,
   dans lequel chacune des premières valeurs de sous-bande et chacune des deuxièmes valeurs de sous-bande sont représentées comme nombres complexes,
   dans lequel l'unité de décalage de fréquence (120; 320) est conçue pour déterminer une valeur de résultat d'une fonction exponentielle complexe, et
   dans lequel l'unité de décalage de fréquence (120; 320) est conçue pour générer au moins l'une des deuxièmes valeurs de sous-bande sur base de l'une des premières valeurs de sous-bande en multipliant un premier nombre complexe représentant l'une des premières valeurs de sous-bande par la valeur de résultat, pour obtenir un deuxième nombre complexe représentant l'une des deuxièmes valeurs de sous-bande.

4. Dispositif (100; 150; 300) selon la revendication 3,
   dans lequel l'unité de décalage de fréquence (120; 320) est conçue pour déterminer la valeur de résultat de la fonction exponentielle complexe, la fonction exponentielle complexe présentant la forme:

$$e^{-j \cdot b \cdot \varphi \cdot \frac{\pi}{180°}}$$

   où j est une unité imaginaire, où b est une valeur de nombre entier, et où φ est un angle en degrés qui dépend de la différence de fréquence de laquelle doivent être déplacées les premières valeurs des sous-bandes.

5. Dispositif (100; 150; 300) selon l'une des revendications précédentes,
   dans lequel l'unité de décalage de fréquence (120; 320) est conçue pour générer l'une des deuxièmes valeurs de sous-bande sur base de l'une des premières valeurs de sous-bande, et

dans lequel les premières valeurs de sous-bande sont des premiers coefficients de MDCT du signal audio d'entrée qui sont des coefficients d'une transformation cosinusoïdale discrète modifiée du signal audio d'entrée, ou dans lequel les premières valeurs de sous-bande sont des premiers coefficients de QMF du signal audio d'entrée qui sont des coefficients d'une transformation QMF du signal audio d'entrée.

6. Dispositif (100; 150; 300) selon l'une des revendications précédentes,
dans lequel l'appareil (100; 150; 300) comporte par ailleurs une unité de transformation MDCT/MDST (315),
dans lequel l'unité de transformation MDCT/MDST (315) est conçue pour recevoir un ou plusieurs premiers coefficients de MDCT du signal audio d'entrée qui sont des coefficients d'une transformation cosinusoïdale discrète modifiée du signal audio d'entrée,
dans lequel l'unité de transformation MDCT/MDST (315) est conçue pour déterminer, sur base de l'un ou plusieurs des premiers coefficients de MDCT du signal audio d'entrée, un ou plusieurs premiers coefficients de MDST du signal audio d'entrée qui sont des coefficients d'une transformation sinusoïdale discrète modifiée, et
dans lequel l'unité de décalage de fréquence (120; 320) est conçue pour générer chacune des deuxièmes valeurs de sous-bande sur base de chaque fois l'une des premières valeurs de sous-bande, chacune des premières valeurs de sous-bande étant basée sur l'un des premiers coefficients de MDCT et l'un des premiers coefficients de MDST qui a été déterminé sur base de ce premier coefficient de MDCT.

7. Dispositif (100; 150; 300) selon la revendication 6,
dans lequel l'unité de décalage de fréquence (120; 320) est conçue pour générer chacune des deuxièmes valeurs de sous-bande sur base de chaque fois l'une des premières valeurs de sous-bande, chacun des premiers coefficients de MDCT et chacun des premiers coefficients de MDST étant de valeur réelle, et chacune des premières valeurs de sous-bande représentant une somme de l'un des premiers coefficients de MDCT et de l'un des premiers coefficients de MDST multipliés par l'unité imaginaire $j$ qui a été déterminée sur base de ce premier coefficient de MDCT.

8. Dispositif (100; 150; 300) selon l'une des revendications 6 ou 7,
dans lequel l'unité de transformation MDCT/MDST (315) est conçue pour déterminer, sur base de l'un ou plusieurs des premiers coefficients de MDST du signal audio d'entrée, les un ou plusieurs premiers coefficients de MDCT du signal audio d'entrée,
dans lequel les premiers coefficients de MDCT du signal audio d'entrée peuvent être représentés comme coefficients de matrice d'une matrice de coefficients MDCT $\underset{\sim}{\mathbf{X}}$ qui comprend une ou plusieurs colonnes,
dans lequel le signal audio d'entrée est subdivisé en blocs,
dans lequel chacune des colonnes de la matrice de coefficients de MDCT $\underset{\sim}{\mathbf{X}}$ représente l'un des blocs du signal audio d'entrée,
dans lequel chacune des colonnes de la matrice de coefficients de MDCT $\underset{\sim}{\mathbf{X}}$ constitue un spectre de MDCT du bloc respectif du signal audio d'entrée, et
dans lequel l'unité de transformation MDCT/MDST (315) est conçue pour déterminer les coefficients de matrice d'une matrice de transformation $\underset{\sim}{\mathbf{H}}$ de sorte que par multiplication matricielle de la matrice de transformation $\underset{\sim}{\mathbf{H}}$ par la matrice de coefficients de MDST $\underset{\sim}{\mathbf{X}}$ soit obtenue une matrice de coefficients de MDCT $\underset{\sim}{\mathbf{X}}_{MDST}$ dont les coefficients de matrice représentent les premiers coefficients de MDST.

9. Dispositif (100; 150; 300) selon l'une des revendications 6 ou 7,
dans lequel l'unité de transformation MDCT/MDST (315) est conçue pour déterminer, sur base de l'un ou plusieurs des premiers coefficients de MDST du signal audio d'entrée, les un ou plusieurs premiers coefficients de MDCT du signal audio d'entrée,
dans lequel les premiers coefficients de MDCT du signal audio d'entrée peuvent être représentés comme des coefficients de matrice d'une matrice de coefficients de MDCT $\underset{\sim}{\mathbf{X}}$ qui comprend une ou plusieurs colonnes,
dans lequel le signal audio d'entrée est subdivisé en blocs, chacune des colonnes de la matrice de coefficients de MDCT $\underset{\sim}{\mathbf{X}}$ représentant l'un des blocs du signal audio d'entrée,
et dans lequel l'unité de transformation MDCT/MDST (315) est conçue pour appliquer une formule

$$\underset{\sim}{X}_{MDST}(b-1) = \underset{\sim}{H}_0 \cdot \underset{\sim}{X}(b) + \underset{\sim}{H}_1 \cdot \underset{\sim}{X}(b-1) + \underset{\sim}{H}_2 \cdot \underset{\sim}{X}(b-2)$$

pour déterminer les premiers coefficients de MDST,

où $\underline{X}(b)$ est la b-ième colonne de la matrice $\underline{\underline{X}}$,

où $\underline{X}(b-1)$ est la b-1-ième colonne de la matrice $\underline{\underline{X}}$,

où $\underline{X}(b-2)$ est la b-2-ième colonne de la matrice $\underline{\underline{X}}$,

où $\underline{\underline{H}}_0$ est une première matrice partielle,

où $\underline{\underline{H}}_1$ est une deuxième matrice partielle,

où $\underline{\underline{H}}_2$ est une troisième matrice partielle, et

où $\underline{X}_{MDST}(b-1)$ représente un spectre de MDST du bloc b-1 qui comporte les premiers coefficients de MDST.

**10.** Dispositif (100; 150; 300) selon la revendication 9,
dans lequel l'unité de transformation MDCT/MDST (315) est conçue pour appliquer la formule

$$\underline{X}_{MDST}(b-1) = \underset{\sim_0}{H} \cdot \underline{X}(b) + \underset{\sim_1}{H} \cdot \underline{X}(b-1) + \underset{\sim_2}{H} \cdot \underline{X}(b-2)$$

pour déterminer les premiers coefficients de MDST,

dans lequel deux ou plusieurs coefficients de matrice de la première matrice partielle $\underline{\underline{H}}_0$ ont la valeur 0, dans lequel deux ou plusieurs coefficients de matrice de la deuxième matrice partielle $\underline{\underline{H}}_1$ ont la valeur O, et dans lequel deux ou plusieurs coefficients de matrice de la troisième matrice partielle $\underline{\underline{H}}_2$ ont la valeur 0.

**11.** Dispositif (100; 150; 300) selon la revendication 9 ou 10,
dans lequel l'unité de transformation MDCT/MDST (315) est conçue pour appliquer

$$\underline{X}_{MDST}(b-1) = \underset{\sim_0}{H} \cdot \underline{X}(b) + \underset{\sim_1}{H} \cdot \underline{X}(b-1) + \underset{\sim_2}{H} \cdot \underline{X}(b-2)$$

pour déterminer les premiers coefficients de MDST,

la deuxième matrice partielle $\underline{\underline{H}}_1$ présentant la forme suivante:

$$\underline{\underline{H}}_1 = \begin{bmatrix} 0,5 & -0,5 & 0 & & \cdots & & 0 \\ 0,5 & 0 & -0,5 & 0 & & & \\ 0 & 0,5 & 0 & -0,5 & 0 & & \vdots \\ & \ddots & \ddots & \ddots & \ddots & \ddots & \\ \vdots & & 0 & 0,5 & 0 & -0,5 & 0 \\ & & & 0 & 0,5 & 0 & -0,5 \\ 0 & & \cdots & & 0 & 0,5 & 0,5 \end{bmatrix}$$

où ,, ... " signifie que les mêmes valeurs de coefficients de matrice précédents de la deuxième matrice partielle $\underline{\underline{H}}_1$ sont continuées dans les coefficients de matrice successifs de la deuxième matrice partielle $\underline{\underline{H}}_1$.

**12.** Dispositif (100; 150; 300) selon l'une des revendications précédentes, dans lequel le dispositif (100; 150; 300) présente par ailleurs une unité de filtre (330), dans lequel l'unité de filtre (330) est conçue pour filtrer les deuxièmes valeurs de sous-bande en utilisant un filtre présentant une pluralité de coefficients de filtre de sorte que soient réduites les composantes parasites des deuxièmes valeurs de sous-bande qui se sont produites lors de la génération des deuxièmes valeurs de sous-bande sur base des premières valeurs de sous-bande.

13. Dispositif (100; 150; 300) selon la revendication 12,
dans lequel l'unité de décalage de fréquence (120; 320) est conçue pour générer l'une des deuxièmes valeurs de sous-bande sur base de l'une des premières valeurs de sous-bande de sorte que le deuxième angle de phase de cette deuxième valeur de sous-bande diffère du premier angle de phase de cette première valeur de sous-bande de la différence d'angle de phase,
dans lequel l'unité de filtre (330) est conçue pour filtrer les deuxièmes valeurs de sous-bande en appliquant le filtre, et dans lequel un ou plusieurs des coefficients de filtre dépendent de la différence d'angle de phase.

14. Dispositif (100; 150; 300) selon la revendication 13,
dans lequel le dispositif (100; 150; 300) présente par ailleurs une mémoire ou une base de données,
dans lequel un ou plusieurs des coefficients de filtre dépendent de la différence d'angle de phase,
dans lequel l'unité de filtre (330) est conçue pour lire les coefficients de filtre en fonction de la différence d'angle de phase de la mémoire ou de la base de données, et
dans lequel l'unité de filtre (330) est conçue pour filtrer les deuxièmes valeurs de sous-bande en appliquant le filtre qui présente les coefficients de filtre lus de la mémoire ou de la base de données.

15. Dispositif (100; 150; 300) selon l'une des revendications 12 à 14,
dans lequel l'unité de filtre (330) est conçue pour filtrer chacune des une ou plusieurs deuxièmes valeurs de sous-bande de chacune des deuxièmes sous-bandes, pour obtenir une ou plusieurs valeurs de sous-bande filtrées pour chacune des deuxièmes sous-bandes,
dans lequel l'unité de filtre (330) est conçue pour déterminer chacune des valeurs de sous-bande filtrées en formant une somme d'un premier terme de somme et d'un ou plusieurs autres termes de somme,
dans lequel le premier terme de somme de l'une des deuxièmes valeurs de sous-bande est l'une des deuxièmes sous-bandes,
dans lequel les un ou plusieurs autres termes de somme sont une ou plusieurs valeurs de sous-bande pondérées, et dans lequel l'unité de filtre (330) est conçue pour déterminer les une ou plusieurs valeurs de sous-bande pondérées en multipliant chaque fois l'un des coefficients de filtre par chaque fois une autre valeur de sous-bande d'une autre des autres sous-bandes.

16. Dispositif (100; 150; 300) selon l'une des revendications précédentes 12 à 15,
dans lequel l'unité de filtre (330) est conçue pour filtrer les deuxièmes valeurs de sous-bande en appliquant le filtre présentant la pluralité de coefficients de filtre de sorte que soient réduites les composantes parasites des deuxièmes valeurs de sous-bande,
dans lequel les coefficients de filtre du filtre présentent une séquence ordonnée, et dans lequel, dans cet ordre chaque coefficient de filtre qui est différent de 0 est suivi d'un coefficient de filtre qui est égal à 0.

17. Dispositif (100; 150; 300) selon l'une des revendications précédentes, dans lequel l'interface (110; 310) est conçue pour recevoir l'information de fréquence indiquant la différence de fréquence de laquelle doivent être décalées les premières valeurs des sous-bandes du signal audio d'entrée.

18. Dispositif (100; 150; 300) selon l'une des revendications précédentes,
dans lequel le dispositif (100; 150; 300) comprend par ailleurs une unité de transformée de synthèse (340), et
dans lequel l'unité de transformée de synthèse est conçue pour recevoir, par transformation des deuxièmes valeurs de sous-bande en une pluralité de valeurs de balayage dans le domaine temporel, le signal audio décalé en fréquence.

19. Dispositif (150) selon l'une des revendications précédentes,
dans lequel le dispositif (150) est conçu pour générer un signal audio élargi en fréquence,
dans lequel le dispositif (150) est conçu pour générer le signal audio élargi en fréquence en ce que le dispositif (150) génère les deuxièmes valeurs de sous-bande du signal audio décalé en fréquence, le signal audio élargi en fréquence comportant les premières valeurs de sous-bande du signal audio d'entrée et les deuxièmes valeurs de sous-bande du signal audio décalé en fréquence.

20. Dispositif (150) selon la revendication 19,

dans lequel le dispositif (150) comporte par ailleurs une unité de transformation de synthèse (340), et dans lequel l'unité de transformation de synthèse est conçue pour recevoir, par transformation des premières valeurs de sous-bande et des deuxièmes valeurs de sous-bande en une pluralité de valeurs de balayage dans le domaine temporel, le signal audio élargi en fréquence.

21. Dispositif (150) selon l'une des revendications précédentes 19 ou 20, dans lequel le dispositif (150) comporte par ailleurs une unité d'adaptation d'enveloppe (350) qui est conçue pour filtrer le signal audio élargi en fréquence de sorte que soit imprimée une enveloppe spectrale au signal élargi en fréquence.

22. Dispositif (150) selon la revendication 21, dans lequel l'unité d'adaptation d'enveloppe (350) est conçue pour filtrer le signal audio élargi en fréquence par filtration inverse par des coefficients de LPC, pour imprimer l'enveloppe spectrale au signal élargi en fréquence.

23. Procédé de génération d'un signal audio décalé en fréquence sur base d'un signal audio d'entrée, le signal audio d'entrée étant représenté pour une pluralité de premières sous-bandes par une ou plusieurs premières valeurs de sous-bande, le procédé comprenant le fait de:

recevoir le signal audio d'entrée, et
générer le signal audio décalé en fréquence, le signal audio décalé en fréquence présentant pour une pluralité de deuxièmes sous-bandes chaque fois une ou plusieurs deuxièmes valeurs de sous-bande,
dans lequel chacune des premières et des deuxièmes valeurs de sous-bande présente une information sur chaque fois un angle de phase, et
dans lequel l'une des deuxièmes valeurs de sous-bande est générée sur base de l'une des premières valeurs de sous-bande de sorte que le deuxième angle de phase de cette deuxième valeur de sous-bande diffère du premier angle de phase de cette première valeur de sous-bande d'une différence d'angle de phase,
dans lequel la différence d'angle de phase dépend d'une information de fréquence qui indique la différence de fréquence de laquelle doit être décalé le signal audio d'entrée pour obtenir le signal audio décalé en fréquence, **caractérisé par le fait que** la différence d'angle de phase dépend d'une largeur de bande de fréquences de l'une des premières sous-bandes.

24. Programme d'ordinateur qui est conçu pour réaliser le procédé selon la revendication 23 lorsque le programme d'ordinateur est exécuté sur un ordinateur ou processeur de signal.

Vorrichtung zur Erzeugung eines frequenzverschobenen Audiosignals

100

110 Schnitt-stelle

120 Frequenz-verschiebungs-einheit

Audioeinganssignal

erste Subband-Werte

frequenz-verschobenes Audiosignal (mit zweiten Subband-Werten)

FIG 1A

Audioeinganssignal → [ **Schnitt-stelle** 110 ] → erste Subband-Werte → [ **Frequenz-verschiebungs-einheit** 120 ] → frequenz-verbreitertes Audiosignal (mit ersten und zweiten Subband-Werten)

150

**FIG 1B**

FIG 2

FIG 3

Schnitt-stelle 310

300

HSBE-Decoder

MDCT-/MDST-Spektrum 315

MDCST-Synthese-filterbank 340

Hüllkurven-anpassung* 350

PCM-Ausgang

HF-Generator 320

Anti-Aliasing-Filterung 330

Berechnung von $\tau$ und $\varphi$ 318

$\tau, \varphi$

$\varphi$

$\varphi$

$f_{lag}$

$h_{LRC}*$

Bitstrom

Core-Decoder

Audioinformation

Kontrollparameter

optionale Komponenten*

EP 2 867 894 B1

$$H_0$$

exakt berechnete Transformationsmatrix $H_0$

# FIG 4A

$H_0{}'$

vereinfachte Transformationsmatrix $H_0$

FIG 4B

FIG 5

FIG 6

EP 2 867 894 B1

FIG 7

FIG 8

FIG 9

FIG 10

EP 2 867 894 B1

FIG 11

Zeitdomänen Signal

iMDCT/iMDST

FIG 12

komplexe MDCT-/MDST-Koeffizientden

FIG 13

EP 2 867 894 B1

Komplexität - HSBE (local_HSBEpatching())

FIG 14

EP 2 867 894 B1

Komplexität - MDCT/MDST (fmdcst1d())

FIG 15

Komplexität – MDCT/MDST-Transformation

FIG 16

FIG 17

HSBE Bandbreitenerweiterung - Patchverhältnis 2,5:1

FIG 18

FIG 19

FIG 20

○ Addition
▲ Multiplikation mit $S_n$
▷ Multiplikation mit $C_n$

**FIG 21**

FIG 22

PCM-Eingang

Analysefilterbank

Quantisierung
&
Entropiecodierung

Bitstrommultiplexer

Bitstrom

Audioinformation

Kontrollparameter

Psychoakustisches
Modell

FIG 23

FIG 24

FIG 25

FIG 26

EP 2 867 894 B1

tieffrequente BWE          hochfrequente BWE

psychoakustische BWE          II  |  IV

physikalische BWE          I  |  III

FIG 27

FIG 28

EP 2 867 894 B1

SBR-Decoder

QMF-Analyse
filterbank
(32 Bänder)

QMF-Synthese-
filterbank
(64 Bänder)

PCM-Ausgang

Bitstrom

Core-Decoder

HF-Generator

Hüllkurvenanpassung

Tonalitätsanpassung

Audioinformation

Kontrollparameter

FIG 29

EP 2 867 894 B1

FIG 30

FIG 31

FIG 32

FIG 33

EP 2 867 894 B1

FIG 34

EP 2 867 894 B1

FIG 35

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 2012065983 A1

### In der Beschreibung aufgeführte Nicht-Patentliteratur

- **AHMED, N. ; NATARAJAN, T. ; RAO, K.R.** Discrete Cosine Transform. In: Computers. *IEEE Transactions on C-23,* Januar 1974, vol. 1
- **BOSI, M. ; GOLDBERG, R. E.** Introduction to Digital Audio Coding and Standards. Kluwer Academic Publishers, 2003
- **BRITANAK, V. ; YIP, P. C. ; RAO, K. R.** Discrete Cosine and Sine Transforms: General Properties, Fast Algorithms and Integer Approximations. Elsevier, 2007
- **BURRUS, C. S. ; PARKS, T.** DFT/FFT and Convolution Algorithms: Theory and Implementation. John Wiley & Sons Ltd, 1985
- **CHENG, C.** Method for Estimating Magnitude and Phase in the MDCT Domain. *In: Audio Engineering Society Convention 116,* Mai 2004
- **DOLSON, M.** The Phase Vocoder: A Tutorial. *In: Computer Music Journal,* 1986, vol. 10 (4
- **EKSTRAND, P.** Bandwidth Extension of Audio Signals by Spectral Band Replication. *In: Proceedings of 1st IEEE Benelux Workshop on MPCA,* November 2002, vol. 1
- **FASTL, H. ; ZWICKER, E.** Psychoacoustics: Facts and Models. Springer, 2007
- **JORDAN-ENGELN, G. ; REUTTER, F.** Numerische Mathematik für Ingenieure. Bibliographisches Institut, 1978
- **KIENCKE, U. ; JÄKEL, H.** Signale und Systeme. Oldenburg Verlag, 2005
- **LARSEN, E. ; AARTS, R. M.** Audio Bandwidth Extension: Application of Psychoacoustics, Signal Processing and Loudspeaker Design. John Wiley & Sons Ltd, 2004
- **LOCHMANN, D.** Digitale Nachrichtentechnik: Digitale Modulation und Signalverarbeitung. VBE Verlag Technik, 1990, vol. 1
- **MALVAR, H. S.** Signal Processing with Lapped Transforms. Artech House, 1992
- **MALVAR, H. S. ; STAELIN, D. H.** The LOT: transform coding without blocking effects. *In: Acoustics, Speech and Signal Processing, IEEE Transactions,* April 1989, vol. 37 (4
- **NAGEL, F. ; DISCH, S.** A harmonic bandwidth extension method for audio codecs. *In: Acoustics, Speech and Signal Processing, 2009. ICASSP 2009. IEEE International Conference,* April 2009
- **NAGEL, F. ; DISCH, S. ; WILDE, S.** A continuous modulated single sideband bandwidth extension. *In: Acoustics Speech and Signal Processing (ICASSP), 2010 IEEE International Conference,* Marz 2010
- **PRINCEN, J. ; BRADLEY, A.** Analysis/Synthesis filter bank design based on time domain aliasing cancellation. *In: Acoustics, Speech and Signal Processing, IEEE Transactions,* Oktober 1986, vol. 34 (5
- **PRINCEN, J. ; JOHNSON, A. ; BRADLEY, A.** Subband/Transform coding using filter bank designs based on time domain aliasing cancellation. *In: Acoustics, Speech, and Signal Processing, IEEE International Conference on ICASSP '87,* April 1987, vol. 12
- **RAO, K. R. ; YIP, P. C.** The Transform and Data Compression Handbook. CRC Press, 2001
- **SCHULLER, G. D. T. ; SMITH, M. J. T.** New framework for modulated perfect reconstruction filter banks. *In: Signal Processing, IEEE Transactions,* August 1996, vol. 44 (8
- **WEINZIERL, S.** Handbuch der Audiotechnik Berlin. Springer, 2008
- **WILDE ; STEPHAN.** Entwicklung von Zeitbereichsverfahren zur Bandbreitenerweiterung von Audiosignalen. Friedrich-Alexander-Universität Erlangen-Nürnberg, 2009
- **YOST, W. A.** Fundamentals of Hearing: An Introduction. Academic Press, 1994
- **ZÖLZER, U.** *Digitale Audiosignalverarbeitung,* 2005